(19) Europäisches Patentamt
European Patent Office
Office européen des brevets

(11) EP 4 737 505 A1

(12) **EUROPEAN PATENT APPLICATION**
published in accordance with Art. 153(4) EPC

(43) Date of publication:
**06.05.2026 Bulletin 2026/19**

(21) Application number: **24831870.1**

(22) Date of filing: **21.06.2024**

(51) International Patent Classification (IPC):
***C08G 73/06*** (2006.01) ***C08G 73/22*** (2006.01)
***C08K 5/00*** (2006.01) ***C08L 79/04*** (2006.01)
***C08L 79/08*** (2006.01) ***G03F 7/023*** (2006.01)
***G03F 7/037*** (2006.01) ***G03F 7/038*** (2006.01)
***H05B 33/14*** (2006.01) ***H10K 50/84*** (2023.01)
***H10K 59/122*** (2023.01) ***H10K 59/124*** (2023.01)
***H10K 85/10*** (2023.01)

(52) Cooperative Patent Classification (CPC):
**C08G 73/06; C08G 73/22; C08K 5/00; C08L 79/04; C08L 79/08; G03F 7/023; G03F 7/037; G03F 7/038; H05B 33/14; H10K 50/84; H10K 59/122; H10K 59/124; H10K 85/10**

(86) International application number:
**PCT/JP2024/022587**

(87) International publication number:
**WO 2025/005009 (02.01.2025 Gazette 2025/01)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **27.06.2023 JP 2023104746**

(71) Applicant: **Toray Industries, Inc.**
**Tokyo 103-8666 (JP)**

(72) Inventors:
- **TANIGAKI, Yugo**
**Otsu-shi, Shiga 520-8558 (JP)**
- **BABA, Osamu**
**Otsu-shi, Shiga 520-8558 (JP)**
- **WADA, Tatsuho**
**Otsu-shi, Shiga 520-8558 (JP)**
- **SAEKI, Akinori**
**Otsu-shi, Shiga 520-8558 (JP)**

(74) Representative: **Kador & Partner Part mbB**
**Corneliusstraße 15**
**80469 München (DE)**

(54) **RESIN, PHOTOSENSITIVE COMPOSITIONS, CURED OBJECT, DISPLAY DEVICE, ELECTRONIC COMPONENT, AND METHOD FOR PRODUCING CURED OBJECT**

(57) An object of the present invention is to provide a photosensitive composition capable of suppressing residues after development, to provide a photosensitive composition capable of obtaining a cured product included in a display device having excellent light emission characteristics capable of low voltage driving in obtaining a desired current density and excellent reliability of a light emitting element, and to provide a photosensitive composition capable of obtaining a cured product included in an electronic component excellent in migration resistance. There is provided a resin being one or more resins selected from the group consisting of a polyimide, a polyimide precursor, a polybenzoxazole, a polybenzoxazole precursor, a polyamideimide, a polyamideimide precursor, and a copolymer thereof, in which the resin has a first amine residue (DA1): an amine residue having a phenolic hydroxyl group, the first amine residue (DA1) has at least two cyclic structures having a phenolic hydroxyl group, and further has a specific structure linking them, and the resin satisfies a condition that a content of a fluorine element in the structure of the resin is 10,000 ppm by mass or less.

EP 4 737 505 A1

Fig. 1

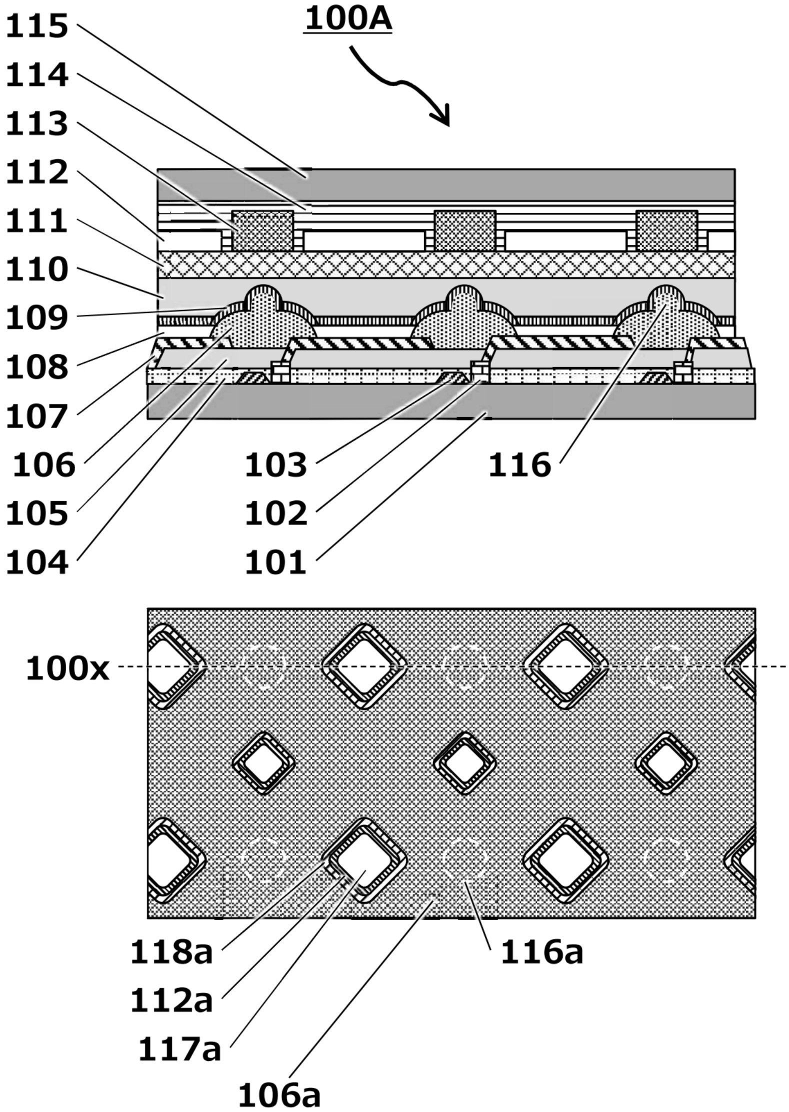
100A
115
114
113
112
111
110
109
108
107
106
105
104
103
102
101
116
100x
118a
112a
117a
106a
116a

## Description

TECHNICAL FIELD

The present invention relates to a resin, a photosensitive composition, a cured product, a display device, an electronic component, and a method for producing a cured product.

BACKGROUND ART

In recent years, efforts have been made to reduce cost and increase integration by improving efficiency of a semiconductor manufacturing process, and a semiconductor device that forms a multilayer metal redistribution wiring has attracted attention. A material used for an interlayer insulating layer in such multilayer metal redistribution wiring is required to have high migration resistance because reliability related to electrical insulation is required due to wiring miniaturization associated with high integration of the semiconductor device. Furthermore, development residue suppression during pattern formation of positive type or negative type by photolithography is also required.

Further, in an organic electroluminescence (hereinafter, "organic EL") display as a display device, a pixel dividing layer or a thin film transistor (hereinafter, "TFT") planarization layer is formed at a position adjacent to or close to a light emitting element. Therefore, in order to improve reliability of the organic EL display, it is necessary to examine a configuration of the pixel dividing layer and the like and physical properties such as heat resistance of a material used for the pixel dividing layer and the like. In addition, in order to achieve high luminance and power saving of the organic EL display, excellent light emission characteristics capable of low voltage driving in obtaining a desired current density are required.

As the display device, for example, a display device including a pixel dividing layer containing polyimide (see, for example, Patent Document 1) and an organic EL display (see, for example, Patent Document 2) in which a sum of contents of a metal element and/or a halogen element in a cured film falls within a specific range are known.

PRIOR ART DOCUMENT

PATENT DOCUMENTS

Patent Document 1: Japanese Patent Laid-open Publication No. 2002-091343
Patent Document 2: International Publication No. 2018/123853

SUMMARY OF THE INVENTION

PROBLEMS TO BE SOLVED BY THE INVENTION

However, the display device described in Patent Document 1 or Patent Document 2 still has a problem with light emission characteristics related to low voltage driving, reliability of a light emitting element, or migration resistance. In addition, the composition described in Patent Document 1 or Patent Document 2 has a problem in suppressing residues after development.

An object of the present invention is to provide a photosensitive composition capable of suppressing residues after development, and to provide a display device that has excellent light emission characteristics capable of low voltage driving in obtaining a desired current density and has excellent reliability of the light emitting element. Further, another object of the present invention is to provide an electronic component excellent in migration resistance.

SOLUTIONS TO THE PROBLEMS

As a result of intensive studies to solve the above-described problems, it has been found that significant effects can be achieved by focusing on a fluorine element among halogen elements. In particular, the present inventors have found that the above-described problems can be solved by a specific configuration related to the content of the fluorine element in a resin contained in a composition used for forming a cured film or the content of the fluorine element in the composition, and have completed the present invention. The resin of the present invention, the photosensitive composition of the present invention, or the display device of the present invention has the following configurations [1] to [22].

[1] A resin being one or more resins selected from the group consisting of a polyimide, a polyimide precursor, a

polybenzoxazole, a polybenzoxazole precursor, a polyamideimide, a polyamideimide precursor, and a copolymer thereof, in which

the resin has a first amine residue (DA1): an amine residue having a phenolic hydroxyl group, and the first amine residue (DA1) has at least two structures (Ia): a cyclic structure having a phenolic hydroxyl group, and a structure (IIa): a structure linking at least two of the structures (Ia), and
the structure (IIa) is a sulfonyl group, an alkylene group, a condensed polycyclic structure, a hydrocarbon group including an ether bond, a direct bond, an ether bond, a sulfide bond, a carbonyl group, a carboxylate ester bond, an amide bond, a urea bond, a urethane bond, a carbonate ester bond, a cycloalkylene group, an arylene group, a condensed polycyclic heterocyclic structure, a hydrocarbon group including a carbonyloxy group, or a hydrocarbon group including a carbonyl amide group, and
the resin satisfies the following condition (P1a):
(P1a) the content of a fluorine element in the structure of the resin is 10,000 ppm by mass or less.

[2] The resin according to [1], in which the first amine residue (DA1) has an amine residue satisfying the following condition (S1x):
(S1x) an amine residue has a $C_1$ symmetry axis as a molecular symmetry and does not have a $C_2$ symmetry axis.
[3] The resin according to [1] or [2], further having a second amine residue (DA2): an amine residue having no phenolic hydroxyl group, and satisfying the following condition ($\alpha$1) and/or condition ($\alpha$2), in which

a total content ratio of the first amine residue (DA1) to all amine residues in the resin is 20 mol% or more and 90 mol% or less, and
a total content ratio of the second amine residue (DA2) to all amine residues in the resin is 10 mol% or more and 80 mol% or less:

($\alpha$1) the second amine residue (DA2) has at least two structures (Ib): a cyclic structure having no phenolic hydroxyl group, and a structure (IIb): a structure linking at least two of the structures (Ib), and
the structure (IIb) is a sulfonyl group, an alkylene group, a condensed polycyclic structure, a hydrocarbon group including an ether bond, a direct bond, an ether bond, a sulfide bond, a carbonyl group, a carboxylate ester bond, an amide bond, a urea bond, a urethane bond, a carbonate ester bond, a cycloalkylene group, an arylene group, a condensed polycyclic heterocyclic structure, a hydrocarbon group including a carbonyloxy group, or a hydrocarbon group including a carbonyl amide group;
($\alpha$2) the second amine residue (DA2) has a structure (IIIb): a silicone structure and/or a siloxane structure.

[4] The resin according to [3], in which the first amine residue (DA1) has an amine residue satisfying the following condition (S1x), and/or the second amine residue (DA2) has an amine residue satisfying at least one of the following conditions (S1x) and (S2x):

(S1x) the amine residue has a $C_1$ symmetry axis as a molecular symmetry and does not have a $C_2$ symmetry axis;
(S2x) the amine residue has at least one of a chiral center, a chiral axis, a chiral plane, and a helical axis.

[5] The resin according to any one of [1] to [4] having a polyimide unit and a polyimide precursor unit, in which

a content ratio of a polyimide unit to a total of the polyimide unit and the polyimide precursor unit is 1.0 mol% or more and 30 mol% or less, and
a content ratio of an amic acid ester structure to a total of an amic acid structure and an amic acid ester structure in the polyimide precursor unit is 40 mol% or more and 99 mol% or less.

[6] The resin according to any one of [1] to [5] having a polyimide unit and/or a polyimide precursor unit, and

the resin has one or more selected from the group consisting of a polybenzoxazole unit, a polybenzoxazole precursor unit, a polyamideimide unit, and a polyamideimide precursor unit, in which
the total content ratio of the polybenzoxazole unit, the polybenzoxazole precursor unit, the polyamideimide unit, and the polyamideimide precursor unit to the total of the polyimide unit, the polyimide precursor unit, the polybenzoxazole unit, the polybenzoxazole precursor unit, the polyamideimide unit, and the polyamideimide precursor unit of the resin is 10 mol% or more and 90 mol% or less.

[7] The resin according to any one of [1] to [6], further satisfying at least one of the following conditions (P1b), (P1c), and

(P1d) :

(P1b) the content of a chlorine element in the structure of the resin is 30,000 ppm by mass or less;
(P1c) the content of a bromine element in the structure of the resin is 30,000 ppm by mass or less;
(P1d) the content of a sulfur element in the structure of the resin is 30,000 ppm by mass or less.

[8] A photosensitive composition containing a binder resin (A) and a photosensitive agent (C), and further containing a radical polymerizable compound (B) and/or a crosslinking agent (F), in which
the binder resin (A) includes the resin according to any one of [1] to [7].
[9] The photosensitive composition according to [8], in which

the binder resin (A), the photosensitive agent (C), the radical polymerizable compound (B), or the crosslinking agent (F) has a fluorine atom, a chlorine atom, a bromine atom, a fluoride ion, a chloride ion, or a bromide ion in its structure, or
the photosensitive composition further contains a component including a fluorine element, a chlorine element, or a bromine element and/or a component including a fluoride ion, a chloride ion, or a bromide ion, and
the photosensitive composition satisfies the following condition (P1x) and the following condition (1x):

(P1x) a total content of the fluorine element, the chlorine element, and the bromine element in the structure of the resin is 30,000 ppm by mass or less;
(1x) a total content of the fluorine element, the chlorine element, and the bromine element in a total solid content of the photosensitive composition is 0.010 ppm by mass or more and 1,000 ppm by mass or less.

[10] A photosensitive composition containing a binder resin (A) and a photosensitive agent (C), and further containing a radical polymerizable compound (B) and/or a crosslinking agent (F), in which

the binder resin (A) includes a resin (Ax): one or more resins selected from the group consisting of a polyimide, a polyimide precursor, a polybenzoxazole, a polybenzoxazole precursor, a polyamideimide, a polyamideimide precursor, and a copolymer thereof, and
the resin (Ax) has a first amine residue (DA1): an amine residue having a phenolic hydroxyl group, and the first amine residue (DA1) has at least two structures (Ia): a cyclic structure having a phenolic hydroxyl group, and a structure (IIa): a structure linking at least two of the structures (Ia), and
the structure (IIa) is a sulfonyl group, an alkylene group, a condensed polycyclic structure, a hydrocarbon group including an ether bond, a direct bond, an ether bond, a sulfide bond, a carbonyl group, a carboxylate ester bond, an amide bond, a urea bond, a urethane bond, a carbonate ester bond, a cycloalkylene group, an arylene group, a condensed polycyclic heterocyclic structure, a hydrocarbon group including a carbonyloxy group, or a hydrocarbon group including a carbonyl amide group, and
the photosensitive composition satisfies the following condition (1a):
(1a) the content of the fluorine element in the total solid content of the photosensitive composition is 1,000 ppm by mass or less.

[11] The photosensitive composition according to [10], in which

the binder resin (A), the photosensitive agent (C), the radical polymerizable compound (B), or the crosslinking agent (F) has a chlorine atom, a bromine atom, a sulfur atom, a chloride ion, a bromide ion, or a sulfur-based anion as described below in its structure, or
the photosensitive composition further contains a component including a chlorine element, a bromine element, or a sulfur element and/or a component including a chloride ion, a bromide ion, or a sulfur-based anion as described below, and
the photosensitive composition satisfies at least one of the following conditions (1b), (1c), and (1d):

sulfur-based anion: one or more ions selected from the group consisting of a sulfide ion, a hydrogen sulfide ion, a sulfate ion, and a hydrogen sulfate ion;
(1b) the content of the chlorine element in the total solid content of the photosensitive composition is 0.010 ppm by mass or more and 1,000 ppm by mass or less;
(1c) the content of the bromine element in the total solid content of the photosensitive composition is 0.010 ppm by mass or more and 1,000 ppm by mass or less;
(1d) the content of the sulfur element in the total solid content of the photosensitive composition is 0.010 ppm

by mass or more and 1,000 ppm by mass or less.

[12] The photosensitive composition according to any one of [8] to [11], further containing a phenol compound (I), in which the phenol compound (I) satisfies the following condition (β1), and the photosensitive composition satisfies the following condition (5):

(β1) having at least two of the following structures (Ic) and the following structure (IIIc);
structure (Ic): a cyclic structure having a phenolic hydroxyl group;
structure (IIIc): a structure linking at least two of the structures (Ic), the structure being a sulfonyl group, an alkylene group, a condensed polycyclic structure, a hydrocarbon group including an ether bond, a direct bond, an ether bond, a sulfide bond, a carbonyl group, a carboxylate ester bond, an amide bond, a urea bond, a urethane bond, a carbonate ester bond, a cycloalkylene group, an arylene group, a condensed polycyclic heterocyclic structure, a hydrocarbon group including a carbonyloxy group, or a hydrocarbon group including a carbonyl amide group;
(5) the total content of the phenol compound (I) in the total solid content of the photosensitive composition is 0.010 ppm by mass or more and 10,000 ppm by mass or less.

[13] The photosensitive composition according to any one of [8] to [12], further containing one or more resins selected from the group consisting of a phenolic resin, polyhydroxystyrene, a phenol group-containing epoxy resin, and a phenol group-containing acrylic resin.
[14] The photosensitive composition according to any one of [8] to [13], in which the photosensitive agent (C) contains a compound having a 1,2-naphthoquinonediazide-5-sulfonic acid ester structure and a compound containing a 1,2-naphthoquinonediazide-4-sulfonic acid ester structure.
[15] The photosensitive composition according to any one of [8] to [14], further containing water, and satisfying the following condition (3):
(3) the content of water in the photosensitive composition is 0.010 mass% or more and 3.0 mass% or less.
[16] The photosensitive composition according to any one of [8] to [15], further containing a nitrogen-containing compound (H), in which the nitrogen-containing compound (H) includes one or more selected from the group consisting of a cyclic amide compound, an amide compound, a cyclic urea compound, a urea compound, an oxazolidone compound, and an isoxazolidone compound, and the photosensitive composition satisfies the following condition (4):
(4) the total content of the cyclic amide compound, the amide compound, the cyclic urea compound, the urea compound, the oxazolidone compound, and the isoxazolidone compound in the total solid content of the photosensitive composition is 0.010 mass% or more and 5.0 mass% or less.
[17] The photosensitive composition according to any one of [8] to [16], further containing a crosslinkable aromatic compound (J), in which

the crosslinkable aromatic compound (J) has at least two structures (Id): a cyclic structure in which a phenolic hydroxyl group and at least two crosslinkable groups are bonded, and at least two structures (IId): a cyclic structure having a phenolic hydroxyl group different from the structure (Id), and further has a structure (IIId): a structure linking at least two of the structures (IId), and
the photosensitive composition satisfies the following condition (6):
(6) the total content of the crosslinkable aromatic compound (J) in the total solid content of the photosensitive composition is 0.010 ppm by mass or more and 5,000 ppm by mass or less.

[18] A cured product obtained by curing the photosensitive composition according to any one of [8] to [17].
[19] A display device including the cured product according to [18].
[20] An electronic component including the cured product according to [18].
[21] A method for producing a cured product, the method including: (1) a step of forming a coating film of the photosensitive composition according to any one of [8] to [17] on a substrate; (2) a step of irradiating the coating film of the photosensitive composition with actinic radiation through a photomask; (3) a step of performing development using a developer to form a pattern of the photosensitive composition; and (4) a step of heating the pattern of the photosensitive composition to obtain a cured pattern of the photosensitive composition.
[22] A display device having a substrate, a first electrode, a second electrode, a pixel dividing layer, a light emitting layer, and a TFT planarization layer, in which the pixel dividing layer and/or the TFT planarization layer includes one or more resins selected from the group consisting of a polyimide, a polyimide precursor, a polybenzoxazole, a polybenzoxazole precursor, a polyamideimide, a polyamideimide precursor, and a copolymer thereof, and

the resin has an amine residue having a phenolic hydroxyl group, and the amine residue having a phenolic hydroxyl group has at least two structures (XIa): a cyclic structure having a phenolic hydroxyl group, and a structure (XIIa): a structure linking at least two of the structures (XIa), and

the structure (XIIa) is a sulfonyl group, an alkylene group, a condensed polycyclic structure, a hydrocarbon group including an ether bond, a direct bond, an ether bond, a sulfide bond, a carbonyl group, a carboxylate ester bond, an amide bond, a urea bond, a urethane bond, a carbonate ester bond, a cycloalkylene group, an arylene group, a condensed polycyclic heterocyclic structure, a hydrocarbon group including a carbonyloxy group, or a hydrocarbon group including a carbonyl amide group, and

the display device satisfies the following condition (X1a) :

(X1a) the content of the fluorine element in the pixel dividing layer is 1,000 ppm by mass or less, and/or the content of the fluorine element in the TFT planarization layer is 1,000 ppm by mass or less.

## EFFECTS OF THE INVENTION

With the resin of the present invention, it is possible to provide a photosensitive composition capable of suppressing residues after development. Further, it is possible to provide a photosensitive composition with which a cured product is obtained that is included in a display device that has excellent light emission characteristics capable of low voltage driving in obtaining a desired current density and has excellent reliability of the light emitting element. In addition, it is possible to provide a photosensitive composition with which a cured product included in an electronic component excellent in migration resistance is obtained.

In addition, according to the photosensitive composition of the present invention, it is possible to obtain a cured product included in a display device that can suppress residues after development, has the same excellent light emission characteristics, and has excellent reliability of a light emitting element. In addition, a cured product included in an electronic component excellent in migration resistance can be obtained. Further, with the display device of the present invention, it is possible to provide a display device that has the same excellent light emission characteristics and has excellent reliability of the light emitting element.

## BRIEF DESCRIPTION OF THE DRAWINGS

Fig. 1 is a schematic cross-sectional view and a plan view illustrating an example of a display device 100A having a step shape in which a pixel dividing layer has a thick film portion and a thin film portion.

Fig. 2 is a plan view illustrating a production process of steps 1 to 4 on a substrate of an organic EL display used to evaluate light emission characteristics.

## EMBODIMENTS OF THE INVENTION

Hereinafter, the resin, the photosensitive composition, the cured product, and the method for producing the cured product of the present invention will be described. Note that, in a case where "the photosensitive composition of the present invention" is described, it is a description common to the photosensitive compositions according to a first and second aspects of the present invention. On the other hand, in a case where reference to the photosensitive composition according to a specific aspect is made, there is described "the photosensitive composition according to the first aspect of the present invention" and the like. It is noted that the present invention is not limited to the following embodiments, and various modifications can naturally be made as long as the modifications can achieve the object of the invention and do not depart from the gist of the invention.

A hydrocarbon group or an alkylene group including a "** bond" or a "** group" refers to a hydrocarbon group or an alkylene group to which a "** bond" or a "** group" is bonded, or at least two hydrocarbon groups or at least two alkylene groups linked by a "** bond" or a "** group". A silicone structure refers to a structure having a Si-O-Si bond as a main skeleton and having two organic groups on a silicon atom. In other words, silicon atoms in the silicone structure are each bonded to two organic groups and two oxygen atoms. Further, a siloxane structure refers to a structure having a Si-O-Si bond as the main skeleton and having one organic group on a silicon atom. In other words, silicon atoms in the siloxane structure are each bonded to one organic group and three oxygen atoms.

In the resin of the present invention and the binder resin (A) in the photosensitive composition of the present invention, the amine residue refers to a structure obtained by removing a nitrogen atom and a substituent on the nitrogen atom from a structure derived from an amine or a structure derived from an amine derivative in the resin. That is, the amine residue corresponds to a structure obtained by removing a nitrogen atom and a substituent on the nitrogen atom from an amine molecule or an amine derivative molecule as a raw material of the resin. The amine residue preferably has a divalent

or higher valent structure, that is, a structure obtained by removing at least two nitrogen atoms and substituents on the nitrogen atoms from a structure derived from an amine or a structure derived from an amine derivative in a structural unit of the resin. It is also preferable that the amine residue has a trivalent or higher structure. Examples of such an amine residue include a structure obtained by removing a nitrogen atom and a substituent on the nitrogen atom from a diamine molecule, a triamine molecule, a diamine derivative molecule, or a triamine derivative molecule as a raw material of the resin.

In the resin of the present invention and the binder resin (A) in the photosensitive composition of the present invention, the carboxylic acid residue refers to a structure obtained by removing a carbonyl group and a substituent on a carbonyl carbon atom from a structure derived from a carboxylic acid or a structure derived from a carboxylic acid derivative in the resin. That is, the carboxylic acid residue corresponds to a structure obtained by removing a carbonyl group and a substituent on a carbonyl carbon atom from a carboxylic acid molecule or a carboxylic acid derivative molecule as a raw material of a resin. The carboxylic acid residue preferably has a divalent or higher structure, that is, a structure obtained by removing at least two carbonyl groups and a substituent on a carbonyl carbon atom from a structure derived from a carboxylic acid or a structure derived from a carboxylic acid derivative in the structural unit of the resin. The carboxylic acid residue preferably has a trivalent or higher structure, and also preferably has a tetravalent or higher structure. Examples of such a carboxylic acid residue include a structure obtained by removing a carbonyl group and a substituent on a carbonyl carbon atom from a dicarboxylic acid molecule, a tricarboxylic acid molecule, a tetracarboxylic acid molecule, a dicarboxylic acid derivative molecule, a tricarboxylic acid derivative molecule, or a tetracarboxylic acid derivative molecule, which are raw materials of a resin.

<Resin>

The resin of the present invention has the configuration described in [1] above. With the above configuration, the resin of the present invention can provide a photosensitive composition capable of suppressing residues after development. Further, it is possible to provide a photosensitive composition with which a cured product is obtained that is included in a display device that has excellent light emission characteristics capable of low voltage driving in obtaining a desired current density and has excellent reliability of the light emitting element. In addition, it is possible to provide a photosensitive composition with which a cured product included in an electronic component excellent in migration resistance is obtained. It is presumed that by containing the above resin in which the content of the fluorine element is equal to or less than a specific value in the photosensitive composition, the content of the fluorine element and fluoride ions in these resins or an anion including the fluorine element derived from these resins becomes equal to or less than the specific value, and therefore these resins locally activate protons in the photosensitive composition by an interaction such as hydrogen bonding. Therefore, it is considered that the effect of suppressing the residue after development is achieved by the dissolution promoting action on the developer. In addition, since the surface of the substrate is surface-modified by these components, it is presumed that the effect of suppressing residues after development is achieved by preventing residue adhesion at the opening, and the effects of achieving low voltage driving of light emission characteristics and improving the luminance become remarkable. Furthermore, it is considered that by containing a polyimide or the like having an amine residue with a specific structure having a phenolic hydroxyl group, the hydrogen bond between the phenolic hydroxyl group and a fluorine atom improves stability of the component including the fluorine element and the anion including the fluorine element in the photosensitive composition, and contributes to the effect of suppressing residues after development.

Further, it is considered that by intentionally containing the above resin in which the content of the fluorine element is equal to or less than a specific value, a detection intensity of these ions on surface of the cured product is adjusted to a specific value or less, and a polarization structure and a charge balance in the cured product are controlled. As a result, it is presumed that the effect of high reliability or excellent migration resistance of the light emitting element is achieved by suppressing ion migration and electromigration caused by metal impurities and ion impurities that adversely affect the light emission characteristics or electrical insulation properties. In addition, it is presumed that a highly reliable effect in a display device, an electronic component, or a semiconductor device is achieved by suppressing migration or aggregation of a metal in an electrode or a metal in a metal wiring.

The resin of the present invention is one or more resins selected from the group consisting of (Ax resin): a polyimide, a polyimide precursor, a polybenzoxazole, a polybenzoxazole precursor, a polyamideimide, a polyamideimide precursor, and a copolymer thereof (hereinafter, "polyimide-based resins"). Examples of the polyimide precursor include a polyamic acid, a polyamic acid ester, a polyamic acid amide, and a polyisoimide. Examples of the polyimide include a resin obtained by dehydrating and cyclizing a polyimide precursor. Examples of the polybenzoxazole precursor include polyhydroxyamides. Examples of the polybenzoxazole include a resin obtained by dehydrating and cyclizing a polybenzoxazole precursor. Examples of the polyamideimide precursor include a resin obtained by reacting a tricarboxylic anhydride or the like with a diamine or the like. Examples of the polyamideimide include a resin obtained by dehydrating and cyclizing a polyamideimide precursor. Examples of the polyamide include a resin obtained by reacting a dicarboxylic acid chloride or the like with a diamine or the like. Note that the resin of the present invention may be a single resin, a mixture

thereof, or a copolymer thereof.

<First Amine Residue (DA1)>

The resin of the present invention has a first amine residue (DA1): an amine residue having a phenolic hydroxyl group, and the first amine residue (DA1) has at least two structures (Ia): a cyclic structure having a phenolic hydroxyl group, and a structure (IIa): a structure linking at least two of the structures (Ia). It is also preferable that the resin of the present invention has two or more types of first amine residues (DA1).

The cyclic structure in the structure (Ia) is preferably an aromatic structure or a condensed polycyclic structure, and more preferably an aromatic structure having 6 to 15 carbon atoms or a condensed polycyclic structure having 6 to 20 carbon atoms, from a viewpoint of improving the reliability of the light emitting element and the migration resistance. The aromatic structure is preferably a biphenyl structure or a benzene structure. The condensed polycyclic structure is preferably a fluorene structure, an anthracene structure, or a naphthalene structure. Note that, the phenolic hydroxyl group in the first amine residue (DA1) may react with a structure and/or a group in the resin to form a benzoxazole ring. In other words, in the resin having a benzoxazole ring in the structural unit of the resin, the benzoxazole ring may have the first amine residue (DA1).

In the resin of the present invention, the structure (IIa) is a sulfonyl group, an alkylene group, a condensed polycyclic structure, a hydrocarbon group including an ether bond, a direct bond, an ether bond, a sulfide bond, a carbonyl group, a carboxylate ester bond, an amide bond, a urea bond, a urethane bond, a carbonate ester bond, a cycloalkylene group, an arylene group, a condensed polycyclic heterocyclic structure, a hydrocarbon group including a carbonyloxy group, or a hydrocarbon group including a carbonyl amide group. The alkylene group, cycloalkylene group, or arylene group in the structure (IIa) is preferably an alkylene group having 1 to 10 carbon atoms, a cycloalkylene group having 4 to 10 carbon atoms, or an arylene group having 6 to 15 carbon atoms. The hydrocarbon group in the hydrocarbon group including an ether bond is preferably an alkylene group having 1 to 10 carbon atoms, a cycloalkylene group having 4 to 10 carbon atoms, or an arylene group having 6 to 15 carbon atoms. The number of carbon atoms of the hydrocarbon group including a carbonyloxy group and the hydrocarbon group including a carbonyl amide group is preferably 1 to 15, and the hydrocarbon group is preferably an aliphatic structure, an alicyclic structure, an aromatic structure, a condensed polycyclic structure, or a condensed polycyclic heterocyclic structure.

<Specific First Amine Residue (DA1)>

It is preferable that the first amine residue (DA1) has an amine residue satisfying the following condition (S1x) (hereinafter, a "specific first amine residue (DA1)"), from the viewpoint of suppressing residues after development, achieving low voltage driving of the light emission characteristics, improving the reliability of the light emitting element, and improving the migration resistance. The amine residue satisfying the following condition (S1x) in the first amine residue (DA1) is more preferably an amine residue further satisfying the following condition (S1y), and still more preferably an amine residue further satisfying the following condition (S1z). It is also preferable that the resin of the present invention has two or more types of specific first amine residues (DA1).

(S1x) An amine residue has a $C_1$ symmetry axis as a molecular symmetry and does not have a $C_2$ symmetry axis.

(S1y) The amine residue has a $C_1$ symmetry axis as the molecular symmetry and does not have a $C_2$ symmetry axis or a $C_3$ symmetry axis.

(S1z) The amine residue has a $C_1$ symmetry axis as a molecular symmetry, and has no symmetry axis other than the $C_1$ symmetry axis.

The amine residue in the first amine residue (DA1) is as described above. The molecular symmetry of the amine residue under the above conditions (S1x) to (S1z) refers to a molecular symmetry in the amine residue in a case where the amine residue included in the resin of the present invention is regarded as a molecule. Examples of the molecular symmetry include a symmetry axis, a symmetry plane, a symmetry center, and a roto-reflection axis. The above conditions (S1x) to (S1z) shall be considered with respect to the symmetry axis among these molecular symmetries.

Having a $C_x$ symmetry axis as the molecular symmetry under the above conditions (S1x) to (S1z) means that a three-dimensional structure before rotation and a three-dimensional structure after rotation are the same in the three-dimensional structure of a target molecule in a case where the target molecule is rotated by (360/x)° around an arbitrary axis. Note that x represents an integer of 1 or more. That is, having the $C_1$ symmetry axis as the molecular symmetry means that the three-dimensional structures are the same before and after being rotated by 360° with respect to an arbitrary axis. Having a $C_2$ symmetry axis as the molecular symmetry means that the three-dimensional structures are the same before and after being rotated by 180° with respect to an arbitrary axis. Having a $C_3$ symmetry axis as the molecular symmetry means that the three-dimensional structures are the same before and after being rotated by 120° with respect to an arbitrary axis. In addition, having no symmetry axis other than the $C_1$ symmetry axis as the molecular symmetry means having no $C_x$ symmetry axis ($1 < x \leq 360$) such as the $C_2$ symmetry axis (axis having the same three-dimensional structure

before and after being rotated by 180°) or the $C_3$ symmetry axis (axis having the same three-dimensional structure before and after being rotated by 120°).

Note that, when considering the symmetry axis in the molecular symmetry of the amine residue under the above conditions (S1x) to (S1z) related to the first amine residue (DA1), the three-dimensional structure before rotation of a target amine residue shall take into account all possible conformations as a molecule. In other words, in the three-dimensional structure before rotation, in a case where at least one of the conformations that can be taken as a molecule by the target amine residue has a $C_2$ symmetry axis, the above condition (S1x) is not satisfied, in a case where at least one has a $C_2$ symmetry axis or a $C_3$ symmetry axis, the above condition (S1y) is not satisfied, and in a case where at least one has a $C_x$ symmetry axis ($1 < x \leq 360$), the above condition (S1z) is not satisfied.

Note that, it is also preferable that the first amine residue (DA1) has an amine residue including at least one of a chiral center, a chiral axis, a chiral plane, and a helical axis.

When the first amine residue (DA1) has the above configuration, the first amine residue (DA1) has an asymmetric structure having no $C_2$ symmetry axis, so that the symmetry in the resin of the present invention is reduced. Therefore, it is considered that an orientation and stacking of the resin in the film of the photosensitive composition are suppressed. As a result, solubility of the resin is improved, and the effect of suppressing residues after development becomes remarkable by a dissolution promoting action of the resin on the developer. Further, it is presumed that a surface modification action on the substrate surface by the fluorine element, the fluoride ions, or the like is promoted by the effect of suppressing residues after development, and the effect of achieving low voltage driving of the light emission characteristics becomes remarkable. In addition, it is considered that the control of the polarization structure and the charge balance in the cured product by the fluorine element, the fluoride ion, or the like described above is promoted. As a result, it is presumed that the ion migration and the electromigration are suppressed, and the effect of improving the reliability and the migration resistance of the light emitting element becomes remarkable.

It is preferable that the first amine residue (DA1) has an amine residue represented by formula (31) from the viewpoint of suppressing residues after development, achieving low voltage driving of the light emission characteristics, improving the reliability of the light emitting element, and improving the migration resistance.

[Chemical Formula 1]

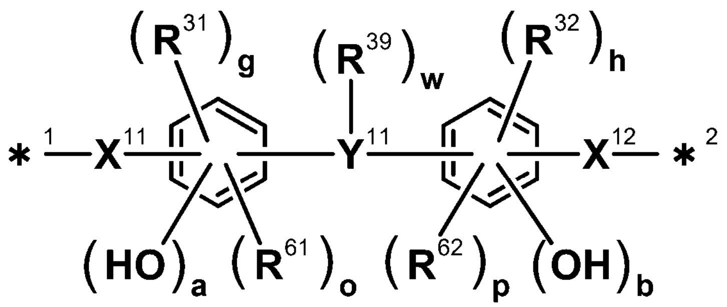

(31)

In Formula (31), $R^{31}$ and $R^{32}$ each independently represent a carboxy group, a mercapto group, or a sulfonic acid group. $R^{39}$ represents a hydrocarbon group, a hydrocarbon group containing an ether bond, or a hydrocarbon group containing a carbonyl group. $R^{61}$ and $R^{62}$ each independently represent an alkyl group having 1 to 10 carbon atoms, a cycloalkyl group having 4 to 10 carbon atoms, an aryl group having 6 to 15 carbon atoms, an alkenyl group having 2 to 10 carbon atoms, an alkoxy group having 1 to 10 carbon atoms, an alkenyloxy group having 2 to 10 carbon atoms, or an acyl group having 1 to 10 carbon atoms. $X^{11}$ and $X^{12}$ each independently represent a direct bond, a hydrocarbon group, a hydrocarbon group containing an ether bond, or a hydrocarbon group containing a carbonylamide group. $Y^{11}$ represents a sulfonyl group, an alkylene group, a condensed polycyclic structure, a hydrocarbon group containing an ether bond, a direct bond, an ether bond, a sulfide bond, a carbonyl group, a carboxylic acid ester bond, an amide bond, a urea bond, a urethane bond, a carbonate ester bond, a cycloalkylene group, an arylene group, a condensed polycyclic heterocyclic structure, a hydrocarbon group containing a carbonyloxy group, or a hydrocarbon group containing a carbonylamide group. a and b each independently represent an integer of 1 to 4. g and h each independently represent an integer of 0 to 3. o and p each independently represent an integer of 0 to 3. w represents an integer of 0 to 6. Note that $1 \leq a + g + o \leq 4$ and $1 \leq b + h + p \leq 4$ are satisfied. $*^1$ and $*^2$ each independently represent a bonding point in the resin.

In formula (31), the hydrocarbon group in $R^{39}$, the hydrocarbon group containing an ether bond, and the hydrocarbon group containing a carbonyl group are preferably an alkyl group having 1 to 10 carbon atoms, a cycloalkyl group having 4 to 10 carbon atoms, an aryl group having 6 to 15 carbon atoms, or an arylalkyl group having 10 to 20 carbon atoms, more preferably an alkyl group having 1 to 8 carbon atoms, and even more preferably an alkyl group having 1 to 6 carbon atoms. When o represents an integer of 1 to 3, the corresponding $R^{61}$ is preferably an alkyl group having 1 to 6

carbon atoms, and more preferably a methyl group, an ethyl group, a propyl group, an isopropyl group, a butyl group, an isobutyl group, or an s-butyl group. When p represents an integer of 1 to 3, the corresponding $R^{62}$ is preferably an alkyl group having 1 to 6 carbon atoms, and more preferably a methyl group, an ethyl group, a propyl group, an isopropyl group, a butyl group, an isobutyl group, or an s-butyl group. It is preferable that at least one of o and p is 1. It is also preferable that o and p are 0, and it is more preferable that o and p are 1. It is also preferable that o represents an integer of 1 to 3 and p is 0, and it is more preferable that o is 1. It is also preferable that o is 0 and p represents an integer of 1 to 3, and it is more preferable that p is 1.

From a viewpoint of satisfying the above condition (S1x), a chemical structure of $R^{39}$ preferably satisfies the above condition (S1x). Further, from the viewpoint of satisfying the above condition (S1x), it is also preferable to satisfy at least one of the following conditions: (a) the chemical structures of $R^{31}$ and $R^{32}$ are not the same; (b) substitution positions of $R^{31}$ and $R^{32}$ bonded to the aromatic ring in the formula (31) are different (asymmetric substitution positions); and (c) g and h each independently represent an integer of 0 to 3 different from each other. Further, from the viewpoint of satisfying the above condition (S1x), it is also preferable to satisfy at least one of the following conditions: (d) the chemical structures of $R^{61}$ and $R^{62}$ are not the same; (e) the substitution positions of $R^{61}$ and $R^{62}$ bonded to the aromatic ring in the formula (31) are different (asymmetric substitution positions); and (f) o and p each independently represent an integer of 0 to 3 different from each other. Further, from the viewpoint of satisfying the above condition (S1x), it is also preferable to satisfy at least one of the following conditions: (g) the substitution positions of at least two phenolic hydroxyl groups bonded to the aromatic ring in the formula (31) are different (asymmetric substitution positions); and (h) a and b each independently represent an integer of 1 to 4 different from each other.

In formula (31), the hydrocarbon group in $X^{11}$ and $X^{12}$, the hydrocarbon group containing an ether bond, and the hydrocarbon group containing a carbonylamide group are preferably an alkylene group having 1 to 10 carbon atoms, a cycloalkylene group having 4 to 10 carbon atoms, an arylene group having 6 to 15 carbon atoms, or an arylalkylene group having 10 to 20 carbon atoms. The hydrocarbon group in a case of the hydrocarbon group including a carbonylamide group in $X^{11}$ and $X^{12}$ is more preferably an arylene group having 6 to 15 carbon atoms, and still more preferably an arylene group having 6 to 10 carbon atoms. It is preferable that an arylene group having 6 to 15 carbon atoms is bonded to a carbonyl group in the carbonylamide group. Preferably, the nitrogen atom of the carbonylamide group is bonded to the aromatic ring in Formula (31), and the arylene group having 6 to 15 carbon atoms bonded to the carbonyl group in the carbonylamide group is bonded to $*^1$ or $*^2$ in Formula (31). In $Y^{11}$, the hydrocarbon group in a case of the hydrocarbon group including an ether bond is preferably an alkylene group having 1 to 10 carbon atoms, a cycloalkylene group having 4 to 10 carbon atoms, or an arylene group having 6 to 15 carbon atoms. In $Y^{11}$, the number of carbon atoms of the hydrocarbon group including a carbonyloxy group and the hydrocarbon group including a carbonylamide group is preferably 1 to 15, and the hydrocarbon group is preferably an aliphatic structure, an alicyclic structure, an aromatic structure, a condensed polycyclic structure, or a condensed polycyclic heterocyclic structure. The substituents and structures described above may have a hetero atom, and may be either unsubstituted or substituted.

From the viewpoint of satisfying the above condition (S1x), it is preferable to satisfy at least one of the following conditions: (i) the chemical structures of $X^{11}$ and $X^{12}$ are not the same; (j) the substitution positions of $X^{11}$ and $X^{12}$ bonded to the aromatic ring in the formula (31) are different (asymmetric substitution positions). Further, from the viewpoint of satisfying the above condition (S1x), it is also preferable that the chemical structure of $Y^{11}$ satisfies the above condition (S1x).

The phenolic hydroxyl group in the amine residue represented by Formula (31) may react with a structure and/or a group in the resin to form a benzoxazole ring. That is, in the resin having a benzoxazole ring in the structural unit of the resin, the benzoxazole ring may have an amine residue represented by Formula (31). The phenolic hydroxyl group in the amine residue represented by the formula (31) may be protected by a monovalent acid-dissociable group having 1 to 120 carbon atoms. In other words, it is also preferable that the amine residue represented by the formula (31) has a phenolic hydroxyl group, and the phenolic hydroxyl group in the amine residue represented by the formula (31) has an amine residue protected by a monovalent acid-dissociable group having 1 to 120 carbon atoms. The monovalent acid-dissociable group having 1 to 120 carbon atoms is preferably an alkyl group having 1 to 6 carbon atoms, a cycloacrylic group having 4 to 10 carbon atoms, an alkoxyalkyl group having 2 to 10 carbon atoms, or a cycloalkoxyalkyl group having 5 to 15 carbon atoms.

When the structures in the specific first amine residue (DA1) are not the same in chemical structure, it is preferable that at least one of the number of carbon atoms, the number of hydrogen atoms, the number of heteroatoms, a molecular weight, a molecular volume, and an aspect ratio is different between structures to be compared. Further, when the structures in the specific first amine residue (DA1) are not the same in chemical structure, it is also preferable that the structures to be compared are in a relationship of structural isomerism or geometric isomerism. It is also preferable that the structure to be compared has at least one of a chiral center, a chiral axis, a chiral plane, and a helical axis. The same applies to the following description regarding the structure in the specific first amine residue (DA1).

In the formula (31), $Y^{11}$ is preferably a group represented by the formula (32), the formula (33) or the formula (34) from the viewpoint of suppressing residues after development, achieving low voltage driving of the light emission

characteristics, improving the reliability of the light emitting element, and improving the migration resistance. When $Y^{11}$ in Formula (31) is a group represented by Formula (32), (33), or (34), $R^{39}$ in Formula (31) is a group corresponding to $R^{34}$ bonded to an atom of a ring member in Formula (32), a group corresponding to $R^{35}$ bonded to an atom of a ring member in Formula (33), or a group bonded to $R^{36}$ or $R^{37}$ in Formula (34).

[Chemical Formula 2]

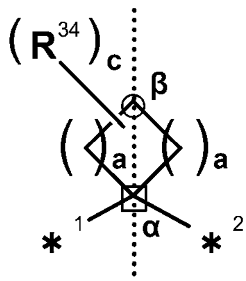 (32) 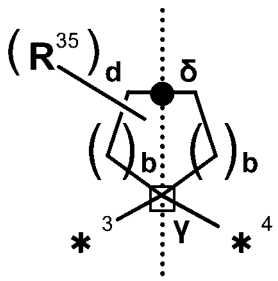 (33) 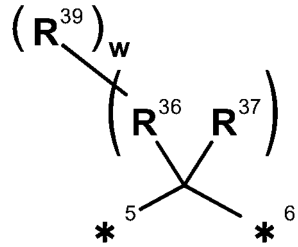 (34)

In Formulas (32) to (34), $R^{34}$ and $R^{35}$ each independently represent a hydrocarbon group, a hydrocarbon group including an ether bond, or a hydrocarbon group including a carbonyl group. $R^{36}$ and $R^{37}$ each independently represent a hydrogen atom, a hydrocarbon group, a hydrocarbon group including an ether bond, or a hydrocarbon group including a carbonyl group. $R^{39}$ represents a hydrocarbon group, a hydrocarbon group containing an ether bond, or a hydrocarbon group containing a carbonyl group. a and b each independently represent an integer of 1 or 2. c represents an integer of 1 to $((4 \times a) + 2)$. d represents an integer of 1 to $((4 \times a) + 4)$. w represents an integer of 0 to 6. $*^1$ to $*^6$ each independently represent a bonding point to an aromatic ring in Formula (31) resin. The formula (32) satisfies the following condition (Y1), the formula (33) satisfies the following condition (Y2), and the formula (34) satisfies the following condition (Y3).

(Y1) When a carbon center bonded to an aromatic ring in Formula (31) is $\alpha$ (represented as □), a carbon atom thereof is at the 1 position, and an (a + 2) position of a carbon atom forming a ring is $\beta$ (represented as o), left and right chemical structures separated by broken lines passing through $\alpha$ and $\beta$ are not the same on the paper.

(Y2) When a carbon center bonded to an aromatic ring in Formula (31) is represented by $\gamma$ (represented by □), a carbon atom thereof is at the 1 position, and a midpoint between the (b + 2) position and the (b + 3) position of a carbon atom forming the ring is represented by $\delta$ (represented by ●), left and right chemical structures separated by broken lines passing through $\gamma$ and $\delta$ are not the same on the paper.

(Y3) The chemical structures of $R^{36}$ and $R^{37}$ in Formula (34) are not the same.

Note that, in a case where the group represented by the formula (32) has at least one of a chiral center, a chiral axis, a chiral plane, and a helical axis, the formula (32) satisfies the above condition (Y1). Further, in a case where the group represented by the formula (33) has at least one of a chiral center, a chiral axis, a chiral plane, and a helical axis, the formula (33) satisfies the above condition (Y2). Further, in a case where the group represented by the formula (34) has at least one of a chiral center, a chiral axis, a chiral plane, and a helical axis, the formula (34) satisfies the above condition (Y3).

Note that, when considering the above conditions (Y1) to (Y3) related to the formulas (32) to (34), the chemical structure of the target group represented by the formula (32), the formula (33), or the formula (34) shall take into account all possible conformations of the target group. In other words, in a case where at least one of the possible conformations of the target group represented by the formula (32) has the same chemical structure on left and right sides separated by a dashed line passing through $\alpha$ and $\beta$ on the paper, the above condition (Y1) is not satisfied. Further, in a case where at least one of the possible conformations of the target group represented by the formula (33) has the same chemical structure on the left and right sides separated by a dashed line passing through $\alpha$ and $\gamma$ on the paper, the above condition (Y2) is not satisfied. Further, in a case where at least one of the possible conformations of the target group represented by the formula (34) has the same chemical structure of $R^{36}$ and $R^{37}$, the above condition (Y3) is not satisfied.

In Formulas (32) to (34), $R^{36}$ and $R^{37}$ each independently preferably represent a hydrocarbon group, a hydrocarbon group including an ether bond, or a hydrocarbon group including a carbonyl group. The hydrocarbon group in a case of the hydrocarbon group in $R^{34}$, $R^{35}$, $R^{36}$, $R^{37}$, and $R^{39}$, the hydrocarbon group including an ether bond, and the hydrocarbon group including a carbonyl group is preferably an alkyl group having 1 to 10 carbon atoms, a cycloalkyl group having 4 to 10 carbon atoms, an aryl group having 6 to 15 carbon atoms, or an arylalkyl group having 10 to 20 carbon atoms, more preferably an alkyl group having 1 to 8 carbon atoms, and still more preferably an alkyl group having 1 to 6 carbon atoms.

When the first amine residue (DA1) has the above configuration, the first amine residue (DA1) has an asymmetric structure or a stereoscopically asymmetric structure having no $C_2$ symmetry axis, so that the symmetry in the resin of the present invention is reduced. Therefore, it is considered that an orientation and stacking of the resin in the film of the photosensitive composition are suppressed. For the same reason as described above, it is presumed that the effects of

suppressing residues after development, achieving low voltage driving of the light emission characteristics, improving the reliability of the light emitting element, and improving the migration resistance become remarkable.

It is particularly preferable that the first amine residue (DA1) satisfies the above condition (S1x) and has an amine residue represented by the formula (31), and in the formula (31), $Y^{11}$ is a group represented by the formula (32), the formula (33), or the formula (34), from the viewpoint of suppressing residues after development, achieving low voltage driving of the light emission characteristics, improving the reliability of the light emitting element, and improving the migration resistance.

In Formula (31), $Y^{11}$ is preferably a group represented by any one of Formulas (55) to (68) from the viewpoint of the effects of the invention described above.

[Chemical Formula 3]

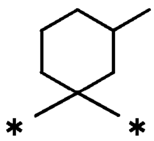 (55) 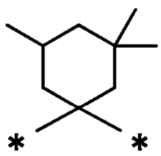 (56) 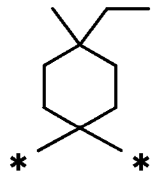 (57) 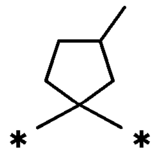 (58)

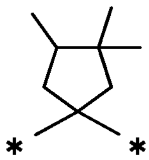 (59) 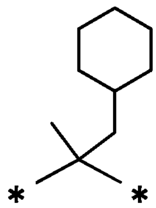 (60) 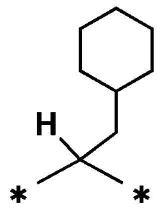 (61) 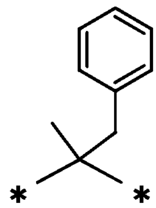 (62)

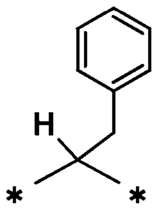 (63) 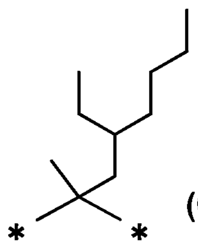 (64) 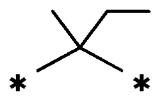 (65) 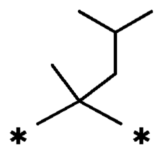 (66)

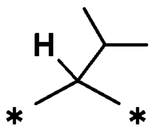 (67) 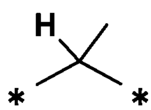 (68)

In Formulas (55) to (68), * each independently represents a bonding point in the resin.

The first amine residue (DA1) in which $Y^{11}$ is a group represented by any one of formulas (55) to (68) in the formula (31) is preferably an amine residue represented by any one of formulas (70) to (99).

[Chemical Formula 4]

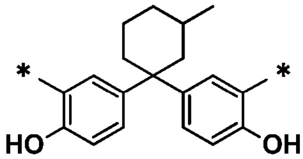 (70) 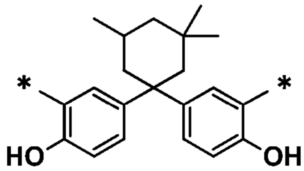 (71) 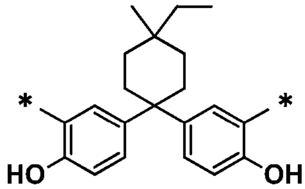 (72)

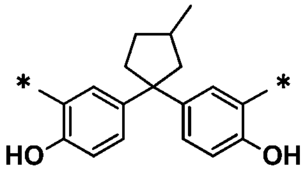 (73) 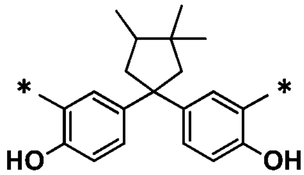 (74) 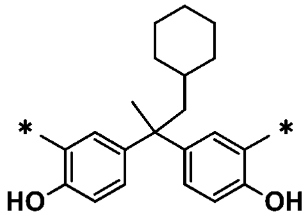 (75)

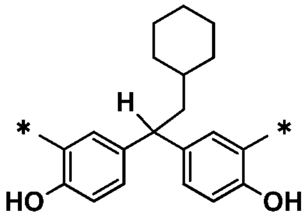 (76) 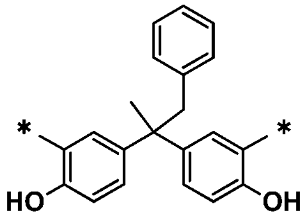 (77) 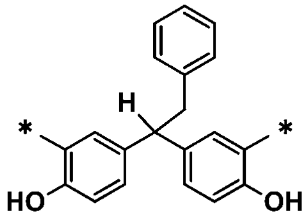 (78)

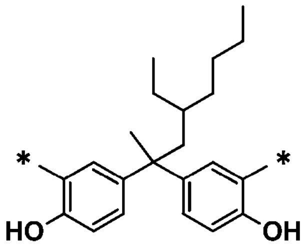 (79) 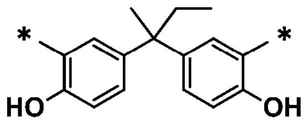 (80) 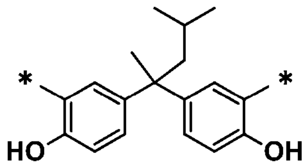 (81)

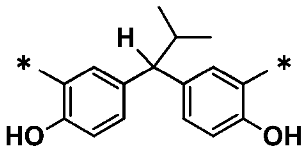 (82) 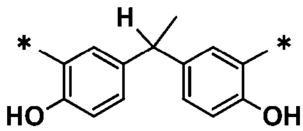 (83) 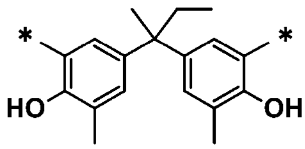 (84)

[Chemical Formula 5]

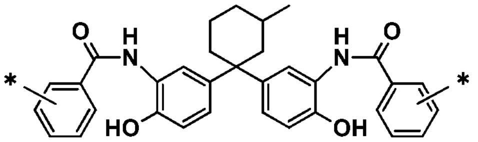 (85) 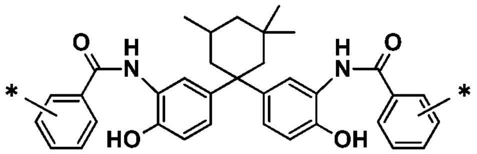 (86)

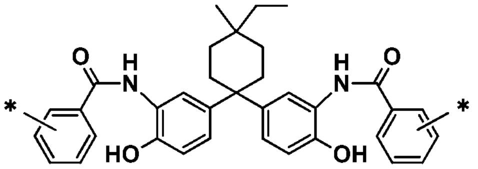 (87) 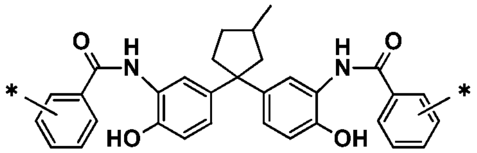 (88)

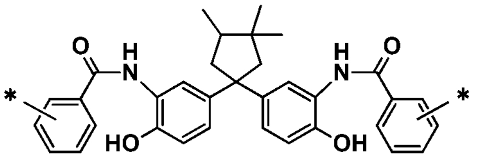 (89) 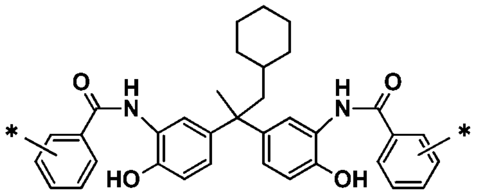 (90)

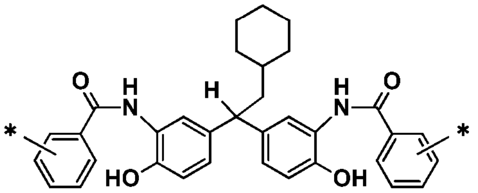 (91) 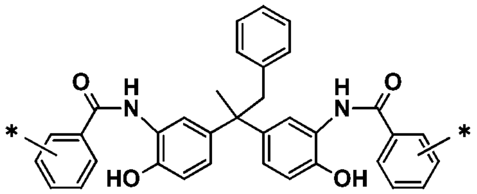 (92)

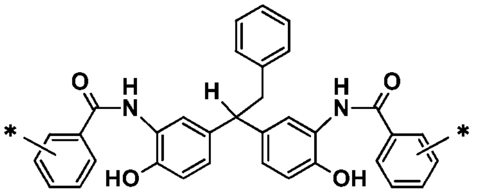 (93) 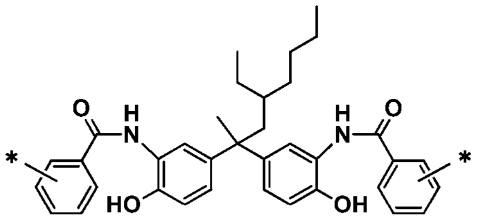 (94)

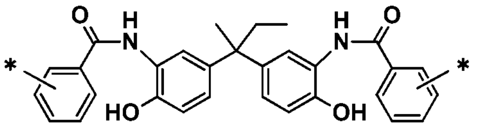 (95) 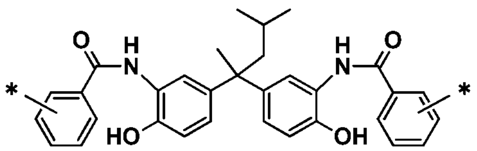 (96)

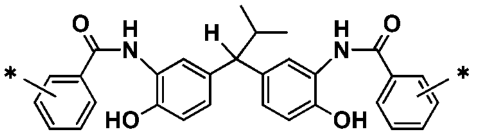 (97) 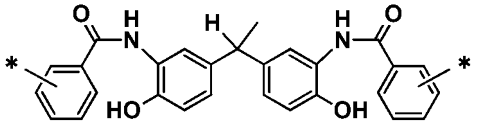 (98)

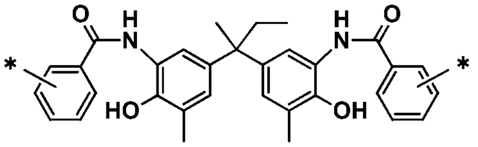 (99)

The total content ratio of the amine residue represented by the formula (31) to all the amine residues in the resin of the present invention is preferably 10 mol% or more, more preferably 20 mol% or more, still more preferably 30 mol% or more, and particularly preferably 50 mol% or more, from the viewpoint of suppressing residues after development, achieving low voltage driving of the light emission characteristics, improving the reliability of the light emitting element, and improving the migration resistance. On the other hand, the total content ratio of the amine residues represented by the formula (31) is preferably 100 mol% or less, more preferably 90 mol% or less, still more preferably 80 mol% or less, and particularly preferably 70 mol% or less from the viewpoint of the effects of the invention described above.

<Second Amine Residue (DA2)>

From the viewpoint of improving the reliability of the light emitting element and improving the migration resistance, it is preferable that the resin of the present invention further has a second amine residue (DA2): an amine residue having no phenolic hydroxyl group, and satisfies the following condition ($\alpha$1) and/or condition ($\alpha$2). The resin of the present invention preferably satisfies the following conditions ($\alpha$1) and ($\alpha$2) from the viewpoint of suppressing residues after development. It is also preferable that the resin of the present invention has two or more types of second amine residues (DA2).

($\alpha$1) The second amine residue (DA2) has at least two structures (Ib): a cyclic structure having no phenolic hydroxyl group, and further has a structure (IIb): a structure linking at least two structures (Ib), and the structure (IIb) is a sulfonyl group, an alkylene group, a condensed polycyclic structure, a hydrocarbon group including an ether bond, a direct bond, an ether bond, a sulfide bond, a carbonyl group, a carboxylate ester bond, an amide bond, a urea bond, a urethane bond, a carbonate ester bond, a cycloalkylene group, an arylene group, a condensed polycyclic heterocyclic structure, a hydrocarbon group including a carbonyloxy group, or a hydrocarbon group including a carbonyl amide group.

($\alpha$2) The second amine residue (DA2) has a structure (IIIb): a silicone structure and/or a siloxane structure.

The cyclic structure in the structure (Ib) is preferably an aromatic structure or a condensed polycyclic structure, and more preferably an aromatic structure having 6 to 15 carbon atoms or a condensed polycyclic structure having 6 to 20 carbon atoms, from the viewpoint of improving the reliability of the light emitting element and improving the migration resistance. The aromatic structure is preferably a biphenyl structure or a benzene structure. The condensed polycyclic structure is preferably a fluorene structure, an anthracene structure, or a naphthalene structure.

The alkylene group, the cycloalkylene group, or the arylene group in the structure (IIb) is preferably an alkylene group having 1 to 10 carbon atoms, a cycloalkylene group having 4 to 10 carbon atoms, or an arylene group having 6 to 15 carbon atoms. The hydrocarbon group in the hydrocarbon group including an ether bond is preferably an alkylene group having 1 to 10 carbon atoms, a cycloalkylene group having 4 to 10 carbon atoms, or an arylene group having 6 to 15 carbon atoms. The number of carbon atoms of the hydrocarbon group including a carbonyloxy group and the hydrocarbon group including a carbonyl amide group is preferably 1 to 15, and the hydrocarbon group is preferably an aliphatic structure, an alicyclic structure, an aromatic structure, a condensed polycyclic structure, or a condensed polycyclic heterocyclic structure.

It is preferable that the silicone structure and the siloxane structure in the structure (IIIb) are bonded to at least two alkylene groups, and are each a divalent or more structure in which these alkylene groups are interposed. The divalent or more structure is more preferably trivalent or more, and still more preferably tetravalent or more. On the other hand, the divalent or more structure is preferably hexavalent or less. The number of silicon atoms of the silicone structure and/or the siloxane structure is preferably 2 or more, more preferably 3 or more, and still more preferably 4 or more. On the other hand, the number of the silicon atoms is preferably 15 or less, more preferably 10 or less, and still more preferably 8 or less. The silicone structure is preferably a dialkylsilicone structure and/or a monoalkylsilicone structure, and the siloxane structure is preferably a monoalkylsiloxane structure. The number of carbon atoms in the alkyl group of the dialkylsilicone structure, the monoalkylsilicone structure, and the monoalkylsiloxane structure is preferably 1 or more, more preferably 2 or more, and still more preferably 3 or more. On the other hand, the number of the carbon atoms in the alkyl group is preferably 10 or less, more preferably 8 or less, and still more preferably 6 or less.

<Specific Second Amine Residue (DA2)>

It is preferable that the second amine residue (DA2) has an amine residue satisfying at least one of the following conditions (S1x) and (S2x) (hereinafter, a "specific second amine residue (DA2)"), from the viewpoint of suppressing residues after development, achieving low voltage driving of the light emission characteristics, improving the reliability of the light emitting element, and improving the migration resistance.

In a case where the resin of the present invention has the second amine residue (DA2), it is preferable that the first amine residue (DA1) has an amine residue satisfying the following condition (S1x) and/or the second amine residue (DA2) has an amine residue satisfying at least one of the following conditions (S1x) and (S2x) (hereinafter, a "specific second amine residue (DA2)") from the viewpoint of the effects of the invention described above.

It is also preferable that the resin of the present invention has two or more types of specific second amine residues (DA2).

(S1x) An amine residue has a $C_1$ symmetry axis as a molecular symmetry and does not have a $C_2$ symmetry axis.

(S1y) The amine residue has a $C_1$ symmetry axis as the molecular symmetry and does not have a $C_2$ symmetry axis or a $C_3$ symmetry axis.

(S1z) The amine residue has a $C_1$ symmetry axis as a molecular symmetry, and has no symmetry axis other than the $C_1$ symmetry axis.

(S2x) The amine residue has at least one of a chiral center, a chiral axis, a chiral plane, and a helical axis.

(S2y) The amine residue has at least one of a chiral center and a chiral axis.

(S2z) The amine residue has a chiral axis.

The amine residue satisfying the above condition (S1x) in the second amine residue (DA2) is more preferably an amine residue further satisfying the above condition (S1y), and still more preferably an amine residue further satisfying the above condition (S1z). Further, the amine residue satisfying the above condition (S2x) in the second amine residue (DA2) is more preferably an amine residue further satisfying the above condition (S2y), and still more preferably an amine residue further satisfying the above condition (S2z).

The amine residue in the second amine residue (DA2) is as described above. Examples and preferred descriptions of the above conditions (S1x) to (S1z) related to the first amine residue (DA1) are the same as those described above. Examples and preferred descriptions of the amine residue under the above conditions (S1x) to (S1z) related to the second amine residue (DA2) are as described above for the first amine residue (DA1). Further, examples and preferred descriptions regarding the molecular symmetry of the amine residue and a $C_x$ symmetry axis as the molecular symmetry under the above conditions (S1x) to (S1z) related to the second amine residue (DA2) are as described above for the first amine residue (DA1).

Note that, when considering the symmetry axis in the molecular symmetry of the amine residue under the above conditions (S1x) to (S1z) related to the second amine residue (DA2), as with the first amine residue (DA1), the three-dimensional structure before rotation of the target amine residue shall take into account all possible conformations as a molecule. In other words, in the three-dimensional structure before rotation, in a case where at least one of the conformations that can be taken as a molecule by the target amine residue has a $C_2$ symmetry axis, the above condition (S1x) is not satisfied, in a case where at least one has a $C_2$ symmetry axis or a $C_3$ symmetry axis, the above condition (S1y) is not satisfied, and in a case where at least one has a $C_x$ symmetry axis ($1 < x \leq 360$), the above condition (S1z) is not satisfied.

The chiral center, the chiral axis, the chiral plane, and the helical axis under the above conditions (S2x) to (S2z) refer to a chiral center, a chiral axis, a chiral plane, and a helical axis in a molecule when the amine residue in the resin of the present invention is used as the molecule.

Examples of the chiral center include a chiral atom. The chiral atom is preferably a chiral carbon atom, a chiral silicon atom, a chiral germanium atom, a chiral nitrogen, a chiral phosphorus atom, or a chiral arsenic atom. Examples of the chiral axis include an axis connecting two rings in two ring structures, an axis connecting two ring structures passing through a center atom in two ring structures connected by sharing one center atom, and an axis linearly connecting three atoms connected by two double bonds. The structure having a chiral axis is preferably a biphenyl structure, a binaphthyl structure, a spiro structure, or an allene structure. Examples of the chiral plane include a plane in which at least two rings face each other in a ring structure formed by connecting at least two rings by a single bond, and a plane in which at least two rings face each other in a metal coordination ring structure including at least two rings coordinated to a metal atom. As the structure having a chiral plane, a cyclophane structure or a metallocene structure is preferable, and a paracyclophane structure or a ferrocene structure is more preferable. Examples of the helical axis include an axis of a helical structure in which at least two aromatic rings are continuously condensed. The structure having a helical axis is preferably a polyhelicene structure.

Regarding the chiral center, the chiral axis, the chiral plane, and the helical axis under the above conditions (S2x) to (S2z), when the amine residue in the resin of the present invention is used as a molecule, the molecule may be a meso compound. Further, the amine residue under the above conditions (S2x) to (S2z) preferably has chirality, and more preferably has central chirality, axial chirality, planar chirality, or helicity.

When the second amine residue (DA2) has the above configuration, the second amine residue (DA2) has an asymmetric structure or a stereoscopically asymmetric structure having no $C_2$ symmetry axis, so that the symmetry in the resin of the present invention is reduced. Therefore, it is considered that an orientation and stacking of the resin in the film of the photosensitive composition are suppressed. As a result, for the same reason as that of the first amine residue (DA1), it is presumed that the effects of suppressing residues after development, achieving low voltage driving of the light emission characteristics, improving the reliability of the light emitting element, and improving the migration resistance become remarkable.

It is preferable that the second amine residue (DA2) has an amine residue represented by formula (36) from the viewpoint of suppressing residues after development, achieving low voltage driving of the light emission characteristics, improving the reliability of the light emitting element, and improving the migration resistance.

[Chemical Formula 6]

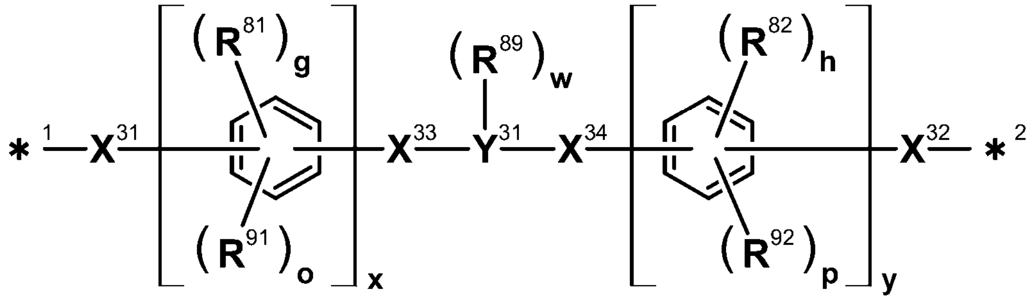

(36)

In Formula (36), $R^{81}$ and $R^{82}$ each independently represent a carboxy group, a mercapto group, or a sulfonic acid group. $R^{89}$ represents a hydrocarbon group, a hydrocarbon group including an ether bond, or a hydrocarbon group including a carbonyl group. $R^{91}$ and $R^{92}$ each independently represent an alkyl group having 1 to 10 carbon atoms, a cycloalkyl group having 4 to 10 carbon atoms, an aryl group having 6 to 15 carbon atoms, an alkenyl group having 2 to 10 carbon atoms, an alkoxy group having 1 to 10 carbon atoms, an alkenyloxy group having 2 to 10 carbon atoms, or an acyl group having 1 to 10 carbon atoms. $X^{31}$ and $X^{32}$ each independently represent a direct bond, a hydrocarbon group, a hydrocarbon group including an ether bond, or a hydrocarbon group including a carbonylamide group. $X^{33}$ and $X^{34}$ each independently represent a direct bond, a hydrocarbon group, a hydrocarbon group including an ether bond, a hydrocarbon group including a carbonyloxy group, or a hydrocarbon group including a carbonylamide group. $Y^{31}$ represents a sulfonyl group, an alkylene group, a condensed polycyclic structure, a hydrocarbon group including an ether bond, a direct bond, an ether bond, a sulfide bond, a carbonyl group, a carboxylic acid ester bond, an amide bond, a urea bond, a urethane bond, a carbonate ester bond, a cycloalkylene group, an arylene group, a condensed polycyclic heterocyclic structure, a hydrocarbon group including a carbonyloxy group, or a hydrocarbon group including a carbonylamide group. g and h each independently represent an integer of 0 to 4. o and p each independently represent an integer of 0 to 4. x and y each independently represent 0 or 1. w represents an integer of 0 to 6. $*^1$ and $*^2$ each independently represent a bonding point in the resin.

In Formula (36), the hydrocarbon group in $R^{89}$, the hydrocarbon group containing an ether bond, and the hydrocarbon group containing a carbonyl group are preferably an alkyl group having 1 to 10 carbon atoms, a cycloalkyl group having 4 to 10 carbon atoms, an aryl group having 6 to 15 carbon atoms, or an arylalkyl group having 10 to 20 carbon atoms, more preferably an alkyl group having 1 to 8 carbon atoms, and even more preferably an alkyl group having 1 to 6 carbon atoms. When o represents an integer of 1 to 3, the corresponding $R^{91}$ is preferably an alkyl group having 1 to 6 carbon atoms, and more preferably a methyl group, an ethyl group, a propyl group, an isopropyl group, a butyl group, an isobutyl group, or an s-butyl group. When p represents an integer of 1 to 3, the corresponding $R^{92}$ is preferably an alkyl group having 1 to 6 carbon atoms, and more preferably a methyl group, an ethyl group, a propyl group, an isopropyl group, a butyl group, an isobutyl group, or an s-butyl group. It is preferable that at least one of o and p is 1. It is also preferable that o and p are 0, and it is more preferable that o and p are 1. It is also preferable that o represents an integer of 1 to 3 and p is 0, and it is more preferable that o is 1. It is also preferable that o is 0 and p represents an integer of 1 to 3, and it is more preferable that p is 1.

From the viewpoint of satisfying the above condition (S1x), the chemical structure of $R^{89}$ preferably satisfies the above condition (S1x). Further, from the viewpoint of satisfying the above condition (S1x), it is also preferable to satisfy at least one of the following conditions: (a) the chemical structures of $R^{81}$ and $R^{82}$ are not the same; (b) the substitution positions of $R^{81}$ and $R^{82}$ bonded to the aromatic ring in the formula (36) are different (asymmetric substitution positions); and (c) g and h each independently represent an integer of 0 to 4 different from each other. Further, from the viewpoint of satisfying the above condition (S1x), it is also preferable to satisfy at least one of the following conditions: (d) the chemical structures of $R^{91}$ and $R^{92}$ are not the same; (e) the substitution positions of $R^{91}$ and $R^{92}$ bonded to the aromatic ring in the formula (36) are different (asymmetric substitution positions); and (f) o and p each independently represent an integer of 0 to 4 different from each other. On the other hand, from the viewpoint of satisfying the above condition (S2x), the chemical structure of $R^{89}$ preferably satisfies the above condition (S2x).

In Formula (36), the hydrocarbon group in a case of the hydrocarbon group in $X^{31}$ and $X^{32}$, the hydrocarbon group including an ether bond, and the hydrocarbon group including a carbonylamide group is preferably an alkylene group having 1 to 10 carbon atoms, a cycloalkylene group having 4 to 10 carbon atoms, an arylene group having 6 to 15 carbon atoms, or an arylalkylene group having 10 to 20 carbon atoms. The hydrocarbon group in $X^{33}$ and $X^{34}$, the hydrocarbon group including an ether bond, the hydrocarbon group including a carbonyloxy group, and the hydrocarbon group including a carbonylamide group are preferably an alkylene group having 1 to 10 carbon atoms, a cycloalkylene group having 4 to 10 carbon atoms, an arylene group having 6 to 15 carbon atoms, or an arylalkylene group having 10 to 20 carbon atoms. In

$Y^{31}$, the hydrocarbon group in the hydrocarbon group containing an ether bond is preferably an alkylene group having 1 to 10 carbon atoms, a cycloalkylene group having 4 to 10 carbon atoms, or an arylene group having 6 to 15 carbon atoms. In $Y^{31}$, the number of carbon atoms of the hydrocarbon group including a carbonyloxy group and the hydrocarbon group including a carbonylamide group is preferably 1 to 15, and the hydrocarbon group is preferably an aliphatic structure, an alicyclic structure, an aromatic structure, a condensed polycyclic structure, or a condensed polycyclic heterocyclic structure. The substituents and structures described above may have a hetero atom, and may be either unsubstituted or substituted.

From the viewpoint of satisfying the above condition (S1x), it is preferable to satisfy at least one of the following conditions: (i) the chemical structures of $X^{31}$ and $X^{32}$ are not the same; and (j) the substitution positions of $X^{31}$ and $X^{32}$ bonded to the aromatic ring in the formula (36) are different (asymmetric substitution positions). Further, from the viewpoint of satisfying the above condition (S1x), it is also preferable to satisfy at least one of the following conditions: (k) the chemical structures of $X^{33}$ and $X^{34}$ are not the same; and (1) the substitution positions of $X^{33}$ and $X^{34}$ bonded to the aromatic ring in the formula (36) are different (asymmetric substitution positions). Further, from the viewpoint of satisfying the above condition (S1x), it is also preferable that the chemical structure of $Y^{31}$ satisfies the above condition (S1x). On the other hand, from the viewpoint of satisfying the above condition (S2x), the chemical structure of $Y^{31}$ preferably satisfies the above condition (S2x), more preferably satisfies the above condition (S2y), and still more preferably satisfies the above condition (S2z). From the viewpoint of satisfying the above condition (S2z), $Y^{31}$ preferably includes a structure having a chiral axis. The structure having a chiral axis is preferably a biphenyl structure, a binaphthyl structure, a spiro structure, or an allene structure.

When the structures in the specific second amine residue (DA2) are not the same in chemical structure, it is preferable that at least one of the number of carbon atoms, the number of hydrogen atoms, the number of heteroatoms, a molecular weight, a molecular volume, and an aspect ratio is different between structures to be compared. Further, when the structures in the specific second amine residue (DA2) are not the same in chemical structure, it is also preferable that the structures to be compared are in a relationship of structural isomerism or geometric isomerism. It is also preferable that the structure to be compared has at least one of a chiral center, a chiral axis, a chiral plane, and a helical axis. The same applies to the following description regarding the structure in the specific second amine residue (DA2).

In Formula (36), $Y^{31}$ is preferably a group represented by Formula (37) or (38) from the viewpoint of the effects of the invention described above. When $Y^{31}$ in Formula (36) is a group represented by Formula (37) or (38), $R^{89}$ in Formula (36) is a group corresponding to $R^{84}$ to $R^{87}$ bonded to a ring member atom in Formula (37) or a group corresponding to $R^{94}$ to $R^{96}$ bonded to a ring member atom in Formula (38).

[Chemical Formula 7]

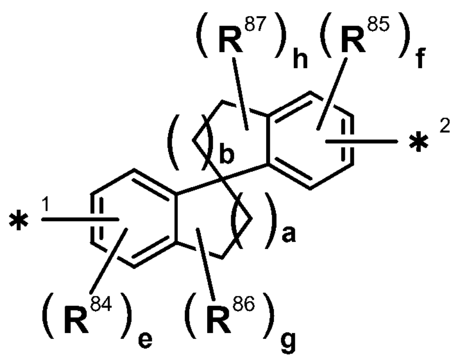
(37)

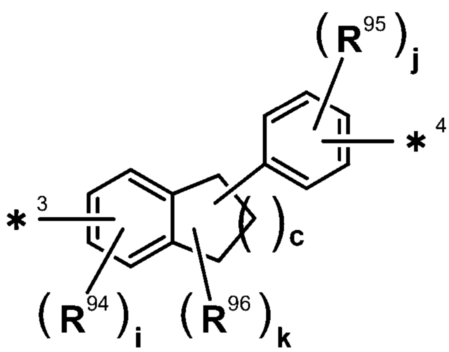
(38)

In Formulas (37) and (38), $R^{84}$ to $R^{87}$ and $R^{94}$ to $R^{96}$ each independently represent a hydrocarbon group, a hydrocarbon group including an ether bond, or a hydrocarbon group including a carbonyl group. a, b, and c each independently represent an integer of 1 or 2. e and f each independently represent an integer of 0 to 3. g represents an integer of 0 to $((2 \times a) + 2)$. h represents an integer of 0 to $((2 \times b) + 2)$. i represents an integer of 0 to 3. j represents an integer of 0 to 4. k represents an integer of 0 to $((2 \times c) + 3)$. $*^1$ to $*^4$ each independently represent a bonding point to $X^{33}$ or $X^{34}$ in Formula (36).

In Formulas (37) and (38), the hydrocarbon group in a case of the hydrocarbon group in $R^{84}$, $R^{85}$, $R^{86}$, $R^{87}$, $R^{94}$, $R^{95}$, and $R^{96}$, the hydrocarbon group including an ether bond, and the hydrocarbon group including a carbonyl group is preferably an alkyl group having 1 to 10 carbon atoms, a cycloalkyl group having 4 to 10 carbon atoms, an aryl group having 6 to 15 carbon atoms, or an arylalkyl group having 10 to 20 carbon atoms, more preferably an alkyl group having 1 to 8 carbon atoms, and still more preferably an alkyl group having 1 to 6 carbon atoms.

When the second amine residue (DA2) has the above configuration, the second amine residue (DA2) has an

asymmetric structure or a stereoscopically asymmetric structure having no $C_2$ symmetry axis, so that the symmetry in the resin of the present invention is reduced. Therefore, it is considered that an orientation and stacking of the resin in the film of the photosensitive composition are suppressed. For the same reason as described above, it is presumed that the effects of suppressing residues after development, achieving low voltage driving of the light emission characteristics, improving the reliability of the light emitting element, and improving the migration resistance become remarkable.

It is particularly preferable that the second amine residue (DA2) satisfies at least one of the above conditions (S1x) and (S2x) and has an amine residue represented by the formula (36), and in the formula (36), $Y^{31}$ is a group represented by the formula (37) or the formula (38), from the viewpoint of suppressing residues after development, achieving low voltage driving of the light emission characteristics, improving the reliability of the light emitting element, and improving the migration resistance.

The total content ratio of the amine residue represented by the formula (36) to all the amine residues in the resin of the present invention is preferably 1 mol% or more, more preferably 5 mol% or more, still more preferably 10 mol% or more, still more preferably 15 mol% or more, and particularly preferably 20 mol% or more, from the viewpoint of suppressing residues after development, achieving low voltage driving of the light emission characteristics, improving the reliability of the light emitting element, and improving the migration resistance. On the other hand, the total content ratio of the amine residues represented by the formula (36) is preferably 80 mol% or less, more preferably 50 mol% or less, still more preferably 40 mol% or less, and still more preferably 30 mol% or less from the viewpoint of the effects of the invention described above.

From the viewpoint of the effects of the invention described above, it is also preferable that the second amine residue (DA2) has an amine residue satisfying the above condition (S1x) and further has an amine residue satisfying the above condition (S2x). Further, from the viewpoint of the effects of the invention described above, it is also preferable that the second amine residue (DA2) has an amine residue that satisfies at least one of the above conditions (S1x) and (S2x), and further has an amine residue that does not satisfy any of the above conditions (S1x) and (S2x).

When the second amine residue (DA2) has such a configuration, the second amine residue (DA2) has not only an asymmetric structure or a sterically asymmetric structure having no $C_2$ symmetry axis but also a structure different from the structure, so that the symmetry in the resin of the present invention is reduced as a whole. Therefore, it is presumed that the orientation and stacking of the resin in the film of the photosensitive composition are suppressed, and the effects of the invention described above become remarkable for the same reason as described above.

Further, from the viewpoint of the effects of the invention described above, it is also preferable that the resin of the present invention has the second amine residue (DA2), and further has an amine residue having no phenolic hydroxyl group different from the second amine residue (DA2). Note that, the resin of the present invention may further have an amine residue different from the first amine residue (DA1) and the second amine residue (DA2). Examples of such an amine residue include an alicyclic amine residue or an aliphatic amine residue.

In the resin of the present invention, it is preferable that the total content ratio of the first amine residue (DA1) to all the amine residues in the resin is 20 mol% or more and 90 mol% or less, and the total content ratio of the second amine residue (DA2) to all the amine residues is 10 mol% or more and 80 mol% or less. The total content ratio of the first amine residue (DA1) to all the amine residues is preferably 20 mol% or more, more preferably 30 mol% or more, still more preferably 40 mol% or more, and particularly preferably 50 mol% or more, from the viewpoint of suppressing residues after development, achieving low voltage driving of the light emission characteristics, improving the reliability of the light emitting element, and improving the migration resistance. On the other hand, the total content ratio of the first amine residue (DA1) is preferably 90 mol% or less, more preferably 80 mol% or less, and still more preferably 70 mol% or less from the viewpoint of the effects of the invention described above. The total content ratio of the second amine residue (DA2) to all the amine residues is preferably 10 mol% or more, more preferably 20 mol% or more, and still more preferably 30 mol% or more from the viewpoint of improving the reliability of the light emitting element and improving the migration resistance. On the other hand, the total content ratio of the second amine residue (DA2) is preferably 80 mol% or less, more preferably 70 mol% or less, still more preferably 60 mol% or less, and particularly preferably 50 mol% or less from the viewpoint of the effects of the invention described above.

<Alicyclic Structure-containing Carboxylic Acid Residue (CB)>

It is preferable that the resin of the present invention further has an alicyclic structure-containing carboxylic acid residue (CB) (hereinafter, "alicyclic acid residue (CB)") from the viewpoint of suppressing residues after development, improving the reliability of the light emitting element, and improving the migration resistance. It is also preferable that the resin of the present invention has two or more types of alicyclic acid residues (CB).

The carboxylic acid residue in the alicyclic acid residue (CB) is as described above. The alicyclic acid residue (CB) has an alicyclic structure. In the alicyclic acid residue (CB), an atom bonded to a bonding point in the resin is preferably a ring member atom of an alicyclic structure. In other words, the structure derived from a carboxylic acid or the structure derived from a carboxylic acid derivative in the resin preferably has a ring member atom of an alicyclic structure bonded to a

carbonyl group.

In a case where the alicyclic acid residue (CB) has a divalent or more structure, the structure derived from a carboxylic acid or the structure derived from a carboxylic acid derivative in the structural unit of the resin preferably has at least two ring member atoms of an alicyclic structure bonded to a carbonyl group, and also preferably has one ring member atom of an alicyclic structure bonded to a carbonyl group and has at least one ring member atom of an alicyclic structure that is not bonded to a carbonyl group.

In a case where the alicyclic acid residue (CB) has a tetravalent or more structure, the structure derived from a carboxylic acid or the structure derived from a carboxylic acid derivative in the structural unit of the resin preferably has at least four ring member atoms of an alicyclic structure bonded to a carbonyl group, and also preferably has two ring member atoms of an alicyclic structure bonded to a carbonyl group and has at least two ring member atoms of an alicyclic structure that is not bonded to a carbonyl group. Note that, in a case where the alicyclic acid residue (CB) has a tetravalent or more structure and has four ring member atoms of an alicyclic structure bonded to a carbonyl group, it is preferable that two of the four ring member atoms are adjacent atoms. Further, in a case where the alicyclic acid residue (CB) has a tetravalent or more structure and has two ring member atoms of an alicyclic structure bonded to a carbonyl group, it is preferable that the two ring member atoms are adjacent atoms.

The alicyclic acid residue (CB) preferably has a cycloalkylene group having 4 to 10 carbon atoms or a cycloalkenylene group having 4 to 10 carbon atoms. The alicyclic acid residue (CB) preferably has a cyclobutane structure, a cyclopentane structure, a cyclohexane structure, a cycloheptane structure, a cyclobutene structure, a cyclopentene structure, a cyclohexene structure, or a cycloheptene structure.

The alicyclic acid residue (CB) more preferably has a condensed polycyclic alicyclic structure, and still more preferably has a tricyclo[5.2.1.0$^{2,6}$]decane structure, an adamantane structure, a norbornene structure, an indane structure, a tetrahydroindane structure, a hexahydroindane structure, a tetrahydronaphthalene structure, an octahydronaphthalene structure, a decahydronaphthalene structure, a tetrahydrofluorene structure, a hexahydrofluorene structure, a tetrahydroanthracene structure, or an octahydroanthracene structure.

The total content ratio of the alicyclic acid residues (CB) to all the carboxylic acid residues in the resin is preferably 5 mol% or more, more preferably 10 mol% or more, still more preferably 20 mol% or more, and particularly preferably 30 mol% or more, from the viewpoint of suppressing residues after development, improving the reliability of the light emitting element, and improving the migration resistance. On the other hand, the total content ratio of the alicyclic acid residues (CB) is preferably 100 mol% or less, more preferably 80 mol% or less, still more preferably 60 mol% or less, and particularly preferably 50 mol% or less from the viewpoint of the effects of the invention described above.

Note that, the resin of the present invention may further have a carboxylic acid residue different from the alicyclic acid residue (CB). Examples of such a carboxylic acid residue include an aromatic carboxylic acid residue and an aliphatic carboxylic acid residue.

<Polyimide Unit and the Like>

It is preferable that the resin of the present invention has a polyimide unit and a polyimide precursor unit from the viewpoint of suppressing residues after development, achieving low voltage driving of the light emission characteristics, improving the reliability of the light emitting element, and improving the migration resistance.

The polyimide unit refers to a unit having two imide structures among structural units of a resin including an amine residue and a carboxylic acid residue. The polyimide unit is preferably a unit represented by formula (1). The polyimide precursor unit refers to a unit having two amic acid structures, two amic acid ester structures, two amic acid amide structures, an amic acid structure and an amic acid ester structure, an amic acid structure and an amic acid amide structure, or an amic acid ester structure and an amic acid amide structure among structural units of a resin including an amine residue and a carboxylic acid residue. Note that, the amic acid structure refers to a structure having one carboxylic acid amide bond and one carboxy group. The amic acid ester structure refers to a structure having one carboxylic acid amide bond and one carboxylate ester bond. The amic acid amide structure refers to a structure having one carboxylic acid amide bond and another carboxylic acid amide bond. The polyimide precursor unit is preferably a unit having two amic acid structures, two amic acid ester structures, or an amic acid structure and an amic acid ester structure, and more preferably a unit having two amic acid ester structures or an amic acid structure and an amic acid ester structure. The polyimide precursor unit is preferably a unit represented by formula (2).

[Chemical Formula 8]

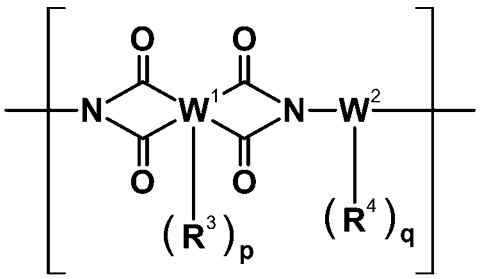 (1) 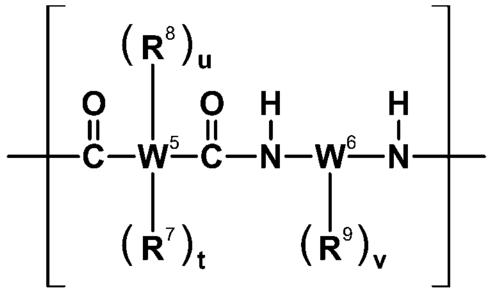 (2)

In the formula (1) and the formula (2), $W^1$ and $W^5$ each independently represent a tetravalent to decavalent organic group. $W^2$ and $W^6$ each independently represent a divalent to decavalent organic group. $R^3$, $R^4$, and $R^9$ each independently represent a phenolic hydroxyl group, a sulfonic acid group, a mercapto group, or a substituent represented by formula (7) or formula (8). $R^7$ represents a substituent represented by the formula (7) or the formula (8). $R^8$ represents a phenolic hydroxyl group, a sulfonic acid group, or a mercapto group. p represents an integer of 0 to 6. q represents an integer of 0 to 8. t represents an integer of 2 to 8, u represents an integer of 0 to 6, and $2 \leq t + u \leq 8$ is satisfied. v represents an integer of 0 to 8. However, in a case where $R^3$ or $R^4$ represents a phenolic hydroxyl group, $W^1$ or $W^2$ bonded to the phenolic hydroxyl group includes an aromatic structure in its structure. Further, in a case where $R^8$ or $R^9$ represents a phenolic hydroxyl group, $W^5$ or $W^6$ bonded to the phenolic hydroxyl group includes an aromatic structure in its structure. $W^1$ and $W^5$ each independently represent a carboxylic acid residue. $W^2$ and $W^6$ each independently represent an amine residue. The substituents and structures described above may have a hetero atom, and may be either unsubstituted or substituted.

[Chemical Formula 9]

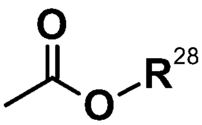 (7) 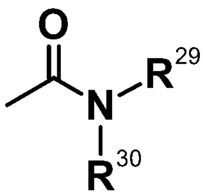 (8)

In the formula (7) and the formula (8), $R^{28}$ to $R^{30}$ each independently represent a hydrogen atom, an alkyl group having 1 to 10 carbon atoms, an acyl group having 2 to 6 carbon atoms, or an aryl group having 6 to 15 carbon atoms. In the formula (7) and the formula (8), $R^{28}$ to $R^{30}$ each independently preferably represent a hydrogen atom, an alkyl group having 1 to 6 carbon atoms, an acyl group having 2 to 4 carbon atoms, or an aryl group having 6 to 10 carbon atoms. The substituents and structures described above may have a hetero atom, and may be either unsubstituted or substituted. In the formula (2), in a case where $R^7$ includes a substituent represented by the formula (7) and $R^{28}$ is a hydrogen atom, the compound has an amic acid structure. In a case where $R^7$ includes a substituent represented by the formula (7) and $R^{28}$ is an alkyl group having 1 to 10 carbon atoms, an acyl group having 2 to 6 carbon atoms, or an aryl group having 6 to 15 carbon atoms, the compound has an amic acid ester structure. In a case where $R^7$ includes a substituent represented by the formula (8), the compound has an amic acid amide structure.

A polybenzoxazole unit refers to a unit having two benzoxazole structures among structural units of a resin including an amine residue and a carboxylic acid residue. The polybenzoxazole unit is preferably a unit represented by formula (3). A polybenzoxazole precursor unit refers to a unit having two hydroxyamide structures among structural units of a resin including an amine residue and a carboxylic acid residue. The polybenzoxazole precursor unit is preferably a unit represented by formula (4).

[Chemical Formula 10]

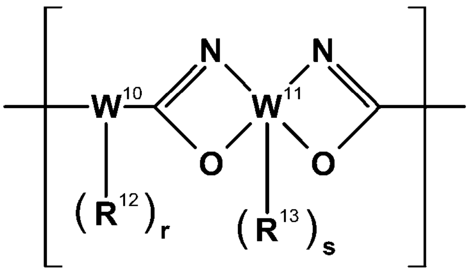
(3)
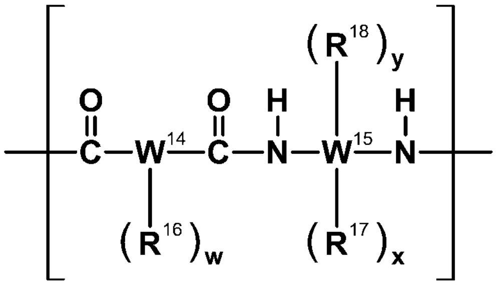
(4)

In the formula (3) and the formula (4), $W^{10}$ and $W^{14}$ each independently represent a divalent to decavalent organic group. $W^{11}$ and $W^{15}$ each independently represent a tetravalent to decavalent organic group having an aromatic structure. $R^{12}$, $R^{13}$, and $R^{16}$ each independently represent a phenolic hydroxyl group, a sulfonic acid group, a mercapto group, or a substituent represented by the above formula (7) or formula (8). $R^{17}$ represents a phenolic hydroxyl group. $R^{18}$ represents a sulfonic acid group, a mercapto group, or a substituent represented by the above formula (7) or formula (8). r represents an integer of 0 to 8. s represents an integer of 0 to 6. w represents an integer of 0 to 8. x represents an integer of 2 to 8, y represents an integer of 0 to 6, and $2 \leq x + y \leq 8$ is satisfied. However, in a case where $R^{12}$ or $R^{13}$ represents a phenolic hydroxyl group, $W^{10}$ or $W^{11}$ bonded to the phenolic hydroxyl group includes an aromatic structure in its structure. Further, in a case where $R^{16}$ represents a phenolic hydroxyl group, $W^{14}$ bonded to the phenolic hydroxyl group includes an aromatic structure in its structure. Further, $W^{15}$ bonded to $R^{17}$ includes an aromatic structure in its structure. $W^{10}$ and $W^{14}$ each independently represent a carboxylic acid residue. $W^{11}$ and $W^{15}$ each independently represent an amine residue. The substituents and structures described above may have a hetero atom, and may be either unsubstituted or substituted.

A polyamideimide unit refers to a unit having an imide structure and an amide structure among structural units of a resin including an amine residue and a carboxylic acid residue. The polyamideimide unit is preferably a unit represented by formula (5). A polyamideimide precursor unit refers to a unit having an amide structure and an amic acid structure, an amide structure and an amic acid ester structure, or an amide structure and an amic acid amide structure among structural units of a resin including an amine residue and a carboxylic acid residue. The polyamideimide precursor unit is preferably a unit having an amide structure and an amic acid structure or an amide structure and an amic acid ester structure. The polyamideimide precursor unit is preferably a unit represented by the formula (5).

[Chemical Formula 11]

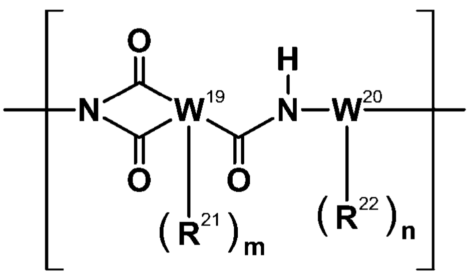
(5)
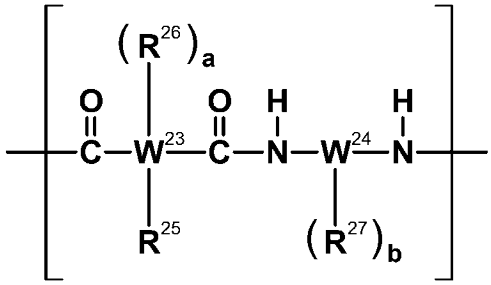
(6)

In the formula (5) and formula (6), $W^{19}$ and $W^{23}$ each independently represent a trivalent to decavalent organic group. $W^{20}$ and $W^{24}$ each independently represent a divalent to decavalent organic group. $R^{21}$, $R^{22}$, and $R^{27}$ each independently represent a phenolic hydroxyl group, a sulfonic acid group, a mercapto group, or a substituent represented by the above formula (7) or formula (8). $R^{25}$ represents a substituent represented by the formula (7) or formula (8). $R^{26}$ represents a phenolic hydroxyl group, a sulfonic acid group, or a mercapto group. m represents an integer of 0 to 7. n represents an integer of 0 to 8. a represents an integer of 0 to 7. b represents an integer of 0 to 8. However, in a case where $R^{21}$ or $R^{22}$ represents a phenolic hydroxyl group, $W^{19}$ or $W^{20}$ bonded to the phenolic hydroxyl group includes an aromatic structure in its structure. Further, in a case where $R^{26}$ or $R^{27}$ represents a phenolic hydroxyl group, $W^{23}$ or $W^{24}$ bonded to the phenolic hydroxyl group includes an aromatic structure in its structure. $W^{19}$ and $W^{23}$ each independently represent a carboxylic acid residue. $W^{20}$ and $W^{24}$ each independently represent an amine residue. The substituents and structures described above may have a hetero atom, and may be either unsubstituted or substituted.

Each of the polyimide unit, the polyimide precursor unit, the polybenzoxazole unit, the polybenzoxazole

precursor unit, the polyamideimide unit, and the polyamideimide precursor unit is a structural unit constituting a resin, and is a recurring unit having a recurring number of two or more. The number of repetitions of these units is preferably 2 or more, more preferably 5 or more, and still more preferably 10 or more. On the other hand, the number of repetitions is preferably 1,000 or less.

A resin in which the content ratio of the polyimide unit to the total of the polyimide unit and the polyimide precursor unit is 50 mol% or more is classified as a polyimide. On the other hand, a resin in which the content ratio of the polyimide unit is less than 50 mol% is classified as a polyimide precursor. Similarly, a resin in which the content ratio of the polybenzoxazole unit to the total of the polybenzoxazole unit and the polybenzoxazole precursor unit is 50 mol% or more is classified as a polybenzoxazole. On the other hand, a resin in which the content ratio of the polybenzoxazole unit is less than 50 mol% is classified as a polybenzoxazole precursor. Similarly, a resin in which the content ratio of the polyamideimide unit to the total of the polyamideimide unit and the polyamideimide precursor unit is 50 mol% or more is classified as a polyamideimide. On the other hand, a resin in which the content ratio of the polyamideimide unit is less than 50 mol% is classified as a polyamideimide precursor. The content ratios of the polyimide unit and the polyimide precursor unit can be calculated from an imide cyclization ratio of the resin. The content ratios of the polybenzoxazole unit and the polybenzoxazole precursor unit can be calculated from a benzoxazole cyclization ratio of the resin. The content ratios of the polyamideimide unit and the polyamideimide precursor unit can be calculated from the imide cyclization ratio of the resin.

Note that, resins having two or more types selected from the group consisting of (1) a polyimide unit or a precursor unit thereof, (2) a polybenzoxazole unit or a precursor unit thereof, and (3) a polyamideimide unit or a precursor unit thereof are classified into both resins based on the respective units. In other words, a resin having a polyimide precursor unit and a polybenzoxazole precursor unit is classified into both a polyimide precursor and a polybenzoxazole precursor. Further, in a case where a certain structural unit in the resin corresponds to, for example, both the polyimide precursor unit and the polybenzoxazole precursor unit, the structural unit is used when calculating each of the total content ratio of the polyimide precursor unit in the resin and the total content ratio of the polybenzoxazole precursor unit in the resin.

In the resin of the present invention, the content ratio of the polyimide unit to the total of the polyimide unit and the polyimide precursor unit is preferably 1.0 mol% or more, more preferably 3.0 mol% or more, still more preferably 5.0 mol% or more, still more preferably 7.0 mol% or more, and particularly preferably 10 mol% or more from the viewpoint of the effects of the invention described above. On the other hand, the content ratio of the polyimide unit is preferably 30 mol% or less, more preferably 25 mol% or less, and still more preferably 20 mol% or less from the viewpoint of the effects of the invention described above.

In the resin of the present invention, the content ratio of the amic acid ester structure to the total of the amic acid structure and the amic acid ester structure in the polyimide precursor unit is preferably 40 mol% or more, more preferably 45 mol% or more, still more preferably 50 mol% or more, still more preferably 55 mol% or more, and particularly preferably 60 mol% or more from the viewpoint of the effects of the invention described above. On the other hand, the content ratio of the amic acid ester structure is preferably 99 mol% or less, more preferably 95 mol% or less, still more preferably 90 mol% or less, still more preferably 80 mol% or less, and particularly preferably 70 mol% or less from the viewpoint of the effects of the invention described above.

In the resin of the present invention, in a case where the content ratio of the polyimide unit has such a configuration and/or in a case where the content ratio of the amic acid ester structure to the total of the amic acid structure and the amic acid ester structure has such a configuration, it is preferable that the resin of the present invention has the first amine residue (DA1) and the first amine residue (DA1) has an amine residue satisfying the above condition (S1x). Further, it is preferable that the resin of the present invention further has the second amine residue (DA2) and satisfies the above condition ($\alpha$1) and/or condition ($\alpha$2), and it is more preferable that the first amine residue (DA1) has an amine residue satisfying the above conditions (S1x) and/or the second amine residue (DA2) has an amine residue satisfying at least one of the above conditions (S1x) and (S2x).

It is preferable that the resin of the present invention has a polyimide unit and/or a polyimide precursor unit, and has one or more types selected from the group consisting of a polybenzoxazole unit, a polybenzoxazole precursor unit, a polyamideimide unit, and a polyamideimide precursor unit from the viewpoint of suppressing residues after development, achieving low voltage driving of the light emission characteristics, improving the reliability of the light emitting element, and improving the migration resistance.

In the resin of the present invention, the total content ratio of the polybenzoxazole unit, the polybenzoxazole precursor unit, the polyamideimide unit, and the polyamideimide precursor unit to the total of the polyimide unit, the polyimide precursor unit, the polybenzoxazole unit, the polybenzoxazole precursor unit, the polyamideimide unit, and the polyamideimide precursor unit is preferably 10 mol% or more, more preferably 20 mol% or more, still more preferably 30 mol% or more, still more preferably 40 mol% or more, and particularly preferably 50 mol% or more from the viewpoint of the effects of the invention described above. On the other hand, the total content ratio of the polybenzoxazole unit, the polybenzoxazole precursor unit, the polyamideimide unit, and the polyamideimide precursor unit is preferably 90 mol% or less, more preferably 85 mol% or less, still more preferably 80 mol% or less, still more preferably 75 mol% or less, and

particularly preferably 70 mol% or less from the viewpoint of the effects of the invention described above.

In the resin of the present invention, in a case where the total content ratio of the polybenzoxazole unit, the polybenzoxazole precursor unit, the polyamideimide unit, and the polyamideimide precursor unit has such a configuration, it is preferable that the resin of the present invention has the first amine residue (DA1), and the first amine residue (DA1) has an amine residue satisfying the above condition (S1x). Further, it is preferable that the resin of the present invention further has the second amine residue (DA2) and satisfies the above condition ($\alpha$1) and/or condition ($\alpha$2), and it is more preferable that the first amine residue (DA1) has an amine residue satisfying the above conditions (S1x) and/or the second amine residue (DA2) has an amine residue satisfying at least one of the above conditions (S1x) and (S2x).

<Content of Fluorine Element in Structure of Resin>

The resin of the present invention satisfies the following condition (P1a). The resin of the present invention preferably further satisfies the following condition (P2a).

(P1a) The content of the fluorine element in the structure of the resin is 10,000 ppm by mass or less.

(P2a) The content of fluoride ions in the structure of the resin is 10,000 ppm by mass or less.

The content of the fluorine element in the structure of the resin is preferably 0 ppm by mass or more, more preferably 0.010 ppm by mass or more, still more preferably 0.030 ppm by mass or more, still more preferably 0.050 ppm by mass or more, particularly preferably 0.070 ppm by mass or more, and most preferably 0.10 ppm by mass or more from the viewpoint of suppressing residues after development, achieving low voltage driving of the light emission characteristics, improving the reliability of the light emitting element, and improving the migration resistance. On the other hand, from the viewpoint of the effects of the invention described above, the content of the fluorine element is preferably 10,000 ppm by mass or less, more preferably 5,000 ppm by mass or less, still more preferably 1,000 ppm by mass or less, still more preferably 500 ppm by mass or less, particularly preferably 300 ppm by mass or less, and most preferably 100 ppm by mass or less. Furthermore, the content of the fluorine element is preferably 50 ppm by mass or less, more preferably 30 ppm by mass or less, still more preferably 10 ppm by mass or less, even more preferably 5 ppm by mass or less, particularly preferably 3 ppm by mass or less, and most preferably 1 ppm by mass or less.

A preferred range of the content of fluoride ions in the structure of the resin is also the same as the preferred range of the content of the fluorine element in the structure of the resin described above.

The content of the fluorine element in the structure of the resin may be 0 ppm by mass. The content of fluoride ions in the structure of the resin may also be 0 ppm by mass.

When the storage stability of the photosensitive composition is poor, for example, foreign matter generation after storage at room temperature may be a problem. In a case where foreign matter is generated during storage of the photosensitive composition, foreign matter remains in the pixel dividing layer layer or a pattern opening when a pixel dividing layer or the like is formed using the photosensitive composition. Such foreign matter causes, for example, a decrease in reliability of the light emitting element in the display device of the present invention and a decrease in migration resistance in the electronic component of the present invention. By setting the content of the fluorine element in the structure of the resin of the present invention within a specific range, generation of foreign matters during storage of the photosensitive composition is suppressed, and the effect of improving storage stability becomes remarkable.

<Contents of Chlorine Element, Bromine Element, and Sulfur Element in Structure of Resin>

It is preferable that the resin of the present invention further satisfies at least one of the following conditions (P1b), (P1c), and (P1d) from the viewpoint of suppressing residues after development, achieving low voltage driving of the light emission characteristics, improving the reliability of the light emitting element, and improving the migration resistance. It is more preferable that the resin of the present invention further satisfies at least one of the following conditions (P2b), (P2c), and (P2d).

Sulfur-based anion: one or more ions selected from the group consisting of a sulfide ion, a hydrogen sulfide ion, a sulfate ion, and a hydrogen sulfate ion

(P1b) The content of the chlorine element in the structure of the resin is 30,000 ppm by mass or less.
(P1c) The content of the bromine element in the structure of the resin is 30,000 ppm by mass or less.
(P1d) The content of the sulfur element in the structure of the resin is 30,000 ppm by mass or less.
(P2b) The content of chloride ions in the structure of the resin is 30,000 ppm by mass or less.
(P2c) The content of bromide ions in the structure of the resin is 30,000 ppm by mass or less.
(P2d) The content of the sulfur-based anions described above in the structure of the resin is 30,000 ppm by mass or less.

From the viewpoint of the effects of the invention described above, the content of the chlorine element in the

structure of the resin is preferably 0 ppm by mass or more, more preferably 0.010 ppm by mass or more, still more preferably 0.030 ppm by mass or more, still more preferably 0.050 ppm by mass or more, particularly preferably 0.070 ppm by mass or more, and most preferably 0.10 ppm by mass or more. On the other hand, the content of the chlorine element is preferably 30,000 ppm by mass or less, more preferably 10,000 ppm by mass or less, and still more preferably 5,000 ppm by mass or less from the viewpoint of the effects of the invention described above. Furthermore, the content of the chlorine element is preferably 1,000 ppm by mass or less, more preferably 500 ppm by mass or less, still more preferably 300 ppm by mass or less, and particularly preferably 100 ppm by mass or less. Furthermore, the content of the chlorine element is preferably 50 ppm by mass or less, more preferably 30 ppm by mass or less, still more preferably 10 ppm by mass or less, still more preferably 5 ppm by mass or less, particularly preferably 3 ppm by mass or less, and most preferably 1 ppm by mass or less.

Preferred ranges of the content of the bromine element, the content of the sulfur element, the content of chloride ions, the content of bromide ions, and the content of sulfur-based anions in the structure of the resin are also the same as the preferred ranges of the content of the chlorine element described above.

One or more selected from the group consisting of the content of the chlorine element, the content of the bromine element, and the content of the sulfur element in the structure of the resin may be 0 ppm by mass. One or more selected from the group consisting of the content of chloride ions, the content of bromide ions, and the content of sulfur-based anions in the structure of the resin may be 0 ppm by mass.

In a case where the resin of the present invention satisfies at least one of the above conditions (P1b), (P1c), and (P1d), it is preferable that the resin of the present invention has the first amine residue (DA1), and the first amine residue (DA1) has an amine residue that satisfies the above condition (S1x). Further, it is preferable that the resin of the present invention further has the second amine residue (DA2) and satisfies the above condition ($\alpha$1) and/or condition ($\alpha$2), and it is more preferable that the first amine residue (DA1) has an amine residue satisfying the above conditions (S1x) and/or the second amine residue (DA2) has an amine residue satisfying at least one of the above conditions (S1x) and (S2x).

<Photosensitive Composition>

A photosensitive composition according to a first aspect of the present invention is a photosensitive composition containing a binder resin (A) and a photosensitive agent (C), and further containing a radical polymerizable compound (B) and/or a crosslinking agent (F), in which the binder resin (A) includes the resin of the present invention.

A photosensitive composition according to a second aspect of the present invention is a photosensitive composition containing a binder resin (A) and a photosensitive agent (C), and further containing a radical polymerizable compound (B) and/or a crosslinking agent (F), in which

the binder resin (A) includes a resin (Ax): one or more resins selected from the group consisting of a polyimide, a polyimide precursor, a polybenzoxazole, a polybenzoxazole precursor, a polyamideimide, a polyamideimide precursor, and a copolymer thereof, and
the resin (Ax) has a first amine residue (DA1): an amine residue having a phenolic hydroxyl group, and the first amine residue (DA1) has at least two structures (Ia): a cyclic structure having a phenolic hydroxyl group, and a structure (IIa): a structure linking at least two of the structures (Ia), and
the structure (IIa) is a sulfonyl group, an alkylene group, a condensed polycyclic structure, a hydrocarbon group including an ether bond, a direct bond, an ether bond, a sulfide bond, a carbonyl group, a carboxylate ester bond, an amide bond, a urea bond, a urethane bond, a carbonate ester bond, a cycloalkylene group, an arylene group, a condensed polycyclic heterocyclic structure, a hydrocarbon group including a carbonyloxy group, or a hydrocarbon group including a carbonyl amide group,
and the photosensitive composition satisfies the following condition (1a):
(1a) a content of a fluorine element in a total solid content of the photosensitive composition is 1,000 ppm by mass or less.

With the above configuration, the photosensitive composition according to the first aspect and the second aspect of the present invention is capable of suppressing residues after development, has excellent light emission characteristics capable of low voltage driving in obtaining a desired current density, and can obtain a cured product included in a display device having excellent reliability of a light emitting element. In addition, a cured product included in an electronic component excellent in migration resistance can be obtained. It is presumed that when the content of the compound including a fluorine atom or the component including a fluorine element in the structure in the photosensitive composition is set to a specific value or less, the content of the fluorine element or fluoride ions in these components or the anions including a fluorine element derived from these components is set to a specific value or less, and therefore protons in the photosensitive composition are locally activated by an interaction such as hydrogen bonding of each component in the photosensitive composition. Therefore, it is considered that the effect of suppressing the residue after development is

achieved by the dissolution promoting action on the developer. In addition, since the surface of the substrate is surface-modified by these components, it is presumed that the effect of suppressing residues after development is achieved by preventing residue adhesion at the opening, and the effects of achieving low voltage driving of light emission characteristics and improving the luminance become remarkable. Furthermore, it is considered that by containing a polyimide or the like having an amine residue with a specific structure having a phenolic hydroxyl group, the hydrogen bond between the phenolic hydroxyl group and a fluorine atom improves stability of the component including the fluorine element and the anion including the fluorine element in the photosensitive composition, and contributes to the effect of suppressing residues after development.

Further, it is considered that by intentionally setting the content of the above components to a specific value or less, the detection intensity of these ions on the surface of the cured product is adjusted and the polarization structure and charge balance in the cured product are controlled. As a result, it is presumed that the effect of high reliability or excellent migration resistance of the light emitting element is achieved by suppressing ion migration and electromigration caused by metal impurities and ion impurities that adversely affect the light emission characteristics or electrical insulation properties. In addition, it is presumed that a highly reliable effect in a display device, an electronic component, or a semiconductor device is achieved by suppressing migration or aggregation of a metal in an electrode or a metal in a metal wiring.

<Binder Resin (A)>

The photosensitive composition of the present invention contains a binder resin (A). The photosensitive composition according to the first aspect of the present invention includes the resin of the present invention. In other words, in the photosensitive composition according to the first aspect of the present invention, the binder resin (A) contains the resin of the present invention. The photosensitive composition according to the second aspect of the present invention preferably includes the resin of the present invention. In other words, in the photosensitive composition according to the second aspect of the present invention, the binder resin (A) preferably contains the resin of the present invention.

In the photosensitive composition of the present invention, the binder resin (A) contains the resin of the present invention. In this case, it is preferable that the binder resin (A) contains one or more resins selected from the group consisting of the polyimide-based resins and has the first amine residue (DA1), and the first amine residue (DA1) has at least two of the structures (Ia) and further has the structure (IIa). In such a configuration, in the binder resin (A), the first amine residue (DA1) preferably has an amine residue that satisfies the above condition (S1x).

In the photosensitive composition of the present invention, in a case where the binder resin (A) contains one or more resins selected from the group consisting of the polyimide-based resins and has the first amine residue (DA1), it is preferable that the binder resin (A) further has the second amine residue (DA2) and satisfies the above condition ($\alpha$1) and/or condition ($\alpha$2). In such a configuration, it is preferable that in the binder resin (A), the first amine residue (DA1) has an amine residue that satisfies the above condition (S1x) and/or the second amine residue (DA2) has an amine residue that satisfies at least one of the above conditions (S1x) and (S2x).

The binder resin (A) preferably has heat resistance with which at least a part remains in a cured product obtained by curing the composition. The binder resin (A) is preferably a resin in which a crosslinked structure is formed and cured by a reaction. The reaction is not particularly limited, and is caused, for example, by heating, irradiation with an energy ray, or the like, and the crosslinked structure may be formed by a crosslinking agent (F) described later. The binder resin (A) is preferably a thermosetting resin.

The binder resin (A) is preferably a resin capable of imparting positive-type or negative-type photosensitivity to the composition by the later-described photosensitive agent (C) and forming a positive-type or negative-type pattern. The binder resin (A) is more preferably an alkali-soluble resin having an acidic group in the structural unit of the resin or an organic solvent-soluble resin having an organic solvent-soluble structure. The acidic group is preferably a phenolic hydroxyl group, a hydroxyimide group, a hydroxyamide group, a silanol group, a mercapto group, a carboxy group, a carboxylic anhydride group, or a sulfonic acid group from a viewpoint of pattern processability with an alkaline developer, and is more preferably a carboxy group, a carboxylic anhydride group, or a sulfonic acid group from a viewpoint of improving sensitivity during exposure and suppressing residues after development.

From the viewpoint of improving the sensitivity during exposure, the binder resin (A) preferably has a radical polymerizable group, and more preferably has a radical polymerizable group in the structural unit of the resin. The radical polymerizable group is preferably a group having an ethylenically unsaturated double bond group, and more preferably a photoreactive group, an alkenyl group having 2 to 5 carbon atoms, or an alkynyl group having 2 to 5 carbon atoms. The photoreactive group is preferably a styryl group, a cinnamoyl group, a maleimide group, a nadimide group, or a (meth)acryloyl group, and more preferably a (meth)acryloyl group from the viewpoint of improving the sensitivity during exposure. On the other hand, the alkenyl group having 2 to 5 carbon atoms or the alkynyl group having 2 to 5 carbon atoms is preferably a vinyl group, an allyl group, a 2-methyl-2-propenyl group, a crotonyl group, a 2-methyl-2-butenyl group, a 3-methyl-2-butenyl group, a 2,3-dimethyl-2-butenyl group, an ethynyl group, or a 2-propargyl group, and is more preferably a vinyl group or an allyl group from the viewpoint of improving the sensitivity during exposure.

<Resin (A1) and Resin (A2) >

The binder resin (A) preferably contains a weakly acidic group-containing resin (A1) and/or a resin having no weakly acidic group (A2). The binder resin (A) preferably includes a weakly acidic group-containing resin (A1) from the viewpoint of improving the sensitivity during exposure. The weakly acidic group-containing resin (A1) preferably has a weakly acidic group (WA): one or more groups selected from the group consisting of a phenolic hydroxyl group, a hydroxyimide group, a hydroxyamide group, a silanol group, and a mercapto group, and more preferably has a weakly acidic group (WA) in the structural unit of the resin. The weakly acidic group (WA) is preferably a phenolic hydroxyl group or a silanol group, more preferably a phenolic hydroxyl group, from the viewpoint of improving the sensitivity during exposure and suppressing residues after development. In the binder resin (A), the weakly acidic group-containing resin (A1) preferably has a radical polymerizable group from the viewpoint of improving the sensitivity during exposure. Examples and preferred descriptions of the radical polymerizable group are as described for the above binder resin (A).

In the weakly acidic group-containing resin (A1), the solubility of an exposed portion is improved by the interaction between a moderate acidity of the weakly acidic group (WA) and the photosensitive agent (C) to be described later, so that the effect of improving the sensitivity during exposure becomes remarkable. Among the weakly acidic groups (WA), the phenolic hydroxyl group has an alkali dissolution promoting action, so that the effect of suppressing residues after development becomes remarkable. Further, in a case where the composition has positive-type photosensitivity, the phenolic hydroxyl group among the weakly acidic groups (WA) can enhance a dissolution contrast between the exposed portion and an unexposed portion by strong interaction with the photosensitive agent (C), and the dissolution promoting action in the exposed portion is also improved, so that the effects of improving the sensitivity during exposure and suppressing residues after development become remarkable.

It is also preferable that the binder resin (A) includes a resin having no weakly acidic group (A2) from the viewpoint of suppressing residues after development. The resin having no weakly acidic group (A2) preferably has an acidic group different from the weakly acidic group (WA), and more preferably has an acidic group different from the weakly acidic group (WA) in the structural unit of the resin. The acidic group different from the weakly acidic group (WA) is preferably a group selected from a carboxy group, a carboxylic anhydride group, and a sulfonic acid group from the viewpoint of improving the sensitivity during exposure and suppressing residues after development.

It is preferable that the binder resin (A) contains the weakly acidic group-containing resin (A1) and/or the resin having no weakly acidic group (A2), the weakly acidic group-containing resin (A1) includes a resin (A1x): a resin having one or more selected from the group consisting of an imide structure, an amide structure, an oxazole structure, and a siloxane structure (hereinafter, "imide structure and the like") in the structural unit of the resin and/or a resin (A1y): a resin having a phenolic hydroxyl group in the structural unit of the resin, and the resin having no weakly acidic group (A2) includes a resin (A2x): a resin having a radical polymerizable group and/or a resin (A2y): a resin having no radical polymerizable group. The binder resin (A) preferably contains the weakly acidic group-containing resin (A1) and the resin having no weakly acidic group (A2) from the viewpoint of improving the sensitivity during exposure and suppressing residues after development.

Both the structural unit having an imide structure and the like and the structural unit having a phenolic hydroxyl group are structural units constituting a resin, and are repeating units having two or more repeating units. The number of repetitions of these units is preferably 2 or more, more preferably 5 or more, and still more preferably 10 or more. On the other hand, the number of repetitions is preferably 1,000 or less. The number of repetitions of these units is preferably 2 or more, more preferably 5 or more, and still more preferably 10 or more. On the other hand, the number of repetitions is preferably 1,000 or less. The structural unit having an imide structure is preferably the polyimide unit or the polyamideimide unit described above. The structural unit having an amide structure is preferably the polyimide precursor unit, the polybenzoxazole precursor unit, the polyamideimide unit, or the polyamideimide precursor unit described above. The structural unit having an oxazole structure is preferably the polybenzoxazole unit described above.

Note that, in a case where each of the resin (A1x), the resin (A1y), the resin (A2x), and the resin (A2y) has a structure or a group constituting another resin among these resins, these resins are classified into any one of the resins by a classification method shown in Table 1-1 below. In a case where a certain resin can correspond to two or more of the resin (A1x), the resin (A1y), the resin (A2x), and the resin (A2y), which resin it corresponds to is determined by the classification method.

[Table 1-1]

| | Weakly acidic group (WA) | Structural unit having imide structure or the like | structural unit including phenolic hydroxyl group | Radical polymerizable group | Classification of resin |
|---|---|---|---|---|---|
| Resin 1 | Present | Present | Present | Present | Resin (A1x) |
| Resin 2 | Present | Present | Present | Absent | Resin (A1x) |

(continued)

| | Weakly acidic group (WA) | Structural unit having imide structure or the like | structural unit including phenolic hydroxyl group | Radical polymerizable group | Classification of resin |
|---|---|---|---|---|---|
| Resin 3 | Present | Present | Absent | Present | Resin (A1x) |
| Resin 4 | Present | Present | Absent | Absent | Resin (A1x) |
| Resin 5 | Present | Absent | Present | Present | Resin (A1y) |
| Resin 6 | Present | Absent | Present | Absent | Resin (A1y) |
| Resin 7 | Absent | Present | Absent | Present | Resin (A2x) |
| Resin 8 | Absent | Present | Absent | Absent | Resin (A2y) |
| Resin 9 | Absent | Absent | Absent | Present | Resin (A2x) |
| Resin 10 | Absent | Absent | Absent | Absent | Resin (A2y) |

The binder resin (A) preferably contains the resin (Alx) and/or the resin (A1y), more preferably contains the resin (A1x), and still more preferably contains the resin (A1x) and the resin (A1y). Further, the binder resin (A) contains the resin (Alx) and/or the resin (A1y), preferably further contains the resin (A2x), and more preferably contains the resin (A1x), the resin (A1y), and the resin (A2x). Further, it is also preferable that the binder resin (A) contains the resin (A1x), the resin (A1y), or the resin (A2x), and further contains the resin (A2y). Further, it is also preferable that the binder resin (A) contains two or more types selected from the group consisting of the resin (A1x), the resin (A1y), the resin (A2x), and the resin (A2y) from a viewpoint of improving the characteristics by each resin.

It is also preferable that the weakly acidic group-containing resin (A1) has a structure in which the weakly acidic group (WA) is protected by a tert-butyl group, a tert-butoxycarbonyl group, or an oxyalkyl group, from the viewpoint of improving the sensitivity during exposure. It is also preferable that the resin having no weakly acidic group (A2) has a structure in which an acidic group different from the weakly acidic group (WA) is protected by a tert-butyl group, a tert-butoxycarbonyl group, or an oxyalkyl group, from the viewpoint of improving the sensitivity during exposure. The oxyalkyl group is preferably an alkoxyalkyl group, and more preferably a 1-alkoxy-1-ethyl group. The structure protected by the oxyalkyl group is preferably a structure derived from a vinyl ether compound. In a case of having the structure as described above, it is preferable that the photosensitive agent (C) to be described later contains a photoacid generator (C3) or a photobase generator (C4).

<Resin (A1x) >

In a case where the binder resin (A) includes the weakly acidic group-containing resin (A1), it is preferable that the weakly acidic group-containing resin (A1) includes a resin (Alx) from the viewpoint of improving the sensitivity during exposure, achieving low voltage driving of the light emission characteristics, improving of the reliability of the light emitting element, and improving the migration resistance. The resin (A1x) preferably contains a resin (A1x-1): a polyimide, a resin (A1x-2): a polyimide precursor, a resin (A1x-3): a polybenzoxazole, a resin (A1x-4): a polybenzoxazole precursor, a resin (Alx-5): a polyamideimide, a resin (A1x-6): a polyamideimide precursor, a resin (A1x-7): a polyamide, and a resin (A1x-8): one or more resins selected from the group consisting of a polysiloxane, a maleimide resin, a maleimide-styrene resin, a maleimide-triazine resin, a maleimide-oxazine resin, and a copolymer thereof, and more preferably contains one or more resins selected from the group consisting of the resin (A1x-1), the resin (A1x-2), the resin (A1x-3), the resin (A1x-4), the resin (A1x-5), the resin(A1x-6), and a copolymer thereof (hereinafter, "polyimide-based resins having a weakly acidic group"). The resin (A1x) further preferably contains two or more types of resins selected from the group consisting of polyimide-based resins having a weakly acidic group, and particularly preferably contains the resin (A1x-2) and the resin (A1x-4). The polyimide-based resin having a weakly acidic group may further be a copolymer with the resin (A1x-7). The polyimide-based resin having a weakly acidic group preferably contains the resin of the present invention. From the viewpoint of improving the reliability of the light emitting element and improving the migration resistance, the resin 0(A1x) more preferably contains the resin (A1x-1) and/or the resin (A1x-3). It is more preferable that the resin (A1x) contains the resin (Alx-2) and/or the resin (A1x-4) from the viewpoint of improving the sensitivity during exposure and achieving low voltage driving of the light emission characteristics. The resin (A1x) may be a single resin or a copolymer thereof.

The resin (A1x) preferably has a radical polymerizable group from the viewpoint of improving the sensitivity during exposure. Examples and preferred descriptions of the radical polymerizable group are as described for the above binder resin (A). The radical polymerizable group is preferably obtained by reaction of a part of the phenolic hydroxyl group and/or carboxy group of the resin with a compound having a radical polymerizable group.

It is preferable that the resin (A1x) contains a resin (A1x) having no radical polymerizable group and a resin (A1x) having a radical polymerizable group, from the viewpoint of improving the sensitivity during exposure, suppressing residues after development, achieving low voltage driving of the light emission characteristics, improving the reliability of the light emitting element, and improving the migration resistance. With the above configuration, the effect of improving a plurality of characteristics becomes remarkable due to a functional separation between residue suppression after development by an acidic group or an organic solvent-soluble structure and an ability to capture metal impurities, ion impurities, and the like, and improvement of the sensitivity during exposure by a radical polymerizable group and improvement of a degree of crosslinking of the film.

An acid equivalent of the resin (Alx) is preferably 200 g/mol or more from the viewpoint of improving the sensitivity during exposure. On the other hand, the acid equivalent of the resin (A1x) is preferably 600 g/mol or less from the viewpoint of suppressing residues after development. The exposure herein refers to irradiation with actinic radiation (radiant rays), and examples thereof include irradiation with visible light, ultraviolet rays, electron beams, X-rays, or the like. Hereinafter, exposure refers to irradiation with actinic radiation (radiant rays). A double bond equivalent of the resin (Alx) is preferably 200 g/mol or more from the viewpoint of suppressing residues after development. On the other hand, the double bond equivalent of the resin (A1x) is preferably 3,000 g/mol or less from the viewpoint of improving the sensitivity during exposure.

On the other hand, it is preferable that the resin (A2x) and the resin (A2y) contain one or more resins selected from the group consisting of a polyimide, a polyimide precursor, a polybenzoxazole, a polybenzoxazole precursor, a polyamideimide, a polyamideimide precursor, and a copolymer thereof (hereinafter, "polyimide-based resins having no weakly acidic group") from the viewpoint of improving the sensitivity during exposure and suppressing residues after development. The polyimide-based resin having no weakly acidic group may further be a copolymer with a polyamide. The polyimide-based resin having no weakly acidic group preferably contains the resin of the present invention.

Hereinafter, a polyimide-based resin having a weakly acidic group and a polyimide-based resin having no weakly acidic group will be collectively described. These resins may be collectively referred to as polyimide-based resins. The polyimide-based resin preferably contains the resin of the present invention. The polyimide precursor preferably has an amic acid structure and an amic acid ester structure from the viewpoint of improving the sensitivity during exposure and achieving low voltage driving of the light emission characteristics.

From the viewpoint of improving the storage stability, the polyimide-based resin preferably has a structure sealed with a monoamine, a dicarboxylic acid anhydride, or a monocarboxylic acid derivative at a resin end. The polyimide-based resin preferably has a radical polymerizable group or a crosslinkable group capable of reacting with the resin or the like at the resin end, and more preferably has a maleimide group or a nadimide group, from the viewpoint of improving the sensitivity during exposure, achieving low voltage driving of the light emission characteristics, improving the reliability of the light emitting element, and improving the migration resistance. Examples of an acid monomer having these groups include maleic anhydride and nadic anhydride.

The maleimide resin is a resin having at least two maleimide groups. The maleimide-styrene resin is a resin having a maleimide group and a unit derived from a styrene derivative. The maleimide-triazine resin is a resin having a maleimide group and a unit including a triazine structure. The maleimide-oxazine resin is a resin having a maleimide group and a unit including an oxazine structure. These resins are different from polyimide-based resins.

In the photosensitive composition according to the second aspect of the present invention, the binder resin (A) contains a resin (Ax): one or more resins selected from the group consisting of a polyimide, a polyimide precursor, a polybenzoxazole, a polybenzoxazole precursor, a polyamideimide, a polyamideimide precursor, and a copolymer thereof (hereinafter, "polyimide-based resins"). In the photosensitive composition according to the second aspect of the present invention, the binder resin (A) is preferably a resin (Ax).

In the photosensitive composition according to the second aspect of the present invention, the binder resin (A) has a first amine residue (DA1): an amine residue having a phenolic hydroxyl group, and the first amine residue (DA1) has at least two of the structures (Ia) described above: a cyclic structure having a phenolic hydroxyl group, and further has the structure (IIa) described above: a structure linking at least two structures (Ia). In the photosensitive composition according to the second aspect of the present invention, the resin (Ax) has a first amine residue (DA1), and the first amine residue (DA1) has at least two of the structures (Ia) described above, and further has the structure (IIa) described above.

In the photosensitive composition according to the second aspect of the present invention, the structure (IIa) in the first amine residue (DA1) is a sulfonyl group, an alkylene group, a condensed polycyclic structure, a hydrocarbon group including an ether bond, a direct bond, an ether bond, a sulfide bond, a carbonyl group, a carboxylate ester bond, an amide bond, a urea bond, a urethane bond, a carbonate ester bond, a cycloalkylene group, an arylene group, a condensed polycyclic heterocyclic structure, a hydrocarbon group including a carbonyloxy group, or a hydrocarbon group including a carbonylamide group.

In the photosensitive composition according to the second aspect of the present invention, it is preferable that the binder resin (A) further has a second amine residue (DA2): an amine residue having no phenolic hydroxyl group, and satisfies the above condition ($\alpha$1) and/or condition ($\alpha$2).

<Resin (A1y) >

The weakly acidic group-containing resin (A1) preferably includes a resin (A1y) from the viewpoint of improving the sensitivity during exposure, suppressing residues after development, improving the reliability of the light emitting element, and improving the migration resistance. From the viewpoint of the effects of the invention described above, it is preferable that the resin (A1y) contains one or more resins selected from the group consisting of a phenolic resin, polyhydroxystyrene, a phenol group-containing epoxy resin, and a phenol group-containing acrylic resin. In other words, it is preferable that the photosensitive composition of the present invention further contains one or more resins selected from the group consisting of a phenolic resin, polyhydroxystyrene, a phenol group-containing epoxy resin, and a phenol group-containing acrylic resin. The resin (A1y) may be a single resin or a copolymer thereof.

The phenolic resin is preferably a novolac resin, a resol resin, or a phenol aralkyl resin. The phenolic resin preferably has a condensed polycyclic structure, a condensed polycyclic heterocyclic structure, an aromatic structure, or a heterocyclic structure. The polyhydroxystyrene preferably has a unit derived from a (meth)acrylic acid ester derivative including a condensed polycyclic structure, a condensed polycyclic heterocyclic structure, or an aromatic structure, or a unit derived from a styrene derivative. Examples of the phenol group-containing epoxy resin include a resin obtained by reaction of a polyfunctional epoxy compound with a phenol compound having an epoxy-reactive group, and a phenol group-containing cardo-based resin or a phenol group-containing epoxy-modified resin is preferable. The phenol group-containing epoxy-modified resin is preferably a phenol group-containing epoxy ester resin. The phenol group-containing cardo-based resin preferably has a condensed polycyclic structure or a condensed polycyclic heterocyclic structure. The phenol group-containing epoxy-modified resin preferably has a condensed polycyclic structure, a condensed polycyclic heterocyclic structure, or an aromatic structure. Examples of the phenol group-containing acrylic resin include a resin obtained by further reaction of a phenol compound having an addition reactive group with an acrylic resin to be described later. Further, examples thereof also include a resin obtained by radical copolymerization of a copolymerization component having a phenolic hydroxyl group with another copolymerization component such as a (meth)acrylic acid derivative. Note that the phenol group-containing acrylic resin is a resin different from polyhydroxystyrene. The phenol group-containing acrylic resin preferably has a unit derived from a (meth)acrylic acid ester derivative including a condensed polycyclic structure, a condensed polycyclic heterocyclic structure, or an aromatic structure or a unit derived from a styrene derivative.

As the condensed polycyclic structure, the condensed polycyclic heterocyclic structure, the aromatic structure, or the heterocyclic structure in these resins, a fluorene structure, an anthracene structure, a naphthalene structure, a tricyclo[5.2.1.0$^{2,6}$]decane structure, an adamantane structure, a xanthene structure, an isoindolinone structure, a biphenyl structure, a benzene structure, a bisphenol A structure, a bisphenol F structure, a bisphenol AF structure, an isocyanuric acid structure, or a triazine structure is preferable.

<Resin (A2x) and Resin (A2y)>

The resin having no weakly acidic group (A2) preferably includes a resin (A2x), and more preferably includes a resin (A2y), from the viewpoint of improving the sensitivity during exposure and suppressing residues after development. The resin (A2x) preferably contains one or more resins selected from the group consisting of a polycyclic side chain-containing resin, an acid-modified epoxy resin, and an acrylic resin from the viewpoint of improving the sensitivity during exposure and suppressing residues after development. The resin (A2x) may be either a single resin or a copolymer thereof. The polycyclic side chain-containing resin is preferably a cardo-based resin having a condensed polycyclic structure or a condensed polycyclic heterocyclic structure. The acid-modified epoxy resin is preferably an epoxy(meth)acrylate resin having a condensed polycyclic structure, a condensed polycyclic heterocyclic structure, or an aromatic structure. The acrylic resin preferably has a unit derived from a (meth)acrylic acid ester derivative including a condensed polycyclic structure, a condensed polycyclic heterocyclic structure, or an aromatic structure, a unit derived from a styrene derivative, or a unit derived from a (meth)acrylic acid ester derivative having an epoxy group.

The total content ratio of the resin (A1x) to the total 100 mass% of the binder resin (A) is preferably 10 mass% or more, more preferably 30 mass% or more, still more preferably 50 mass% or more, and particularly preferably 70 mass% or more, from a viewpoint of the effect of the invention of the resin (A1x) described above. On the other hand, the total content ratio of the resin (A1x) is preferably 100 mass% or less, more preferably 90 mass% or less, and still more preferably 80 mass% or less from the viewpoint of suppressing residues after development. Further, the total content ratio of the resin (A1y) is preferably 5.0 mass% or more, more preferably 10 mass% or more, still more preferably 20 mass% or more, and particularly preferably 30 mass% or more from the viewpoint of the effect of the invention of the resin (A1x) described above. On the other hand, the total content ratio of the resin (A1y) is preferably 70 mass% or less, more preferably 60 mass% or less, and still more preferably 50 mass% or less from the viewpoint of achieving low voltage driving of the light emission characteristics. Further, the total content ratio of the resin (A2x) and the resin (A2x) is preferably 5.0 mass% or more, more preferably 10 mass% or more, still more preferably 20 mass% or more, and particularly preferably 30 mass%

or more from a viewpoint of the effects of the invention of the resin (A2x) and the resin (A2y) described above. On the other hand, the total content ratio of the resin (A2x) and the resin (A2y) is preferably 70 mass% or less, more preferably 60 mass% or less, and still more preferably 50 mass% or less, from the viewpoint of achieving low voltage driving of the light emission characteristics, improving the reliability of the light emitting element, and improving the migration resistance.
The content ratio of the binder resin (A) to the total solid content of the photosensitive composition of the present invention is preferably 10 mass% or more from the viewpoint of improving the characteristics by each resin. On the other hand, the content ratio of the binder resin (A) is preferably 75 mass% or less from the viewpoint of improving the characteristics by each resin. Note that the total solid content of the composition refers to the total mass of all components except the solvent in the composition. Further, the solid content concentration can be calculated as a solid content concentration calculated from the mass before and after heating by heating 1 g of the composition at 150°C for 30 minutes to evaporate to dryness and measuring the mass remaining after heating.

<Radical Polymerizable Compound (B)>

The photosensitive composition of the present invention further contains a radical polymerizable compound (B) (hereinafter, "compound (B)") and/or a crosslinking agent (F). The radical polymerizable compound (B) refers to a compound having a radical polymerizable group. Examples and preferred descriptions of the radical polymerizable group are as described for the above binder resin (A). The radical polymerizable group is preferably a (meth) acryloyl group from the viewpoint of improving the sensitivity during exposure. The number of radical polymerizable groups in the compound (B) is preferably 2 or more, more preferably 3 or more, still more preferably 4 or more from the viewpoint of improving the sensitivity during exposure. On the other hand, the number of radical polymerizable groups is preferably 12 or less, more preferably 10 or less, still more preferably 8 or less, and particularly preferably 6 or less from the viewpoint of suppressing residues after development.
The crosslinking agent (F) will be described later.
In a case where the photosensitive composition of the present invention contains the binder resin (A) and the compound (B), the content of the binder resin (A) is preferably 25 parts by mass or more, more preferably 35 parts by mass or more, and still more preferably 45 parts by mass or more, from a viewpoint of improving the reliability and mechanical properties of the light emitting element when the total of the binder resin (A) and the compound (B) is 100 parts by mass. On the other hand, the content of the binder resin (A) is preferably 85 parts by mass or less, more preferably 80 parts by mass or less, and still more preferably 75 parts by mass or less, from the viewpoint of improving the sensitivity during exposure and suppressing residues after development. Further, the content of the compound (B) is preferably 15 parts by mass or more when the total of the binder resin (A) and the compound (B) is 100 parts by mass, from a viewpoint of improving the characteristics described above. On the other hand, the content of the compound (B) is preferably 75 parts by mass or less from the viewpoint of improving the characteristics described above.

<Photosensitive Agent (C)>

The photosensitive composition of the present invention includes a photosensitive agent (C). The photosensitive agent (C) refers to a compound that gives positive-type or negative-type photosensitivity to a composition that undergoes bond cleavage, reaction, or structural change by exposure to generate another compound. The photosensitive agent (C) preferably includes one or more compounds selected from the group consisting of a naphthoquinonediazide compound (C1) (hereinafter, "compound (C1)"), a photopolymerization initiator (C2) (hereinafter, "compound (C2)"), a photoacid generator (C3) (hereinafter, "compound (C3)"), and a photobase generator (C4) (hereinafter, "compound (C4)").
The content of the photosensitive agent (C) is preferably 1.0 parts by mass or more when the total of the binder resin (A) and the compound (B) is 100 parts by mass, from the viewpoint of improving the sensitivity during exposure. On the other hand, the content of the photosensitive agent (C) is preferably 30 parts by mass or less from the viewpoint of suppressing residues after development.

<Naphthoquinonediazide Compound (C1)>

The compound (C1) refers to a compound whose structure is changed by exposure to generate an indene carboxylic acid and/or a sulfoindene carboxylic acid. Containing the compound (C1) is suitable for forming a positive-type pattern. During exposure, the exposed part of the film of the composition is selectively solubilized with an alkaline developer by the acidic compound in which the compound (C1) has a structural change, so that the effect of improving a resolution after development becomes remarkable.
The compound (C1) preferably contains a compound having a 1,2-naphthoquinonediazide-5-sulfonic acid ester structure (hereinafter, "5-ester structure") and/or a compound having a 1,2-naphthoquinonediazide-4-sulfonic acid ester structure (hereinafter, "4-ester structure"). From a viewpoint of improving the resolution after development, the compound

(C1) preferably contains a compound having a 5-ester structure. From the viewpoint of improving the sensitivity during exposure, the compound (C1) preferably contains a compound having a 4-ester structure. The compound (C1) more preferably contains a compound having a 5-ester structure and a compound containing a 4-ester structure from the viewpoint of improving the sensitivity during exposure, suppressing residues after development, and improving the resolution after development. In other words, the photosensitive agent (C) preferably contains a compound having a 1,2-naphthoquinonediazide-5-sulfonic acid ester structure and a compound containing a 1,2-naphthoquinonediazide-4-sulfonic acid ester structure. The compound (C1) preferably has a 5-ester structure of a phenolic hydroxyl group (hereinafter, "5-ester group") or a 4-ester structure of a phenolic hydroxyl group (hereinafter, "4-ester group").

The total content ratio of the 5-ester group and the 4-ester group to the total number of moles of the phenolic hydroxyl group, the 5-ester group and the 4-ester group in the compound (C1) (hereinafter, an "esterification ratio") is preferably 50 mol% or more, more preferably 55 mol% or more, and still more preferably 60 mol% or more from the viewpoint of improving the resolution after development. On the other hand, the esterification ratio is preferably 100 mol% or less, more preferably 90 mol% or less, still more preferably 80 mol% or less, and particularly preferably 70 mol% or less from the viewpoint of improving the sensitivity during exposure. For the compound (C1), it is also preferable that two or more types of compounds (C1) having different esterification ratios are mixed to obtain the esterification ratio described above.

The total content ratio of the compound having one 5-ester group or 4-ester group in the molecule and the compound having two 5-ester groups or 4-ester groups in the molecule to 100 mol% in total of the compound (C1) (hereinafter, a "low ester substitution ratio") is preferably 60 mol% or more, more preferably 70 mol% or more, and still more preferably 80 mol% or more from the viewpoint of improving the sensitivity during exposure. On the other hand, the low ester substitution ratio is preferably 100 mol% or less, more preferably 95 mol% or less, and still more preferably 90 mol% or less from the viewpoint of improving the resolution after development.

Further, the low ester substitution ratio to 100 mol% in total of the compound (C1) is preferably 0 mol% or more, more preferably 10 mol% or more, still more preferably 20 mol% or more, and particularly preferably 30 mol% or more, from the viewpoint of improving the sensitivity during exposure. On the other hand, the low ester substitution ratio is preferably less than 60 mol%, more preferably 50 mol% or less, and still more preferably 40 mol% or less from the viewpoint of suppressing residues after development.

Examples of a method for producing the compound (C1) include a method in which a compound having a phenolic hydroxyl group is subjected to an esterification reaction with a naphthoquinone diazide sulfonic acid, and a method in which a compound having a phenolic hydroxyl group is subjected to an esterification reaction with a naphthoquinonediazide sulfonic acid chloride. The naphthoquinonediazide sulfonic acid chloride is preferably 1,2-naphthoquinonediazide-5-sulfonic acid chloride or 1,2-naphthoquinonediazide-4-sulfonic acid chloride.

<Photopolymerization Initiator (C2)>

The compound (C2) refers to a compound that undergoes bond cleavage and/or reaction upon exposure to generate radicals. Containing the compound (C2) is suitable for forming a negative-type pattern. During exposure, even when an amount of radicals generated from the compound (C2) is small, radical polymerization of the above compound (B) and the like proceeds in a chain manner, so that the effect of improving the sensitivity during exposure becomes remarkable.

As the compound (C2), a benzyl ketal-based compound, an α-hydroxyketone-based compound, an α-aminoketone-based compound, a biimidazole-based compound, a phosphine oxide-based compound, an oxime ester-based compound, an acridine-based compound, a titanocene-based compound, a benzophenone-based compound, an acetophenone-based compound, an aromatic ketoester-based compound, or a benzoic acid ester-based compound is preferable, and an oxime ester-based compound is more preferable from the viewpoint of improving the sensitivity during exposure. The oxime ester-based compound preferably contains a compound having an oxime ester structure (hereinafter, "α-oxime structure") and/or a compound having an oxime ester carbonyl structure (hereinafter, "β-oxime structure"), from the viewpoint of improving the sensitivity during exposure, improving the reliability of the light emitting element, and improving the migration resistance.

<Photoacid Generator (C3)>

The compound (C3) refers to a compound that undergoes bond cleavage and/or reaction upon exposure to light to generate an acid. Containing the compound (C3) is suitable for forming a negative-type pattern from a viewpoint of promotion of cationic polymerization and the like. On the other hand, in a case where the resin or the like has an acidic group protected by an acid-dissociable group, it is suitable for forming a positive-type pattern, from a viewpoint of releasing the acidic group by exposure, and the effect of improving the sensitivity during exposure becomes remarkable. Note that the compound (C3) is a compound different from the compound (C1).

Examples of the compound (C3) include an ionic compound and a nonionic compound. The ionic compound is preferably a triorganosulfonium salt-based compound. The nonionic compound is preferably a halogen-containing compound, a diazomethane compound, a sulfone compound, a sulfonic acid ester compound, a carboxylic acid ester compound, a sulfonimide compound, a phosphoric acid ester compound, or a sulfonebenzotriazole compound.

<Photobase Generator (C4)>

The compound (C4) refers to a compound that undergoes bond cleavage and/or reaction upon exposure to generate a base. Containing the compound (C4) is suitable for forming a negative-type pattern from a viewpoint of promotion of anionic polymerization and the like. On the other hand, in a case where the resin or the like has an acidic group protected by a base-dissociable group, it is suitable for forming a positive-type pattern, from the viewpoint of releasing the acidic group by exposure, and the effect of improving the sensitivity during exposure becomes remarkable.

Examples of the compound (C4) include an ionic compound and a nonionic compound. The ionic compound is preferably a diazabicycloalkene salt-based compound, a triazabicycloalkene salt-based compound, an $\alpha$-keto quaternary ammonium salt-based compound, a benzyl quaternary ammonium salt-based compound, a guanidine salt-based compound, or a biguanide salt-based compound. The ionic compound preferably has a ketoprofen structure, an oxoxanthene structure, a benzofuran structure, or a naphthalene structure. The nonionic compound is preferably a nitro benzyl carbamate compound, an anthracenyl carbamate compound, a benzoin-based carbamate compound, an anthraquinone-based carbamate compound, a hydroxycinnamamide-based compound, or a coumarin amide-based compound.

<Colorant (D), Thermal Colorant, and Oxidative Colorant>

From the viewpoint of suppressing external light reflection, the photosensitive composition of the present invention preferably further includes the colorant (D). The colorant (D) refers to a compound that is colored by absorbing light having a wavelength of visible light (380 to 780 nm). The colorant (D) is preferably a pigment or a dye. The colorant (D) preferably includes a blacking agent or a colorant mixture of two or more colorants. The blacking agent preferably includes an organic black pigment and/or an inorganic black pigment. A black color in the colorant (D) is as described in paragraphs [0284] to [0285] of WO 2019/087985 A.

The content ratio of the colorant (D) in the total solid content of the photosensitive composition of the present invention is preferably 5.0 mass% or more, more preferably 10 mass% or more, still more preferably 20 mass% or more, and particularly preferably 30 mass% or more, from a viewpoint of suppressing external light reflection and improving the reliability of the light emitting element. On the other hand, the content ratio of the colorant (D) is preferably 70 mass% or less, and more preferably 50 mass% or less from the viewpoint of improving the sensitivity during exposure and suppressing residues after development.

It is preferable that the organic black pigment includes one or more selected from the group consisting of a benzofuranone-based black pigment, a perylene-based black pigment, and an azo-based black pigment, from the viewpoint of suppressing residues after development, achieving low voltage driving of the light emission characteristics, improving the reliability of the light emitting element, and improving the migration resistance. The benzofuranone-based black pigment preferably includes a compound having at least two benzofuran-2(3H)-one structures that may share a benzene ring or at least two benzofuran-3(2H)-one structures that may share a benzene ring, a geometric isomer thereof, a salt thereof, or a salt of a geometric isomer thereof. The perylene-based black pigment preferably includes a compound having a 3,4,9,10-perylenetetracarboxylic acid bisbenzimidazole structure, a geometric isomer thereof, a salt thereof, or a salt of a geometric isomer thereof. The azo-based black pigment preferably includes a compound having an azomethine structure and a carbazole structure, or a salt thereof. Since the organic black pigment has a high transmittance of a wavelength in the ultraviolet region (for example, 400 nm or less), the effect of improving the sensitivity during exposure becomes remarkable.

The inorganic black pigment includes one or more selected from the group consisting of a nitride including a metal element, a carbide including a metal element, and an oxynitride including a metal element (hereinafter, "specific inorganic black pigments"), from the viewpoint of suppressing residues after development, achieving low voltage driving of the light emission characteristics, improving the reliability of the light emitting element, and improving the migration resistance, and the metal element is preferably one or more selected from the group consisting of zirconium, vanadium, niobium, hafnium, and tantalum, and more preferably includes one or more selected from the group consisting of a nitride of zirconium, a carbide of zirconium, and an oxynitride of zirconium. Since the inorganic black pigment has high transmittance of a wavelength in the ultraviolet region, the effect of improving the sensitivity during exposure becomes remarkable. The specific inorganic black pigment preferably includes zirconium, vanadium, niobium, hafnium, or tantalum as a main component element. The main component element in the specific inorganic black pigment refers to an element included most on a mass basis in constituent elements.

The colorant mixture of two or more colors preferably includes a coloring pigment mixture of two or more colors and/or a coloring dye mixture of two or more colors, and from the viewpoint of suppressing residues after development, it is more preferable that the two or more colors include blue and/or purple, and red and orange. The coloring pigment preferably includes an anthraquinone-based pigment, a diketopyrrolopyrrole-based pigment, a perylene-based pigment, an isoindoline-based pigment, an isoindolinone-based pigment, an imidazolone-based pigment, a quinacridone-based pigment, a pyranthrone-based pigment, a phthalocyanine-based pigment, an indantrone-based pigment, or a dioxazine-based pigment. The coloring dye preferably includes a squarylium-based dye, a xanthene-based dye, a triarylmethane-based dye, or a phthalocyanine-based dye.

In the photosensitive composition of the present invention, it is also preferable that the pigment has a coating layer from the viewpoint of suppressing residues after development, achieving low voltage driving of the light emission characteristics, improving the reliability of the light emitting element, and improving the migration resistance. The coating layer refers to a layer that coats the surface of the pigment, and examples thereof include a layer formed by a surface treatment with a silane coupling agent or a coating treatment with a resin. The coating layer preferably has one or more layers selected from the group consisting of a silica coating layer, a metal oxide coating layer, and a metal hydroxide coating layer.

From the viewpoint of suppressing external light reflection, the photosensitive composition of the present invention preferably further contains a thermal colorant and/or an oxidative colorant. The thermal colorant refers to a compound that is colored by absorbing light having a wavelength of visible light (380 to 780 nm) after being heated in an inert atmosphere. The oxidative colorant refers to a compound that absorbs any light within the wavelength (380 to 780 nm) range of visible light to color after heating in an oxygen-containing gas atmosphere. The thermal colorant and the oxidative colorant are preferably compounds having a structure that changes in structure after heating or a structure that decomposes after heating. The thermal colorant and the oxidative colorant preferably include a compound having an aromatic structure in which at least two phenolic hydroxyl groups are bonded, more preferably include a compound having an aromatic structure in which at least three phenolic hydroxyl groups are bonded, and further preferably include 1,2,4-trihydroxybenzene or pyrogallol from the viewpoint of suppressing residues after development, improving the reliability of the light emitting element, and improving the migration resistance.

The thermal colorant and the oxidative colorant preferably include a compound having an aromatic structure in which at least two phenolic hydroxyl groups are bonded, and further preferably include a compound having a structure represented by formula (11), from the viewpoint of suppressing residues after development, improving the reliability of the light emitting element, and improving the migration resistance. It is preferable that the compound having a structure represented by the formula (11) has at least one crosslinkable group at a nitrogen atom, and the crosslinkable group is an alkoxymethyl group and/or a methylol group. As the alkoxymethyl group, a methoxymethyl group, an ethoxymethyl group, or a butoxymethyl group is preferable, and a methoxymethyl group is more preferable.

[Chemical Formula 12]

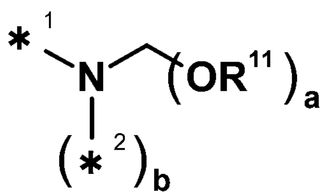

(11)

In Formula (11), $R^{11}$ represents a hydrogen atom or an alkyl group having 1 to 10 carbon atoms. $*^1$ and $*^2$ each independently represent a bonding point, but a carbonyl group is not adjacent to a nitrogen atom. a represents 1 or 2. b represents 0 or 1. Note that a + b = 2. From the viewpoint of the effects of the invention described above, it is preferable that at least one of $*^1$ and $*^2$ is a bonding point with an aromatic structure, an aromatic heterocyclic structure, a condensed polycyclic structure, or a condensed polycyclic heterocyclic structure. It is also preferable that both $*^1$ and $*^2$ are bonding points with an aromatic structure, an aromatic heterocyclic structure, a condensed polycyclic structure, or a condensed polycyclic heterocyclic structure. At the bonding points $*^1$ and $*^2$, from the viewpoint of the effects of the invention described above, the aromatic structure is preferably a benzene structure, a biphenyl structure, or a terphenyl structure, the aromatic heterocyclic structure is preferably a triazine structure, an isocyanuric acid structure, a pyrrole structure, an imidazole structure, or a triazole structure, the condensed polycyclic structure is preferably a fluorene structure or a naphthalene structure, and the condensed polycyclic heterocyclic structure is preferably a carbazole structure, an indole structure, a benzimidazole structure, or a benzotriazole structure. At the bonding point of $*^1$ and $*^2$, a triazine structure is more preferable as the aromatic heterocyclic structure.

Note that, since the compound having the structure represented by the formula (11) has a specific crosslinkable group to be described later, it may be used as the crosslinking agent (F) to be described later. In other words, the compound

is classified into both a thermal colorant and/or an oxidative colorant, and a crosslinking agent (F).

<Dispersant (E)>

From the viewpoint of improving the dispersion stability of the pigment, the photosensitive composition of the present invention preferably further includes the dispersant (E). The dispersant (E) refers to a compound having a structure that interacts with the surface of a pigment and a structure that inhibits approach of pigments to each other. The dispersant (E)preferably has a basic group, an acidic group, or a salt structure thereof, and more preferably has a basic group or a salt structure thereof.

<Crosslinking Agent (F)>

The crosslinking agent (F) refers to a compound having a crosslinking group, a cationically polymerizable group, or an anionically polymerizable group capable of reacting with a resin or the like. From the viewpoint of improving the reliability and migration resistance of the light emitting element, the crosslinking agent (F) preferably has one or more groups selected from the group consisting of an alkoxyalkyl group, a hydroxyalkyl group, an epoxy group, an oxetanyl group, and a blocked isocyanate group (hereinafter, "specific crosslinking group"). The alkoxyalkyl group is preferably an alkoxymethyl group or an alkoxyethyl group, and more preferably a methoxymethyl group or a methoxyethyl group. The hydroxyalkyl group is preferably a methylol group or an ethylol group. The number of specific crosslinking groups contained in the crosslinking agent (F) is preferably 2 or more, more preferably 3 or more, still more preferably 4 or more, and particularly preferably 6 or more, from the viewpoint of improving the reliability of the light emitting element and improving the migration resistance. On the other hand, the number of specific crosslinking groups is preferably 12 or less, more preferably 10 or less, still more preferably 8 or less from the viewpoint of suppressing residues after development.

The content of the crosslinking agent (F) is preferably 1.0 parts by mass or more when the total of the binder resin (A) and the compound (B) is 100 parts by mass, from the viewpoint of improving the sensitivity during exposure. On the other hand, the content of the crosslinking agent (F) is preferably 30 parts by mass or less from the viewpoint of suppressing residues after development.

<Inorganic Particles (G)>

The photosensitive composition of the present invention preferably further includes inorganic particles (G) from the viewpoint of improving the reliability of the light emitting element and improving the migration resistance. The inorganic particles (G) refer to particles including an element selected from the group consisting of a metal element, a metalloid element, and a semiconductor element as a main component element. The main component element in the inorganic particles refers to an element that is included most on a mass basis in the constituent elements of the inorganic particles. The inorganic particles (G) preferably have a hydroxy group and/or a silanol group on the particle surface. The inorganic particles (G) preferably include silica particles from the viewpoint of suppressing external light reflection.

<Phenol Compound (I)>

It is preferable that the photosensitive composition of the present invention further contains a phenol compound (I), from the viewpoint of suppressing residues after development, achieving low voltage driving of the light emission characteristics, improving the reliability of the light emitting element, and improving the migration resistance. It is preferable that the phenol compound (I) satisfies the following condition (β1) and satisfies the following condition (5). Note that the phenol compound (I) does not contain a fluorine atom or a fluoride ion in its structure. Further, it is preferable that the phenol compound (I) does not contain a chlorine atom, a bromine atom, a chloride ion, or a bromide ion in its structure.

(β1) having at least two of the following structures (Ic) and the following structure (IIIc)
Structure (Ic): a cyclic structure having a phenolic hydroxyl group
Structure (IIIc): a structure linking at least two structures (Ic), the structure being a sulfonyl group, an alkylene group, a condensed polycyclic structure, a hydrocarbon group including an ether bond, a direct bond, an ether bond, a sulfide bond, a carbonyl group, a carboxylate ester bond, an amide bond, a urea bond, a urethane bond, a carbonate ester bond, a cycloalkylene group, an arylene group, a condensed polycyclic heterocyclic structure, a hydrocarbon group including a carbonyloxy group, or a hydrocarbon group including a carbonylamide group
(5) The total content of the phenol compound (I) in the total solid content of the photosensitive composition is 0.010 ppm by mass or more and 10,000 ppm by mass or less.

The total content of the phenol compound (I) in the total solid content of the photosensitive composition is preferably 0.010 ppm by mass or more, more preferably 0.030 ppm by mass or more, still more preferably 0.050 ppm by mass or more, still more preferably 0.070 ppm by mass or more, and particularly preferably 0.10 ppm by mass or more, from the viewpoint of the effects of the invention described above. On the other hand, the total content of the phenol compound (I) is preferably 10,000 ppm by mass or less, more preferably 5,000 ppm by mass or less, still more preferably 1,000 ppm by mass or less, still more preferably 500 ppm by mass or less, particularly preferably 300 ppm by mass or less, and most preferably 100 ppm by mass or less, from the viewpoint of the effects of the invention described above. Furthermore, the total content of the phenol compound (I) is preferably 50 ppm by mass or less, more preferably 30 ppm by mass or less, still more preferably 10 ppm by mass or less, still more preferably 5 ppm by mass or less, particularly preferably 3 ppm by mass or less, and most preferably 1 ppm by mass or less.

The cyclic structure in the structure (Ic) is preferably an aromatic structure or a condensed polycyclic structure, and more preferably an aromatic structure having 6 to 15 carbon atoms or a condensed polycyclic structure having 6 to 20 carbon atoms. The aromatic structure is preferably a biphenyl structure or a benzene structure. The condensed polycyclic structure is preferably a fluorene structure, an anthracene structure, or a naphthalene structure.

From the viewpoint of the effects of the invention described above, the phenol compound (I) preferably contains a compound represented by formula (41).

[Chemical Formula 13]

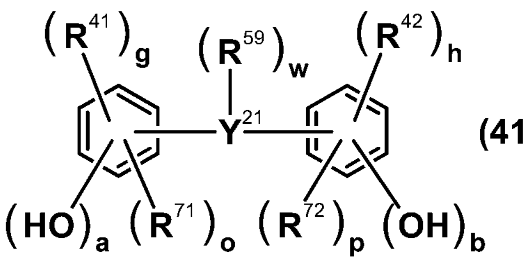

(41)

In the formula (41), $R^{41}$ and $R^{42}$ each independently represent a carboxy group, a mercapto group, or a sulfonic acid group. $R^{59}$ represents an alkyl group having 1 to 6 carbon atoms. $R^{71}$ and $R^{72}$ each independently represent an alkyl group having 1 to 10 carbon atoms, a cycloalkyl group having 4 to 10 carbon atoms, an aryl group having 6 to 15 carbon atoms, an alkenyl group having 2 to 10 carbon atoms, an alkoxy group having 1 to 10 carbon atoms, an alkenyloxy group having 2 to 10 carbon atoms, or an acyl group having 1 to 10 carbon atoms. $Y^{21}$ represents a sulfonyl group, an alkylene group, a condensed polycyclic structure, a hydrocarbon group including an ether bond, a direct bond, an ether bond, a sulfide bond, a carbonyl group, a carboxylate ester bond, an amide bond, a urea bond, a urethane bond, a carbonate ester bond, a cycloalkylene group, an arylene group, a condensed polycyclic heterocyclic structure, a hydrocarbon group including a carbonyloxy group, or a hydrocarbon group including a carbonylamide group. a and b each independently represent an integer of 1 to 5. g and h each independently represent an integer of 0 to 4. o and p each independently represent an integer of 0 to 4. w represents an integer of 0 to 6. Note that $1 \leq a + g + o \leq 5$ and $1 \leq b + h + p \leq 5$ are satisfied.

In $Y^{21}$, the hydrocarbon group in the hydrocarbon group including an ether bond is preferably an alkylene group having 1 to 10 carbon atoms, a cycloalkylene group having 4 to 10 carbon atoms, or an arylene group having 6 to 15 carbon atoms. In $Y^{21}$, the number of carbon atoms of the hydrocarbon group including a carbonyloxy group and the hydrocarbon group including a carbonylamide group is preferably 1 to 15, and the hydrocarbon group preferably has an aliphatic structure, an alicyclic structure, an aromatic structure, a condensed polycyclic structure, or a condensed polycyclic heterocyclic structure. The substituents and structures described above may have a hetero atom, and may be either unsubstituted or substituted.

With the above configuration, it is considered that these compounds promote the surface modification action on the surface of the first electrode in the opening of the pixel dividing layer. Therefore, it is presumed that the effects of suppressing residues after development, achieving low voltage driving of the light emission characteristics, and improving the light emission luminance become remarkable. Further, these compounds have a function as a catalyst that promotes a crosslinking reaction in the film of the photosensitive composition by a thermal reaction. Therefore, improvement of the degree of crosslinking in the film of the photosensitive composition contributes to improvement of the heat resistance and suppression of outgassing, so that the effect of improving the reliability of the light emitting element and improving the migration resistance becomes remarkable.

<Crosslinkable Aromatic Compound (J)>

It is preferable that the photosensitive composition of the present invention further contains a crosslinkable

aromatic compound (J) from the viewpoint of suppressing residues after development, achieving low voltage driving of the light emission characteristics, improving the reliability of the light emitting element, and improving the migration resistance. It is preferable that the crosslinkable aromatic compound (J) has at least two structures (Id): a cyclic structure in which a phenolic hydroxyl group and at least two crosslinkable groups are bonded, and at least two structures (IId): a cyclic structure having a phenolic hydroxyl group different from the structure (Id), and further has a structure (IIId): a structure linking at least two structures (IId), and satisfies the following condition (6). Note that the crosslinkable aromatic compound (J) does not contain a fluorine atom or a fluoride ion in its structure. Further, it is preferable that the crosslinkable aromatic compound (J) does not contain a chlorine atom, a bromine atom, a chloride ion, or a bromide ion in its structure.

(6) The total content of the crosslinkable aromatic compound (J) in the total solid content of the photosensitive composition is 0.010 ppm by mass or more and 5,000 ppm by mass or less.

The cyclic structures in the structure (Id) and the structure (IId) are preferably aromatic structures or condensed polycyclic structures, and more preferably aromatic structures having 6 to 15 carbon atoms or condensed polycyclic structures having 6 to 20 carbon atoms. The aromatic structure is preferably a biphenyl structure or a benzene structure. The condensed polycyclic structure is preferably a fluorene structure, an anthracene structure, or a naphthalene structure. The structure to be linked in the structure (IIId) is preferably a hydrocarbon group, more preferably an alkylene group, and still more preferably an alkylene group having 1 to 10 carbon atoms.

As the structure (IId), a structure (IIdx): an aromatic structure having a phenolic hydroxyl group and having at least one crosslinkable group is preferable. The crosslinkable group in the structure (Id) and the structure (IIdx) preferably has one or more selected from the group consisting of an alkoxyalkyl group, a hydroxyalkyl group, an epoxy group, an oxetanyl group, a vinyl group, and an allyl group, and more preferably has an alkoxyalkyl group and/or a hydroxyalkyl group. The alkoxyalkyl group is preferably an alkoxymethyl group or an alkoxyethyl group, and more preferably a methoxymethyl group or a methoxyethyl group. The hydroxyalkyl group is preferably a methylol group or an ethylol group. Note that the crosslinkable aromatic compound (J) is a compound different from the compound (B) and the crosslinking agent (F).

The total content of the crosslinkable aromatic compound (J) in the total solid content of the photosensitive composition is preferably 0.010 ppm by mass or more, more preferably 0.030 ppm by mass or more, still more preferably 0.050 ppm by mass or more, still more preferably 0.070 ppm by mass or more, and particularly preferably 0.10 ppm by mass or more, from the viewpoint of the effects of the invention described above. On the other hand, the total content of the crosslinkable aromatic compound (J) is preferably 5,000 ppm by mass or less, more preferably 1,000 ppm by mass or less, still more preferably 500 ppm by mass or less, still more preferably 300 ppm by mass or less, and particularly preferably 100 ppm by mass or less, from the viewpoint of the effects of the invention described above. Furthermore, the total content of the crosslinkable aromatic compound (J) is preferably 50 ppm by mass or less, more preferably 30 ppm by mass or less, still more preferably 10 ppm by mass or less, still more preferably 5 ppm by mass or less, particularly preferably 3 ppm by mass or less, and most preferably 1 ppm by mass or less.

The crosslinkable aromatic compound (J) preferably contains a compound represented by formula (51) from the viewpoint of the effects of the invention described above.

[Chemical Formula 14]

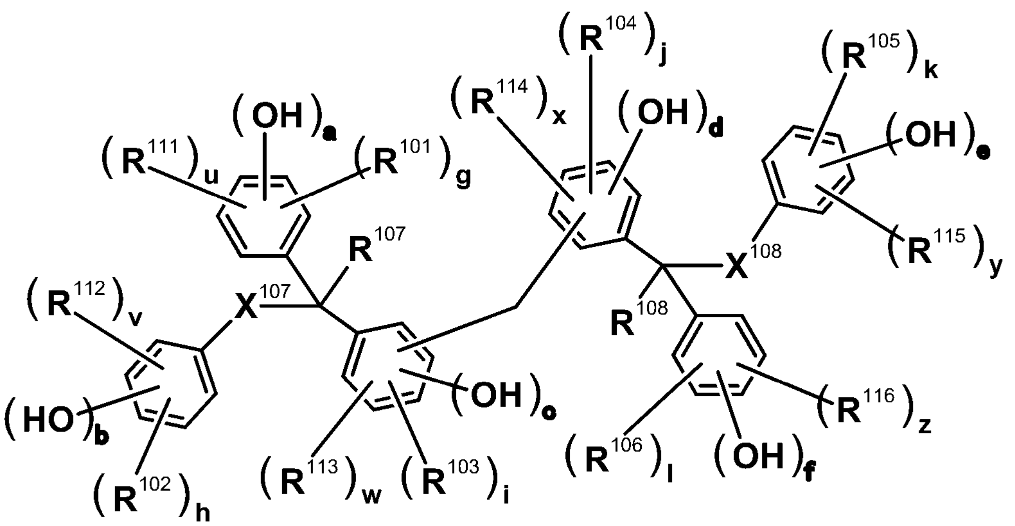

(51)

In the formula (51), $R^{101}$ to $R^{106}$ each independently represent an alkyl group having 1 to 10 carbon atoms. $R^{107}$ and $R^{108}$ each independently represent a hydrogen atom, an alkyl group having 1 to 10 carbon atoms, a cycloalkyl group

having 4 to 10 carbon atoms, or an aryl group having 6 to 15 carbon atoms. $R^{111}$ to $R^{116}$ each independently represent an alkoxyalkyl group having 2 to 10 carbon atoms, a hydroxyalkyl group having 1 to 6 carbon atoms, an alkyl group with 1 to 6 carbon atoms having an epoxy group, an alkoxyalkyl group with 2 to 10 carbon atoms having an epoxy group, an alkyl group with 1 to 8 carbon atoms having an oxetanyl group, an alkoxyalkyl group with 2 to 12 carbon atoms having an oxetanyl group, a vinyl group, or an allyl group. $X^{107}$ and $X^{108}$ each independently represent a direct bond, an arylene group with 6 to 15 carbon atoms linked by an alkylene group with 1 to 10 carbon atoms, or a cycloalkylene group with 4 to 10 carbon atoms linked by an alkylene group with 1 to 10 carbon atoms. a, b, e, and f each independently represent an integer of 1 to 3. c and d each independently represent an integer of 1 to 4. g, h, i, j, k, and l each independently represent an integer of 0 to 3. u, v, y, and z each independently represent an integer of 2 to 4. w and x each independently represent an integer of 0 to 3. Note that $3 \leq a + g + u \leq 5$, $3 \leq b + h + v \leq 5$, $1 \leq c + i + w \leq 4$, $1 \leq d + j + x \leq 4$, $3 \leq e + k + y \leq 5$, and $3 \leq f + l + z \leq 5$ are satisfied. The substituents and structures described above may have a hetero atom, and may be either unsubstituted or substituted.

With the above configuration, it is considered that these compounds promote the surface modification action on the surface of the first electrode in the opening of the pixel dividing layer. Therefore, it is presumed that the effects of suppressing residues after development, achieving low voltage driving of the light emission characteristics, and improving the light emission luminance become remarkable. Further, these compounds have a function as a catalyst that promotes a crosslinking reaction in the film of the photosensitive composition by a thermal reaction. Therefore, improvement of the degree of crosslinking in the film of the photosensitive composition contributes to improvement of the heat resistance and suppression of outgassing, so that the effect of improving the reliability of the light emitting element and improving the migration resistance becomes remarkable.

<Nitrogen-containing Compound (H)>

It is preferable that the photosensitive composition of the present invention further contains a nitrogen-containing compound (H) from the viewpoint of suppressing residues after development, achieving low voltage driving of the light emission characteristics, improving the reliability of the light emitting element, and improving the migration resistance. It is preferable that the nitrogen-containing compound (H) includes one or more selected from the group consisting of a cyclic amide compound, an amide compound, a cyclic urea compound, a urea compound, an oxazolidone compound, and an isoxazolidone compound (hereinafter, "specific nitrogen-containing compounds"), and satisfies the following condition (4). In a case where the photosensitive composition of the present invention includes one or more selected from the group consisting of polyimide-based resins, the photosensitive composition of the present invention preferably contains the nitrogen-containing compound (H), and more preferably satisfies the following condition (4) from the viewpoint of the effects of the invention described above.

(4) The total content of the cyclic amide compound, the amide compound, the cyclic urea compound, the urea compound, the oxazolidone compound, and the isoxazolidone compound in the total solid content of the photosensitive composition is 0.010 mass% or more and 5.0 mass% or less.

From the viewpoint of the effects of the invention described above, the specific nitrogen-containing compound preferably includes one or more compounds selected from the group consisting of a cyclic amide compound represented by Formula (20), an amide compound represented by Formula (21), a cyclic urea compound represented by Formula (22), a urea compound represented by Formula (23), an oxazolidone compound represented by Formula (24), and an isoxazolidone compound represented by Formula (25).

[Chemical Formula 15]

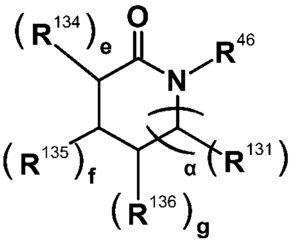 (20) 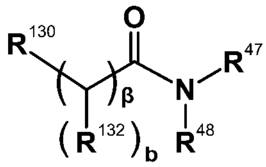 (21) 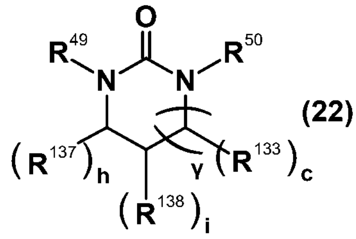 (22)

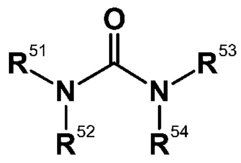 (23) 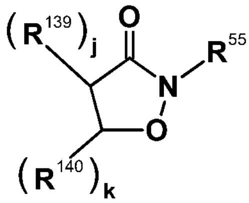 (24) 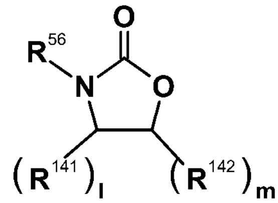 (25)

In Formulas (20) to (25), $R^{46}$ to $R^{56}$ each independently represent a hydrogen atom, an alkyl group having 1 to 6 carbon atoms, a cycloalkyl group having 4 to 10 carbon atoms, an aryl group having 6 to 15 carbon atoms, an alkenyl group having 2 to 6 carbon atoms, or a hydroxyalkyl group having 1 to 6 carbon atoms. $R^{130}$ represents a hydrogen atom, an alkyl group having 1 to 6 carbon atoms, an alkoxy group having 1 to 6 carbon atoms, a hydroxyalkyl group having 1 to 6 carbon atoms, a hydroxyalkoxy group having 1 to 6 carbon atoms, a hydroxy group, an amino group, a monoalkylamino group having 1 to 6 carbon atoms, or a dialkylamino group having 2 to 12 carbon atoms. $R^{131}$ to $R^{142}$ each independently represent an alkyl group having 1 to 6 carbon atoms. $\alpha$, $\beta$, and $\gamma$ each independently represent an integer of 0 to 6. a, b, c, e, f, g, h, i, j, k, l, and m each independently represent an integer of 0 to 2. In a case where $\alpha$ is 0, a is 0. In a case where $\beta$ is 0, b is 0. In a case where $\gamma$ is 0, c is 0. The substituents and structures described above may have a hetero atom, and may be either unsubstituted or substituted.

Specific nitrogen-containing compounds are preferably N-methyl-2-pyrrolidone, N-ethyl-2-pyrrolidone, N-butyl-2-pyrrolidone, N-cyclohexyl-2-pyrrolidone, N-vinyl-2-pyrrolidone, N,N-dimethylformamide, N,N-diethylformamide, N,N-dimethylacetamide, N,N-dimethylpropionamide, N,N-dimethylisobutyramide, N,N-dimethyl-3-methoxypropionamide, N,N-dimethyl-3-butoxypropionamide, 1,3-dimethyl-2-imidazolidinone, 1,3-diethyl-2-imidazolidinone, N,N'-dimethylpropyleneurea, 1,1,3,3-tetramethylurea, 1,1,3,3-tetraethylurea, N-methyl-2-oxazolidone, N-ethyl-2-oxazolidone, N-methyl-3-isoxazolidone or N-ethyl-3-isoxazolidone.

The total content of the specific nitrogen-containing compounds in the total solid content of the photosensitive composition is preferably 0.030 mass% or more, more preferably 0.050 mass% or more, still more preferably 0.070 mass% or more, and particularly preferably 0.10 mass% or more from the viewpoint of the effects of the invention described above. On the other hand, the total content of the specific nitrogen-containing compound is preferably 4.0 mass% or less, more preferably 3.5 mass% or less, still more preferably 3.0 mass% or less from the viewpoint of the effects of the invention described above. The total content of the specific nitrogen-containing compound is preferably 2.5 mass% or less, more preferably 2.0 mass% or less, still more preferably 1.5 mass% or less, still more preferably 1.0 mass% or less, particularly preferably 0.70 mass% or less, and most preferably 0.50 mass% or less.

With the above configuration, it is considered that these compounds promote the surface modification action on the surface of the first electrode in the opening of the pixel dividing layer. Therefore, it is presumed that the effects of suppressing residues after development, achieving low voltage driving of the light emission characteristics, and improving the light emission luminance become remarkable. Further, these compounds have a function as a catalyst that promotes a crosslinking reaction in the film of the photosensitive composition by a thermal reaction. Therefore, improvement of the degree of crosslinking in the film of the photosensitive composition contributes to improvement of the heat resistance and suppression of outgassing, so that the effect of improving the reliability of the light emitting element and improving the migration resistance becomes remarkable.

<Content of Fluorine Element, Chlorine Element, and Bromine Element>

The photosensitive composition of the present invention preferably satisfies the following conditions (P1x) and (1x) to be described later, from the viewpoint of suppressing residues after development, achieving low voltage driving of the light emission characteristics, improving the reliability of the light emitting element, and improving the migration resistance. From the viewpoint of the effects of the invention described above, it is more preferable that the photosensitive composition of the present invention further satisfies the following conditions (P2x) and (2x) to be described later.

It is preferable that from the viewpoint of suppressing residues after development, achieving low voltage driving of the light emission characteristics, improving the reliability of the light emitting element, and improving the migration

resistance, the photosensitive composition of the present invention has a fluorine atom, a chlorine atom, a bromine atom, a fluoride ion, a chloride ion, or a bromide ion in the structure of the binder resin (A), the photosensitive agent (C), the radical polymerizable compound (B), or the crosslinking agent (F), or the photosensitive composition further contains a component including a fluorine element, a chlorine element, or a bromine element and/or a component including a fluoride ion, a chloride ion, or a bromide ion,
and satisfies the following conditions (P1x) and (1x).

(P1x) The total content of the fluorine element, the chlorine element, and the bromine element in the structure of the resin is 30,000 ppm by mass or less.

(1x) The total content of the fluorine element, the chlorine element, and the bromine element in the total solid content of the photosensitive composition is 0.010 ppm by mass or more and 1,000 ppm by mass or less.

From the viewpoint of the effects of the invention described above, it is more preferable that the photosensitive composition of the present invention further satisfies the following conditions (P2x) and (2x).

(P2x) The total content of fluoride ions, chloride ions, and bromide ions in the structure of the resin is 30,000 ppm by mass or less.

(2x) The total content of fluoride ions, chloride ions, and bromide ions in the total solid content of the photosensitive composition is 0.010 ppm by mass or more and 1,000 ppm by mass or less.

The total content of the fluorine element, the chlorine element, and the bromine element in the structure of the resin is preferably 0 ppm by mass or more, more preferably 0.010 ppm by mass or more, still more preferably 0.030 ppm by mass or more, still more preferably 0.050 ppm by mass or more, particularly preferably 0.070 ppm by mass or more, and most preferably 0.10 ppm by mass or more from the viewpoint of the effects of the invention described above. On the other hand, the total content of the fluorine element, the chlorine element, and the bromine element is preferably 30,000 ppm by mass or less, more preferably 10,000 ppm by mass or less, and still more preferably 5,000 ppm by mass or less from the viewpoint of the effects of the invention described above. Furthermore, the total content of the fluorine element, the chlorine element, and the bromine element is preferably 1,000 ppm by mass or less, more preferably 500 ppm by mass or less, still more preferably 300 ppm by mass or less, and particularly preferably 100 ppm by mass or less. Furthermore, the total content of the fluorine element, the chlorine element, and the bromine element is preferably 50 ppm by mass or less, more preferably 30 ppm by mass or less, still more preferably 10 ppm by mass or less, still more preferably 5 ppm by mass or less, particularly preferably 3 ppm by mass or less, and most preferably 1 ppm by mass or less.

The preferred range of the total content of fluoride ions, chloride ions, and bromide ions in the structure of the resin is also the same as the preferred range of the total content of the fluorine element, the chlorine element, and the bromine element in the structure of the resin.

The total content of the fluorine element, the chlorine element, and the bromine element in the structure of the resin may be 0 ppm by mass. The total content of fluoride ions, chloride ions, and bromide ions in the structure of the resin may also be 0 ppm by mass.

As the component including a fluorine element, a chlorine element, or a bromine element, a phenol compound having a substituent including an alkyl fluoride group, an alkyl fluoride compound, a cycloalkyl fluoride compound, an aryl fluoride compound, a phenol compound having a substituent including an alkyl chloride group, an alkyl chloride compound, a cycloalkyl chloride compound, an aryl chloride compound, a phenol compound having a substituent including an alkyl bromide group, an alkyl bromide compound, a cycloalkyl bromide compound, or an aryl bromide compound is preferable. The component including a fluoride ion, a chloride ion, or a bromide ion preferably contains, as a cationic species, an ammonium ion, a primary ammonium ion, a secondary ammonium ion, a tertiary ammonium ion, or a quaternary ammonium ion. The quaternary ammonium ion preferably has a linear or branched hydrocarbon group. The hydrocarbon group is preferably an alkyl group having 1 to 15 carbon atoms, a cycloalkyl group having 4 to 10 carbon atoms, an aryl group having 6 to 15 carbon atoms, an alkenyl group having 2 to 6 carbon atoms, or a hydroxyalkyl group having 1 to 6 carbon atoms, more preferably an alkyl group having 1 to 10 carbon atoms, and still more preferably an alkyl group having 1 to 6 carbon atoms.

The total content of the fluorine element, the chlorine element, and the bromine element in the total solid content of the photosensitive composition is preferably 0.010 ppm by mass or more, more preferably 0.030 ppm by mass or more, still more preferably 0.050 ppm by mass or more, still more preferably 0.070 ppm by mass or more, and particularly preferably 0.10 ppm by mass or more, from the viewpoint of the effects of the invention described above. On the other hand, the total content of the fluorine element, the chlorine element, and the bromine element is preferably 1,000 ppm by mass or less, more preferably 500 ppm by mass or less, still more preferably 300 ppm by mass or less, and particularly preferably 100 ppm by mass or less, from the viewpoint of the effects of the invention described above. Furthermore, the total content of the fluorine element, the chlorine element, and the bromine element is preferably 50 ppm by mass or less, more preferably 30 ppm by mass or less, still more preferably 10 ppm by mass or less, still more preferably 5 ppm by mass or less, particularly preferably 3 ppm by mass or less, and most preferably 1 ppm by mass or less.

The preferred range of the total content of fluoride ions, chloride ions, and bromide ions in the total solid content of the photosensitive composition is also the same as the preferred range of the total content of the fluorine element, the

chlorine element, and the bromine element in the total solid content of the photosensitive composition.

The total content of the fluorine element, the chlorine element, and the bromine element in the total solid content of the photosensitive composition may be 0 ppm by mass. The total content of fluoride ions, chloride ions, and bromide ions in the total solid content of the photosensitive composition may also be 0 ppm by mass. In a case where the total content of the fluorine element, the chlorine element, and the bromine element and/or the total content of fluoride ions, chloride ions, and bromide ions in the total solid content of the photosensitive composition (hereinafter, "total content of specific elements and/or total content of specific ions in total solid content of photosensitive composition") exceeds 0 ppm by mass, the photosensitive composition of the present invention preferably has a fluorine atom, a chlorine atom, a bromine atom, a fluoride ion, a chloride ion, or a bromide ion in the structure of the binder resin (A), the photosensitive agent (C), the compound (B), or the crosslinking agent (F). Further, in a case where the total content of the specific elements and/or the total content of the specific ions in the total solid content of the photosensitive composition exceeds 0 ppm by mass, the photosensitive composition of the present invention preferably further contains a component including a fluorine element, a chlorine element, or a bromine element and/or a component including a fluoride ion, a chloride ion, or a bromide ion.

As described above, when the storage stability of the photosensitive composition is poor, for example, foreign matter generation after storage at room temperature may be a problem. By setting the total content of the fluorine element, the chlorine element, and the bromine element in the total solid content of the photosensitive composition of the present invention within a specific range, foreign matter generation during storage is suppressed, and the effect of improving the storage stability becomes remarkable.

<Content of Fluorine Element>

The photosensitive composition according to the first aspect of the present invention preferably satisfies the following condition (1a) to be described later, from the viewpoint of suppressing residues after development, achieving low voltage driving of the light emission characteristics, improving the reliability of the light emitting element, and improving the migration resistance. It is more preferable that the photosensitive composition according to the first aspect of the present invention further satisfies the following condition (2a) to be described later, from the viewpoint of the effects of the invention described above.

The photosensitive composition according to the second aspect of the present invention satisfies the following condition (1a). The photosensitive composition according to the second aspect of the present invention preferably further satisfies the following condition (2a).

It is preferable that the photosensitive composition of the present invention has a fluorine atom or a fluoride ion in the structure of the binder resin (A), the photosensitive agent (C), the radical polymerizable compound (B), or the crosslinking agent (F), or the photosensitive composition further contains a component including a fluorine element and/or a component including a fluoride ion, and satisfies the following condition (1a), from the viewpoint of suppressing residues after development, achieving low voltage driving of the light emission characteristics, improving the reliability of the light emitting element, and improving the migration resistance. It is more preferable that the photosensitive composition of the present invention further satisfies the following condition (2a) from the viewpoint of the effects of the invention described above.

(1a) The content of the fluorine element in the total solid content of the photosensitive composition is 1,000 ppm by mass or less.

(2a) The content of fluoride ions in the total solid content of the photosensitive composition is 1,000 ppm by mass or less.

Examples and preferred descriptions regarding the component including a fluorine element, the component including a fluoride ion, and the cationic species in the component including a fluoride ion are the same as those described above.

From the viewpoint of the effects of the invention described above, the content of the fluorine element in the total solid content of the photosensitive composition is preferably 0 ppm by mass or more, more preferably 0.010 ppm by mass or more, still more preferably 0.030 ppm by mass or more, still more preferably 0.050 ppm by mass or more, particularly preferably 0.070 ppm by mass or more, and most preferably 0.10 ppm by mass or more. On the other hand, from the viewpoint of the effects of the invention described above, the content of the fluorine element is preferably 1,000 ppm by mass or less, more preferably 500 ppm by mass or less, still more preferably 300 ppm by mass or less, and particularly preferably 100 ppm by mass or less. Furthermore, the content of the fluorine element is preferably 50 ppm by mass or less, more preferably 30 ppm by mass or less, still more preferably 10 ppm by mass or less, even more preferably 5 ppm by mass or less, particularly preferably 3 ppm by mass or less, and most preferably 1 ppm by mass or less.

The preferred range of the content of the fluoride ion in the total solid content of the photosensitive composition is also the same as the preferred range of the content of the fluorine element in the total solid content of the photosensitive composition.

The content of the fluorine element in the total solid content of the photosensitive composition may be 0 ppm by

mass. The content of fluoride ions in the total solid content of the photosensitive composition may also be 0 ppm by mass. When the content of the fluorine element and/or the content of the fluoride ion in the total solid content of the photosensitive composition is more than 0 ppm by mass, the photosensitive composition of the present invention preferably has a fluorine atom or a fluoride ion in the structure of the binder resin (A), the photosensitive agent (C), the compound (B), or the crosslinking agent (F), or the photosensitive composition further contains a component containing a fluorine element and/or a component including a fluoride ion.

As described above, when the storage stability of the photosensitive composition is poor, for example, foreign matter generation after storage at room temperature may be a problem. When the content of the fluorine element in the total solid content of the photosensitive composition of the present invention is in a specific range, generation of foreign matters during storage is suppressed, and the effect of improving storage stability becomes remarkable.

<Contents of Chlorine Element, Bromine Element, and Sulfur Element>

It is preferable that the photosensitive composition of the present invention satisfies at least one of the following conditions (1b), (1c), and (1d) described later from the viewpoint of suppressing residues after development, achieving low voltage driving of light emission characteristics, improving the reliability of the light emitting element, and improving the migration resistance. From the viewpoint of the effects of the invention described above, the photosensitive composition of the present invention more preferably satisfies at least one of the following conditions (2b), (2c), and (2d) described later.

In the photosensitive composition according to the present invention, from the viewpoint of suppressing a residue after development, achieving low voltage driving of light emission characteristics, improving reliability of a light emitting element, and improving migration resistance, it is preferable that the binder resin (A), the photosensitive agent (C), the radical polymerizable compound (B), or the crosslinking agent (F) has a chlorine atom, a bromine atom, a sulfur atom, a chloride ion, a bromide ion, or the following sulfur-based anion in a structure thereof, or the photosensitive composition further includes a component including a chlorine element, a bromine element, or a sulfur element and/or a component containing a chloride ion, a bromide ion, or the following sulfur-based anion,

Further, it is preferable that at least one of the following conditions (1b), (1c), and (1d) is satisfied. The photosensitive composition of the present invention more preferably satisfies the above condition (1a) and further satisfies at least one of the following conditions (1b), (1c), and (1d).

Sulfur-based anion: one or more ions selected from the group consisting of a sulfide ion, a hydrogen sulfide ion, a sulfate ion, and a hydrogen sulfate ion.

(1b) The content of the chlorine element in the total solid content of the photosensitive composition is 0.010 ppm by mass or more and 1,000 ppm by mass or less.

(1c) The content of the bromine element in the total solid content of the photosensitive composition is 0.010 ppm by mass or more and 1,000 ppm by mass or less.

(1d) The content of the sulfur element in the total solid content of the photosensitive composition is 0.010 ppm by mass or more and 1,000 ppm by mass or less.

The photosensitive composition of the present invention more preferably further satisfies at least one of the following conditions (2b), (2c), and (2d) from the viewpoint of the effects of the invention described above.

(2b) The content of chloride ions in the total solid content of the photosensitive composition is 0.010 ppm by mass or more and 1,000 ppm by mass or less.

(2c) The content of bromide ions in the total solid content of the photosensitive composition is 0.010 ppm by mass or more and 1,000 ppm by mass or less.

(2d) The content of the above sulfur-based anion in the total solid content of the photosensitive composition is 0.010 ppm by mass or more and 1,000 ppm by mass or less.

Examples and preferred descriptions regarding the cationic species in the component including a chlorine element or a bromine element; the component including a chloride ion or a bromide ion; and the component including these anions are the same as those described above. As the component including a sulfur element, a thiol compound, a sulfide compound, a disulfide compound, a sulfoxide compound, a sulfone compound, a sultone compound, or a thiophene compound is preferable. The component including a sulfur-based anion preferably contains, as a cationic species, an ammonium ion, a primary ammonium ion, a secondary ammonium ion, a tertiary ammonium ion, or a quaternary ammonium ion. Examples and preferred descriptions regarding the cationic species in the component including a sulfur-based anion are the same as those described above.

The content of the chlorine element in the total solid content of the photosensitive composition is preferably 0.010 ppm by mass or more, more preferably 0.030 ppm by mass or more, still more preferably 0.050 ppm by mass or more, still more preferably 0.070 ppm by mass or more, and particularly preferably 0.10 ppm by mass or more from the viewpoint of the effects of the invention described above. On the other hand, the content of the chlorine element is preferably 1,000 ppm by mass or less, more preferably 500 ppm by mass or less, still more preferably 300 ppm by mass or less, and particularly preferably 100 ppm by mass or less from the viewpoint of the effects of the invention described above. Furthermore, the

content of the chlorine element is preferably 50 ppm by mass or less, more preferably 30 ppm by mass or less, still more preferably 10 ppm by mass or less, still more preferably 5 ppm by mass or less, particularly preferably 3 ppm by mass or less, and most preferably 1 ppm by mass or less.

Preferred ranges of the content of the bromine element, the content of the sulfur element, the content of the chloride ion, the content of the bromide ion, and the content of the sulfur-based anion in the total solid content of the photosensitive composition are also the same as the above preferred ranges of the content of the chlorine element in the total solid content of the photosensitive composition.

One or more selected from the group consisting of the content of the chlorine element, the content of the bromine element, and the content of the sulfur element in the total solid content of the photosensitive composition may be 0 ppm by mass. One or more selected from the group consisting of the content of chloride ions, the content of bromide ions, and the content of sulfur-based anions in the total solid content of the photosensitive composition may be 0 ppm by mass. When one or more content selected from the group consisting of a content of a chlorine element, a content of a bromine element, a content of a sulfur element, a content of a chloride ion, a content of a bromide ion, and a content of a sulfur-based anion in the total solid content of the photosensitive composition (hereinafter, the "content and the like of chlorine element and chloride ions in the total solid content of the photosensitive composition") exceeds 0 ppm by mass, the photosensitive composition of the present invention preferably has a chlorine atom, a bromine atom, a sulfur atom, a chloride ion, a bromide ion, or the following sulfur-based anion in the structure of the binder resin (A), the photosensitive agent (C), the compound (B), or the crosslinking agent (F). When the content and the like of chlorine element and chloride ions in the total solid content of the photosensitive composition exceeds 0 ppm by mass, the photosensitive composition of the present invention preferably further contains a component containing chlorine element, bromine element, or sulfur element and/or a component containing chloride ion, bromide ion, or the following sulfur-based anion.

From the viewpoint of the effects of the invention described above, it is also preferable that the photosensitive composition of the present invention satisfies the above conditions (P1x) and (1x), and further satisfies the above condition (1a). Further, from the viewpoint of the effects of the invention described above, it is also preferable that the photosensitive composition of the present invention satisfies the above conditions (P1x) and (1x), and further satisfies at least one of the above conditions (1b), (1c), and (1d). Further, from the viewpoint of the effects of the invention described above, it is also preferable that the photosensitive composition of the present invention satisfies the above condition (1a), and further satisfies the above condition (1x). For each of the above, examples, preferred descriptions, and preferred contents of the above condition (1a), the above conditions (1b), (1c), and (1d), and the above condition (1x) are the same as those described above.

<Content of Water>

It is preferable that the photosensitive composition of the present invention further contains water and satisfies the following condition (3), from the viewpoint of suppressing residues after development, achieving low voltage driving of the light emission characteristics, improving the reliability of the light emitting element, and improving the migration resistance.

(3) The content of water in the photosensitive composition is 0.010 mass% or more and 3.0 mass% or less.

The content of water in the photosensitive composition is preferably 0.010 mass% or more, more preferably 0.030 mass% or more, still more preferably 0.050 mass% or more, still more preferably 0.070 mass% or more, and particularly preferably 0.10 mass% or more, from the viewpoint of the effects of the invention described above. On the other hand, the content of water is preferably 3.0 mass% or less, more preferably 2.5 mass% or less, still more preferably 2.2 mass% or less, and particularly preferably 2.0 mass% or less from the viewpoint of the effects of the invention described above. Furthermore, the content of water is preferably 1.7 mass% or less, more preferably 1.5 mass% or less, still more preferably 1.2 mass% or less, still more preferably 1.0 mass% or less, particularly preferably 0.70 mass% or less, and most preferably 0.50 mass% or less.

As described above, when the storage stability of the photosensitive composition is poor, it causes a decrease in reliability and a decrease in migration resistance of the light emitting element. When the content of water in the photosensitive composition of the present invention is within a specific range, generation of foreign matters during storage is suppressed, and the effect of improving storage stability becomes remarkable.

<Other Additives and Solvents>

The photosensitive composition of the present invention preferably further includes a dissolution promoter, a sensitizer, a chain transfer agent, a polymerization inhibitor, a silane coupling agent, an ink repellent agent, or a surfactant. As these additives, known additives may be used. The photosensitive composition of the present invention preferably further includes a solvent. In a case where the photosensitive composition of the present invention contains a pigment and further contains a dispersant, the solvent is preferably a compound having an acetate bond, a propionate bond, or a

butyrate bond from a viewpoint of improving the dispersion stability of the pigment.

<Photosensitive Composition Coating Film and Photosensitive Composition Film>

A photosensitive composition coating film of the present invention is a film formed from the photosensitive composition of the present invention in a semi-cured state (stage B). The semi-cured state refers to a state in which a crosslinked structure is not formed, or a crosslinked structure is formed by a partial reaction, but the film has fluidity, or a state thereof. Examples thereof include a state in which a coating film is applied to a substrate or the like and then dried under reduced pressure to distill off a solvent, and a state in which a coating film is heated at 40 to 150°C and dried, and this state refers to a state in which the coating film is soluble in an alkali solution or an organic solvent.

The photosensitive composition film of the present invention preferably has a photosensitive composition coating film formed from the photosensitive composition of the present invention and a support. Such a configuration is suitable from a viewpoint of handleability. The photosensitive composition film has positive-type or negative-type photosensitivity. It is also preferable that the photosensitive composition film is capable of forming a self-supported film as a single film. The photosensitive composition film preferably has adhesive properties, and it is also preferable that a plurality of members are joined with each other. The phrase "capable of forming a self-supported film as a single film" means that a film having a width of 1.5 cm or more, a length of 5.0 cm or more, and a thickness of 5.0 μm or more can be formed without a support. In other words, it is also preferable that the photosensitive composition film is a photosensitive composition coating film capable of forming a self-supported film as a single film.

The support is preferably a flexible substrate, and may be a rigid substrate. The surface of the support on a photosensitive film side may be subjected to a surface treatment with a silane coupling agent or the like. The thickness of the support is preferably 10 to 200 μm from the viewpoint of handleability.

<Cured Product of Photosensitive Composition>

The cured product of the present invention is obtained by curing the photosensitive composition of the present invention. The curing refers to a state in which a crosslinked structure is formed by a reaction and the fluidity of the film is lost, or refers to that state. The curing reaction may be caused by heating, irradiation with an energy ray, or the like, without being particularly limited, and is preferably caused by heating. A state in which a crosslinked structure is formed in the components constituting the photosensitive composition by heating and the fluidity of the film is lost, is referred to as thermal curing. As the heating condition, for example, a condition of heating at 150 to 500°C for 5 to 300 minutes is preferable. The cured product of the present invention may be an object obtained by curing the photosensitive film of the present invention.

The cured product of the present invention is preferably black. The optical density of the cured product of the present invention at a wavelength of visible light per film thickness of 1 μm is preferably 0.5 or more, more preferably 0.7 or more, still more preferably 1.0 or more, still more preferably 1.2 or more, and particularly preferably 1.5 or more from the viewpoint of suppressing external light reflection and improving the reliability of the light emitting element. On the other hand, the optical density is preferably 3.0 or less, more preferably 2.5 or less, and still more preferably 2.0 or less from the viewpoint of achieving low voltage driving of light emission characteristics. The optical density referred to herein is preferably an optical density in a cured product obtained by heating and curing the composition.

An element of the present invention includes the cured product of the present invention. Further, an article of the present invention includes the cured product of the present invention. Examples of the article include a display device, an electronic component, an electronic device, a moving body, a building, a window, and the like.

<Method for Producing Cured Product>

A method for producing a cured product of the present invention includes the steps of: (1) forming a coating film of the photosensitive composition of the present invention on a substrate; (2) irradiating the coating film of the photosensitive composition with active actinic radiation via a photomask to expose the coating film; (3) developing the exposed coating film using a developer to form a pattern of the photosensitive composition; and (4) heating the pattern of the photosensitive composition to obtain a cured pattern of the photosensitive composition. In these steps, the methods described in paragraphs [0453] to [0481] of International Publication No. 2019/087985 may be applied. In the step of forming a coating film, it is preferable to form a film by prebaking after coating. The step of obtaining a cured pattern is preferably a step of heating for thermally curing the pattern.

<Display Device and Electronic Component>

Hereinafter, a display device of the present invention and an electronic component of the present invention will be

described. Note that the description of the display device of the present invention is common to the display devices according to the first and second aspects and a third aspect of the present invention. On the other hand, in a case where a display device of a specific aspect is described, it is described as the display device or the like according to the first aspect of the present invention. It is noted that the present invention is not limited to the following embodiments, and various modifications can naturally be made as long as the modifications can achieve the object of the invention and do not depart from the gist of the invention.

The display device of the present invention includes the cured product of the present invention. The display device according to the first aspect of the present invention includes a cured product of the photosensitive composition according to the first aspect of the present invention containing the resin of the present invention. The display device according to the second aspect of the present invention includes a cured product of the photosensitive composition according to the second aspect of the present invention.

<Display Device>

The display device of the present invention preferably has a first electrode, a second electrode, and a light emitting layer, and has a pixel dividing layer. Further, the display device of the present invention preferably has a first electrode, a second electrode, a light emitting layer, a pixel dividing layer, and a metal wiring, and also has one or more selected from the group consisting of a TFT planarization layer, a TFT protective layer, a TFT interlayer insulating layer, and a gate insulating layer. Examples of such a display device include an organic EL display or a quantum dot display.

The display device of the present invention preferably has a light emitting element and a metal wiring layer, and also has a barrier layer and/or a planarization layer. Further, the display device of the present invention preferably has a light emitting element, a metal wiring layer, and a redistribution layer, and also has an interlayer insulating layer of the redistribution layer. Furthermore, in the display device of the present invention, it is preferable that the light emitting element and the metal wiring layer and/or the light emitting element and the redistribution layer are electrically connected, and the light emitting element is a semiconductor chip. It is preferable that the barrier layer is formed between adjacent light emitting elements, and the planarization layer is formed so as to cover at least a part of the light emitting elements. Further, in the display device of the present invention, an area of the redistribution layer is preferably larger than an area of the light emitting element in plan view, from a viewpoint of improving the integration density and suppressing the transmission loss between the wirings. Examples of such a display device include a micro LED display or a mini LED display.

In the display device of the present invention, from the viewpoint of improving the reliability of the light emitting element, the pixel dividing layer preferably has a step shape having a thick film portion and a thin film portion. Since the pixel dividing layer has the thick film portion, only the thick film portion of the pixel dividing layer is in contact with a deposition mask when the light emitting layer is formed, and a contact area between the pixel dividing layer and the deposition mask can be reduced. Therefore, the effect of suppressing a decrease in yield of a panel and improving the reliability of the light emitting element becomes remarkable by suppressing damage of the pixel dividing layer. In addition, since the thin film portion has a light-shielding property, outgassing from the pixel dividing layer and the film below the pixel dividing layer is suppressed, so that the effect of improving the reliability of the light emitting element becomes remarkable. Fig. 1 illustrates a schematic cross-sectional view and a plan view illustrating an example of a display device 100A in which a pixel dividing layer has a thick film portion and a thin film portion and has a step shape. The cross-sectional view in Fig. 1 is a cross-sectional view taken along a cross-sectional axis 100x in the plan view. Metal wiring 102 and a TFT element layer 103 are formed on a substrate 101, and an interlayer insulating layer 104 and a TFT planarization layer/TFT protective layer 105 are formed thereon in this order. On the TFT planarization layer/TFT protective layer 105, a pixel dividing layer 106 having a step shape and a first electrode 107 are formed such that the pixel dividing layer 106 divides the first electrode 107, and such that the pixel dividing layer 106 overlaps a part of the first electrode 107. The pixel dividing layer 106 includes a thick film portion 116. A light emitting layer 108, the second electrode 109, the sealing layer 110, the touch panel wiring/touch panel electrode 111, the color filter layer 112, the black matrix layer 113, an overcoat layer 114, and a substrate 115 are further formed in this order thereon. In addition, a color filter layer portion 112a, an opening 117a of a pixel dividing layer portion, and an opening 118a of a black matrix layer portion are formed in a portion corresponding to the pixel area in plan view.

<Electronic Component>

The electronic component of the present invention includes the cured product of the present invention. It is preferable that the electronic component of the present invention has a metal wiring, and also has one or more selected from the group consisting of an insulating layer of the metal wiring, a protective layer of the metal wiring, and an interlayer insulating layer of the metal wiring. Examples of the electronic component include a semiconductor device, an antenna, a metal-clad laminate, a wiring substrate, a semiconductor package, an active component including a semiconductor device, and a passive component.

A hollow structure of the present invention includes the cured product of the present invention. The electronic component of the present invention preferably has a hollow structure. It is preferable that the hollow structure of the present invention has a hollow structure support and a hollow structure roof member, and also has a metal electrode and/or a metal wiring layer. The hollow structure support material and the hollow structure roof material preferably include the above polyimide-based resin from the viewpoint of improving heat resistance and reliability. Examples of the electronic component having a hollow structure include micro electro mechanical systems (MEMS).

<Semiconductor Device>

The semiconductor device of the present invention includes the cured product of the present invention. It is preferable that the semiconductor device of the present invention has a semiconductor chip, a sealing material covering the semiconductor chip, and a redistribution layer, and also has an interlayer insulating layer of the redistribution layer. In addition, in the semiconductor device of the present invention, the area of the redistribution layer is preferably larger than the area of the semiconductor chip in plan view from the viewpoint of improving the integration density and suppressing the transmission loss between the wirings. The sealing material covering the semiconductor chip is preferably in direct contact with the interlayer insulating layer of the redistribution layer. In addition, the sealing material covering the semiconductor chip preferably includes an epoxy resin, and more preferably includes a cured epoxy resin, from the viewpoint of improving heat resistance and reliability. Examples of the semiconductor device include a semiconductor device having a fan-out wafer level package structure, a fan-out panel level package structure, or an antenna-in-package structure. These package structures in the semiconductor device of the present invention may be either of structures including a single die or a multi-die, and a structure including a multi-die is preferable from the viewpoint of improving the integration density and suppressing transmission loss between wirings. The structure including the multi-die preferably has a chiplet structure, more preferably includes one or more types of dies selected from the group consisting of a logic, a memory, an analog IC (analog integrated circuit), an RF circuit (radio frequency circuit), and a power semiconductor, and still more preferably includes two or more types of dies.

<Other Electronic Articles>

The antenna of the present invention includes the cured product of the present invention. It is preferable that the antenna of the present invention has a metal wiring and/or a ground wiring, and also has one or more selected from the group consisting of an insulating layer of the metal wiring, a protective layer of the metal wiring, and an interlayer insulating layer of the metal wiring and the ground wiring. Examples of the antenna include a microstrip line antenna and a strip line antenna.

The metal-clad laminate of the present invention includes the cured product of the present invention. It is preferable that the metal-clad laminate of the present invention has a metal wiring, and also has one or more selected from the group consisting of an insulating layer of the metal wiring, a protective layer of the metal wiring, and a solder resist layer of the metal wiring. Examples of the metal-clad laminate include a printed circuit board.

<Use of Photosensitive Composition>

The cured product of the present invention can combine excellent light emission characteristics capable of low voltage driving, excellent reliability of a light emitting element, and high migration resistance. Therefore, the photosensitive composition of the present invention is also preferably used for forming a pixel dividing layer, a TFT planarization layer, a TFT protective layer, a TFT interlayer insulating layer, or a gate insulating layer in an organic EL display or a quantum dot display, and is also preferably used for forming a barrier layer, a planarization layer, or an interlayer insulating layer of a redistribution layer in a micro LED display or a mini LED display. Further, the photosensitive composition of the present invention is preferably used for forming an insulating layer of a metal wiring, a protective layer of a metal wiring, or an interlayer insulating layer of a metal wiring in an electronic component, is also preferably used for forming an interlayer insulating layer of a redistribution in a semiconductor device, is also preferably used for forming an insulating layer of a metal wiring, a protective layer of a metal wiring, or an interlayer insulating layer of a metal wiring and a ground wiring in an antenna, and is also preferably used for forming an insulating layer of a metal wiring, a protective layer of a metal wiring, or a solder resist layer of a metal wiring in a metal-clad laminate.

<Display Device according to Third Aspect>

A display device according to the third aspect of the present invention is a display device having a substrate, a first electrode, a second electrode, a pixel dividing layer, a light emitting layer, and a TFT planarization layer, in which the pixel dividing layer and/or the TFT planarization layer includes one or more resins selected from the group consisting of a

polyimide, a polyimide precursor, a polybenzoxazole, a polybenzoxazole precursor, a polyamideimide, a polyamideimide precursor, and a copolymer thereof, and

the resin has an amine residue having a phenolic hydroxyl group, and the amine residue having a phenolic hydroxyl group has at least two structures (XIa): a cyclic structure having a phenolic hydroxyl group, and a structure (XIIa): a structure linking at least two of the structures (XIa), and
the structure (XIIa) is a sulfonyl group, an alkylene group, a condensed polycyclic structure, a hydrocarbon group including an ether bond, a direct bond, an ether bond, a sulfide bond, a carbonyl group, a carboxylate ester bond, an amide bond, a urea bond, a urethane bond, a carbonate ester bond, a cycloalkylene group, an arylene group, a condensed polycyclic heterocyclic structure, a hydrocarbon group including a carbonyloxy group, or a hydrocarbon group including a carbonyl amide group, and
the display device satisfies the following condition (X1a):
(X1a) a content of a fluorine element in the pixel dividing layer is 1,000 ppm by mass or less, and/or a content of a fluorine element in the TFT planarization layer is 1,000 ppm by mass or less.

With the above configuration, the photosensitive composition according to the third aspect of the present invention can provide a display device having excellent light emission characteristics capable of low voltage driving in obtaining a desired current density and excellent reliability of a light emitting element. It is presumed that when the content of the compound including a fluorine atom or the component including a fluorine element in the above structure in the photosensitive composition is set to a specific value or less, the surface of the substrate is surface-modified by these components, so that the effects of achieving low voltage driving of the light emission characteristics and improving the light emission luminance become remarkable. Further, it is considered that by intentionally setting the content of the above components to a specific value or less, the detection intensity of these ions on the surface of the cured product is adjusted and the polarization structure and charge balance in the cured product are controlled. As a result, it is presumed that an effect of high reliability of the light emitting element is achieved by suppressing ion migration and electromigration caused by metal impurities and ion impurities that adversely affect the light emission characteristics or electrical insulation properties. Further, it is presumed that an effect of high reliability in the display device is achieved by suppressing migration and aggregation of the metal in the electrode or the metal in the metal wiring.
The resin in the pixel dividing layer and the resin in the TFT planarization layer are preferably the binder resin (A) in the photosensitive composition described above, and a resin having a structure derived from the binder resin (A) is also preferable. Examples and preferred descriptions regarding the resin in the pixel dividing layer and the resin in the TFT planarization layer are the same as those described in the binder resin (A) above.
The display device according to the third aspect of the present invention satisfies the following condition (X1a). The display device of the present invention preferably further satisfies the following condition (X2a), from the viewpoint of achieving low voltage driving of the light emission characteristics and improving the reliability of the light emitting element.
(X1a) The content of the fluorine element in the pixel dividing layer is 1,000 ppm by mass or less, and/or the content of the fluorine element in the TFT planarization layer is 1,000 ppm by mass or less.
(X2a) The content of fluoride ions in the pixel dividing layer is 1,000 ppm by mass or less, and/or the content of fluoride ions in the TFT planarization layer is 1,000 ppm by mass or less.
In the display device according to the third aspect of the present invention, the pixel dividing layer preferably contains a component including a fluorine element and/or a component including a fluoride ion. Further, it is also preferable that the resin in the pixel dividing layer has a fluorine atom or a fluoride ion in its structure. The TFT planarization layer preferably contains a component including a fluorine element and/or a component including a fluoride ion. Further, it is also preferable that the resin in the TFT planarization layer has a fluorine atom or a fluoride ion in its structure.
The content of the fluorine element in the pixel dividing layer and the content of the fluorine element in the TFT planarization layer are preferably 0 ppm by mass or more, more preferably 0.010 ppm by mass or more, still more preferably 0.030 ppm by mass or more, still more preferably 0.050 ppm by mass or more, particularly preferably 0.070 ppm by mass or more, and most preferably 0.10 ppm by mass or more, from the viewpoint of the effects of the invention described above. On the other hand, from the viewpoint of the effects of the invention described above, the content of the fluorine element is preferably 1,000 ppm by mass or less, more preferably 500 ppm by mass or less, still more preferably 300 ppm by mass or less, and particularly preferably 100 ppm by mass or less. Furthermore, the content of the fluorine element is preferably 50 ppm by mass or less, more preferably 30 ppm by mass or less, still more preferably 10 ppm by mass or less, even more preferably 5 ppm by mass or less, particularly preferably 3 ppm by mass or less, and most preferably 1 ppm by mass or less.
The preferred ranges of the content of fluoride ions in the pixel dividing layer and the TFT planarization layer are also similar to the preferred ranges of the content of the fluorine element in the pixel dividing layer and the TFT planarization layer, respectively. Examples and preferred descriptions regarding the components including a fluorine element and the components including a fluoride ion in the pixel dividing layer and the TFT planarization layer are as described for each

component in the photosensitive composition above.

The content of the fluorine element in the pixel dividing layer may be 0 ppm by mass. The content of fluoride ions in the pixel dividing layer may also be 0 ppm by mass. In a case where the content of the fluorine element and/or the content of fluoride ions in the pixel dividing layer exceeds 0 ppm by mass, in the display device according to the third aspect of the present invention, it is preferable that the pixel dividing layer contains a component including a fluorine element and/or a component including a fluoride ion. In a case where the content of the fluorine element and/or the content of fluoride ions in the pixel dividing layer exceeds 0 ppm by mass, it is also preferable that the resin in the pixel dividing layer has a fluorine atom or a fluoride ion in its structure in the display device according to the third aspect of the present invention.

The content of the fluorine element in the TFT planarization layer may be 0 ppm by mass. The content of fluoride ions in the TFT planarization layer may also be 0 ppm by mass. In a case where the content of the fluorine element and/or the content of fluoride ions in the TFT planarization layer exceeds 0 ppm by mass, it is preferable that the TFT planarization layer contains a component including a fluorine element and/or a component including a fluoride ion in the display device according to the third aspect of the present invention. In a case where the content of the fluorine element and/or the content of fluoride ions in the pixel dividing layer exceeds 0 ppm by mass, it is also preferable that the resin in the TFT planarization layer has a fluorine atom or a fluoride ion in its structure.

<Contents of Chlorine Element, Bromine Element, and Sulfur Element in Pixel Dividing Layer and TFT Planarization Layer>

The display device according to the third aspect of the present invention preferably further satisfies at least one of the following conditions (X1b), (X1c), and (X1d), from the viewpoint of achieving low voltage driving of the light emission characteristics and improving the reliability of the light emitting element.

(X1b) The content of the chlorine element in the pixel dividing layer is 0.010 ppm by mass or more and 1,000 ppm by mass or less, and/or the content of the chlorine element in the TFT planarization layer is 0.010 ppm by mass or more and 1,000 ppm by mass or less.

(X1c) The content of the bromine element in the pixel dividing layer is 0.010 ppm by mass or more and 1,000 ppm by mass or less, and/or the content of the bromine element in the TFT planarization layer is 0.010 ppm by mass or more and 1,000 ppm by mass or less.

(X1d) The content of the sulfur element in the pixel dividing layer is 0.010 ppm by mass or more and 1,000 ppm by mass or less, and/or the content of the sulfur element in the TFT planarization layer is 0.010 ppm by mass or more and 1,000 ppm by mass or less.

It is more preferable that the display device according to the third aspect of the invention further satisfies at least one of the following conditions (X2b), (X2c), and (X2d), from the viewpoint of the effects of the invention described above.

Sulfur-based anion: one or more ions selected from the group consisting of a sulfide ion, a hydrogen sulfide ion, a sulfate ion, and a hydrogen sulfate ion

(X2b) The content of chloride ions in the pixel dividing layer is 0.010 ppm by mass or more and 1,000 ppm by mass or less, and/or the content of chloride ions in the TFT planarization layer is 0.010 ppm by mass or more and 1,000 ppm by mass or less.

(X2c) The content of bromide ions in the pixel dividing layer is 0.010 ppm by mass or more and 1,000 ppm by mass or less, and/or the content of bromide ions in the TFT planarization layer is 0.010 ppm by mass or more and 1,000 ppm by mass or less.

(X2d) The content of the sulfur-based anions in the pixel dividing layer is 0.010 ppm by mass or more and 1,000 ppm by mass or less, and/or the content of the sulfur-based anions in the TFT planarization layer is 0.010 ppm by mass or more and 1,000 ppm by mass or less.

In the display device according to the third aspect of the present invention, it is preferable that the pixel dividing layer contains a component including a chlorine element, a bromine element, or a sulfur element and/or a component including a chloride ion, a bromide ion, or the sulfur-based anion. Further, it is also preferable that the resin in the pixel dividing layer has a chlorine atom, a bromine atom, a sulfur atom, a chloride ion, a bromide ion, or the sulfur-based anion in its structure. In the display device according to the third aspect of the present invention, it is preferable that the TFT planarization layer contains a component including a chlorine element, a bromine element, or a sulfur element and/or a component including a chloride ion, a bromide ion, or the sulfur-based anion. Further, it is also preferable that the resin in the TFT planarization layer has a chlorine atom, a bromine atom, a sulfur atom, a chloride ion, a bromide ion, or the sulfur-based anion in its structure.

The content of the chlorine element in the pixel dividing layer and the content of the chlorine element in the TFT planarization layer are preferably 0.010 ppm by mass or more, more preferably 0.030 ppm by mass or more, still more preferably 0.050 ppm by mass or more, still more preferably 0.070 ppm by mass or more, and particularly preferably 0.10

ppm by mass or more, from the viewpoint of the effects of the invention described above. On the other hand, the content of the chlorine element is preferably 1,000 ppm by mass or less, more preferably 500 ppm by mass or less, still more preferably 300 ppm by mass or less, and particularly preferably 100 ppm by mass or less from the viewpoint of the effects of the invention described above. Furthermore, the content of the chlorine element is preferably 50 ppm by mass or less, more preferably 30 ppm by mass or less, still more preferably 10 ppm by mass or less, still more preferably 5 ppm by mass or less, particularly preferably 3 ppm by mass or less, and most preferably 1 ppm by mass or less.

The preferred ranges of the content of the bromine element, the content of the sulfur element, the content of chloride ions, the content of bromide ions, and the content of sulfur-based anions in the pixel dividing layer and the TFT planarization layer are also the same as the preferred ranges of the content of the chlorine element in the pixel dividing layer and the TFT planarization layer, respectively. Examples and preferred descriptions regarding the components including a chlorine element, a bromine element, or a sulfur element; the components including a chloride ion, a bromide ion, or a sulfur-based anion; and the cationic species in the components including these anions in the pixel dividing layer and the TFT planarization layer are as described for each component in the photosensitive composition above.

One or more selected from the group consisting of the content of the chlorine element, the content of the bromine element, and the content of the sulfur element in the pixel dividing layer may be 0 ppm by mass. One or more selected from the group consisting of the content of chloride ions, the content of bromide ions, and the content of sulfur-based anions in the pixel dividing layer may also be 0 ppm by mass. In a case where one or more selected from the group consisting of the content of the chlorine element, the content of the bromine element, the content of the sulfur element, the content of chloride ions, the content of bromide ions, and the content of sulfur-based anions in the pixel dividing layer (hereinafter, "contents of the chlorine element and chloride ions or the like in the pixel dividing layer") exceeds 0 ppm by mass, in the display device according to the third aspect of the present invention, it is preferable that the pixel dividing layer contains a component including a chlorine element, a bromine element, or a sulfur element and/or a component including a chloride ion, a bromide ion, or a sulfur-based anion. Further, in a case where the contents of the chlorine element and chloride ions or the like in the pixel dividing layer exceed 0 ppm by mass, it is also preferable that the resin in the pixel dividing layer has a chlorine atom, a bromine atom, a sulfur atom, a chloride ion, a bromide ion, or a sulfur-based anion in its structure in the display device according to the third aspect of the present invention.

One or more selected from the group consisting of the content of the chlorine element, the content of the bromine element, and the content of the sulfur element in the TFT planarization layer may be 0 ppm by mass. One or more selected from the group consisting of the content of chloride ions, the content of bromide ions, and the content of sulfur-based anions in the TFT planarization layer may also be 0 ppm by mass. In a case where one or more selected from the group consisting of the content of the chlorine element, the content of the bromine element, the content of the sulfur element, the content of chloride ions, the content of bromide ions, and the content of sulfur-based anions in the TFT planarization layer (hereinafter, "contents of the chlorine element, chloride ions, etc. in the TFT planarization layer, or the like") exceeds 0 ppm by mass, in the display device according to the third aspect of the present invention, it is preferable that the TFT planarization layer contains a component including a chlorine element, a bromine element, or a sulfur element and/or a component including a chloride ion, a bromide ion, or a sulfur-based anion. Further, in a case where the contents of the chlorine element and chloride ions or the like in the TFT planarization layer exceed 0 ppm by mass, it is also preferable that the resin in the TFT planarization layer has a chlorine atom, a bromine atom, a sulfur atom, a chloride ion, a bromide ion, or a sulfur-based anion in its structure in the display device according to the third aspect of the present invention.

## EXAMPLES

Hereinafter, the present invention will be described more specifically with reference to Examples, Reference Examples, and Comparative Examples, but the present invention is not limited to these ranges. Note that names corresponding to abbreviations of compounds used in the following description or tables are collectively shown in Table 1-2.

[Table 1-2]

| Abbreviation | Corresponding name | Abbreviation | Corresponding name |
|---|---|---|---|
| 6FAP | 2,2-bis(3-amino-4-hydroxyphenyl)hexafluoropropane | KBM-503 | 3-methacryloyloxypropyltrimethoxysilane (manufactured by Shin-Etsu Chemical Co., Ltd.) |
| 6FDA | 4,4'-hexafluoropropane-2,2-diyl-bis(1,2-phthalic anhydride) | MA | Maleic anhydride |
| ABPS | Bis(3-amino-4-hydroxyphenyl)sulfone | MAA | Methacrylic acid |
| ADPE | bis(3-amino-4-hydroxyphenyl)ether, | MBA | 3-methoxy-n-butyl acetate |
| APB-N | 1,3-bis(3-aminophenoxy)benzene | MCS | m-cresol |
| APB-P | 1,3-bis(4-amino-3-hydroxyphenoxy)benzene | MEK-ST-40 | Silica particle dispersion liquid using methyl ethyl ketone as dispersion solvent (manufactured by Nissan Chemical Corporation) |
| APC | Argentum-Palladium-Cuprum (silver-palladium-copper alloy) | MOP | 4-methoxyphenol |
| BAFL | 9,9-bis(3-amino-4-hydroxyphenyl)fluorene | m-TB | (4,4'-diamino-2,2'-dimethyl)biphenyl |
| BAP | 2,2-bis(3-amino-4-hydroxyphenyl)propane | NA | 5-norbornene-2,3-dicarboxylic anhydride |
| BGPF | 9,9-bis(4-glycidoxyphenyl)fluorene | NC-3000-H | Epoxy resin having a structural unit including a biphenyl skeleton, a benzene skeleton, and one epoxy group (manufactured by Nippon Kayaku Co., Ltd.) |
| BnMA | Benzyl methacrylate | | |
| BSAA | 2,2-bis[4-(3,4-dicarboxyphenoxy)phenyl]propane dianhydride | ODB-HBT | Mixture of dicarboxylic acid derivatives obtained by reacting bis(4-carboxyphenyl)ether with 1-hydroxy-1,2,3-benzotriazole |
| DAE | Bis(4-aminophenyl)ether | | |
| DDS | Bis(3-aminophenyl)sulfone | ODPA | Oxydiphthalic dianhydride |
| DFA | N,N-dimethylformamide dimethyl acetal | PGMEA | Propylene glycol monomethyl ether acetate |
| EDM | Diethylene glycol ethyl methyl ether | PHA | Phthalic anhydride |
| EL | Ethyl lactate | SiDA | 1,3-bis(3-aminopropyl)tetramethyldisiloxane |
| FDA | 9,9-bis(4-aminophenyl)fluorene | STR | Styrene |
| GBL | γ-butyrolactone | TCDM | Methacrylic acid tricyclo[5.2.1.02,6]decan-8-yl; methylol-tricyclodecane methacrylate |
| GMA | Glycidyl methacrylate | | |
| HAB | (4,4'-diamino-3,3'-dihydroxy)biphenyl | THPHA | 1,2,3,6-tetrahydrophthalic anhydride |
| HAD | Formaldehyde | TMAC | Trimellitic anhydride chloride |
| HST | 4-hydroxystyrene | TMAH | Tetramethylammonium hydroxide |
| ITO | Indium tin oxide | | |

<Synthesis Example of Each Resin>

As the binder resin (A), the composition of each resin obtained in Synthesis Examples 1 to 62 is collectively shown in Table 1-3 to Table 1-8. Each resin was synthesized by a known method by appropriately changing a monomer compound to be a monomer and a copolymerization ratio based on a method described in a known document. The copolymerization ratio of the monomers is as shown in Table 1-3 to Table 1-8.

The hydroxy group-containing diamines (HA-1) and (HA-2) having the following structures used in Synthesis Examples 9 and 23 were synthesized by a known method based on the synthesis method described in Synthesis Example 1 in paragraphs [0374] to [0376] of WO 2016/056451 A. Note that, the resins obtained in Synthesis Examples 9 and 23 using the hydroxy group-containing diamines (HA-1) and (HA-2) having the following structures are polyimide precursors having an amic acid structure and an amic acid ester structure and an imide cyclization ratio of less than 50%, and are also polybenzoxazole precursors having a hydroxyamide structure and a benzoxazole cyclization ratio of less than 50%.

[Chemical Formula 16]

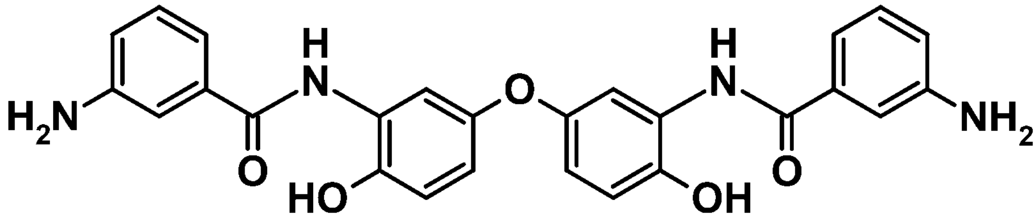

(HA-1)

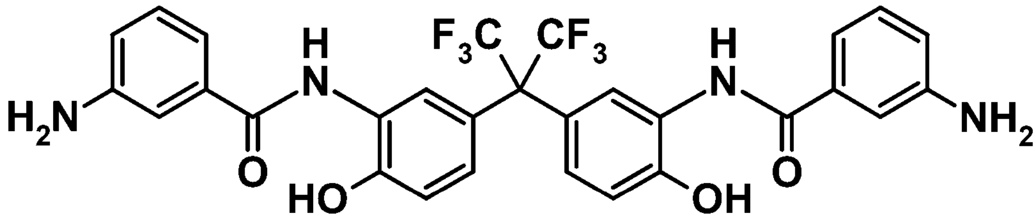

(HA-2)

The structures of the diamines (DA70), (DA71), (DA75) to (DA80), (DA82), (DA84), (DA86), (DA90), (DA92), (DA94), and (DA100) to (DA104) used in the respective Synthesis Examples are shown below. These compounds were synthesized by a known method. The structures of tetracarboxylic dianhydrides (AH1) and (AH2) used in each Synthesis Example are shown below.

[Chemical Formula 17]

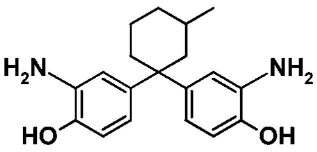

(DA70)

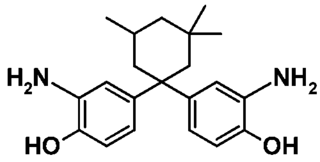

(DA71)

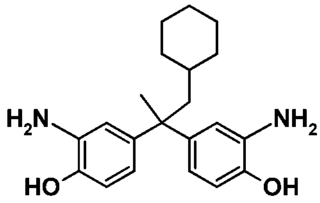

(DA75)

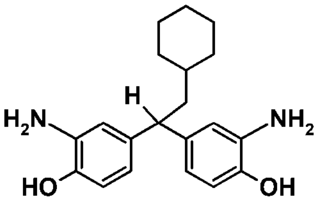

(DA76)

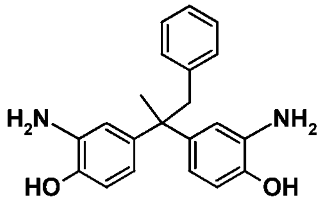

(DA77)

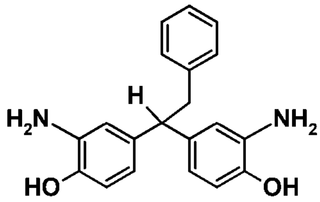

(DA78)

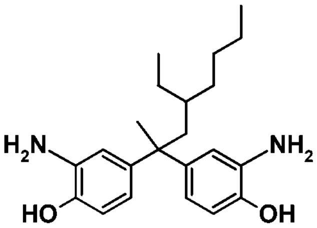

(DA79)

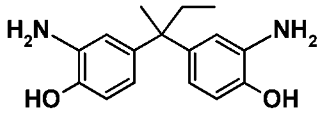

(DA80)

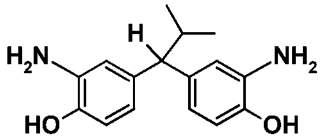

(DA82)

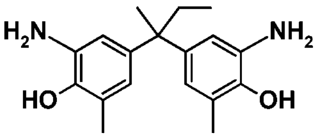

(DA84)

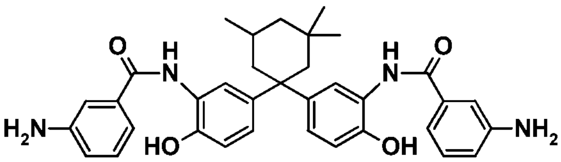

(DA86)

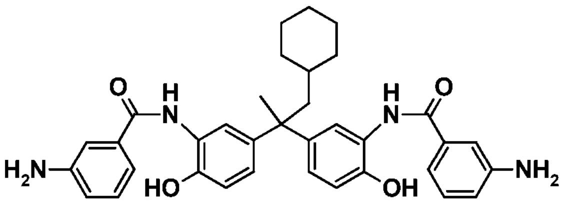

(DA90)

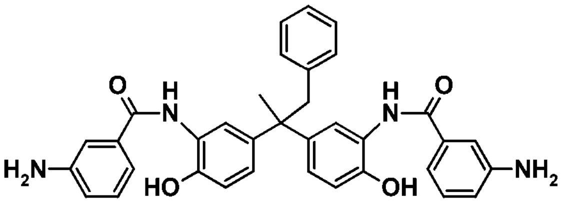

(DA92)

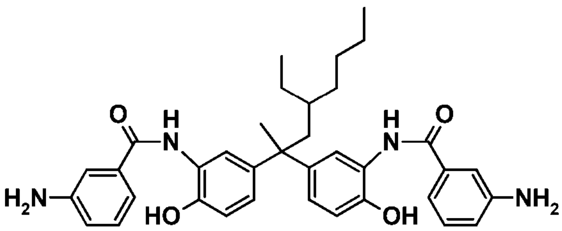

(DA94)

[Chemical Formula 18]

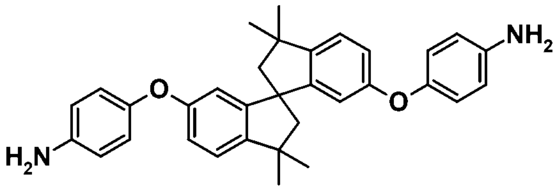

(DA100)

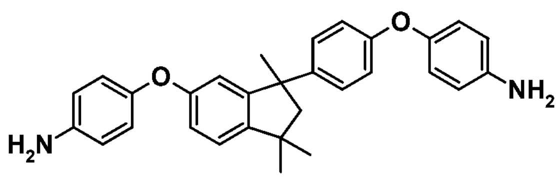

(DA101)

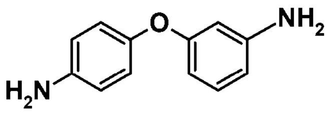

(DA102)

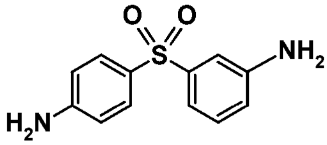

(DA103)

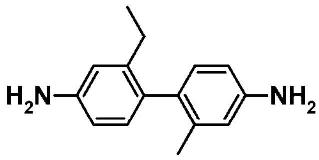

(DA104)

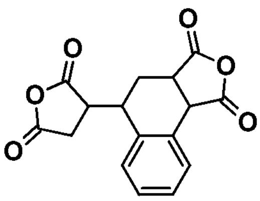

(AH1)

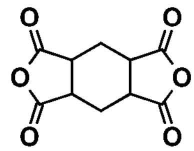

(AH2)

The amine residue derived from any of the diamines (DA70), (DA71), (DA75) to (DA80), (DA82), (DA84), (DA86), (DA90), (DA92), and (DA94) corresponds to the first amine residue (DA1), and satisfies the above conditions (S1x), (S1y), and (S1z). The amine residue derived from any one of (DA70), (DA71), (DA79), (DA86), and (DA94) has a chiral carbon atom that is a chiral center. The amine residue derived from any of the diamines (DA70), (DA71), (DA86), and (DA90) also satisfies the above condition (Y1). The amine residue derived from any of the diamines (DA75) to (DA80), (DA82), (DA84), (DA92), and (DA94) also satisfies the above condition (Y3). Note that, the resins obtained in Synthesis Example 42 to 45 using the diamines (DA86), (DA90), (DA92), and (DA94) are polyimide precursors having an amic acid structure and an amic acid ester structure and an imide cyclization ratio of less than 50%, and are also polybenzoxazole precursors having a hydroxyamide structure and a benzoxazole cyclization ratio of less than 50%. The resin obtained in Synthesis Example 31 using the diamine (DA94) is a polyimide having an imide structure and an imide cyclization ratio of 50% or more, and is also a polybenzoxazole precursor having a hydroxyamide structure and a benzoxazole cyclization ratio of less than 50%.

The amine residue derived from any of the diamines (DA100) to (DA104) corresponds to the second amine residue (DA2). Further, the amine residue derived from the diamine (DA100) has a spiro structure that is a chiral axis, and therefore satisfies the above conditions (S2x), (S2y), and (S2z). The amine residue derived from the diamine (DA101) satisfies the above conditions (S1x), (S1y), and (S1z). The amine residue derived from the diamine (DA101) has a chiral carbon atom that is a chiral center, and therefore also satisfies the above conditions (S2x) and (S2y). The amine residue derived from any of the diamines (DA102) to (DA104) satisfies the above conditions (S1x), (S1y), and (S1z).

The carboxylic acid residue derived from either tetracarboxylic dianhydride (AH1) or (AH2) corresponds to the alicyclic structure-containing carboxylic acid residue (CB). Further, the carboxylic acid residue derived from tetracarboxylic dianhydride (AH1) has two ring member atoms of an alicyclic structure bonded to a carbonyl group, and has two ring member atoms of an alicyclic structure not bonded to a carbonyl group. The carboxylic acid residue derived from tetracarboxylic dianhydride (AH1) also has a cyclohexane structure. The carboxylic acid residue derived from tetracarboxylic dianhydride (AH2) has four ring member atoms of an alicyclic structure bonded to a carbonyl group. The carboxylic acid residue derived from tetracarboxylic dianhydride (AH2) also has a tetrahydronaphthalene structure.

In Synthesis Examples 3 to 17, 23, and 32 to 56, the amic acid structure in the resin was reacted with DFA as an esterifying agent to convert the structure to an amic acid ester structure having a methyl group.

In Synthesis Example 27, GMA having an epoxy group was reacted with a carboxy group derived from MAA in the resin, and ring-opening addition was performed on all the epoxy groups of GMA.

[Table 1-3]

| | Polymer | Monomer [mol ratio] | | | | | | | Weight average molecular weight | Acid equivalent<br>Phenol equivalent<br>Carboxylic acid equivalent<br>[g/mol] | Double bond equivalent [g/mol] |
|---|---|---|---|---|---|---|---|---|---|---|---|
| | | Carboxylic acid derivative | | Amine derivative | | | End-sealing agent | Esterifying agent | | | |
| Synthesis Example 1 | Polyimide (PI-1) | BSAA (80) | - | BAP (50) | DAE (45) | SiDA (5) | MA (40) | - | 26,000 | Acid equivalent: 660<br>Phenol equivalent: 660 | - |
| Synthesis Example 2 | Polyimide (PI-2) | BSAA (80) | - | ABPS (50) | DAE (45) | SiDA (5) | MA (40) | - | 28,000 | Acid equivalent: 670<br>Phenol equivalent: 670 | - |
| Synthesis Example 3 | Polyimide precursor (PIP-1) | BSAA (80) | - | BAP (50) | DAE (45) | SiDA (5) | MA (40) | DFA (200) | 18,000 | Acid equivalent: 370<br>Phenol equivalent: 700<br>Carboxylic acid equivalent: 790 | - |
| Synthesis Example 4 | Polyimide precursor (PIP-2) | BSAA (80) | - | ABPS (50) | DAE (45) | SiDA (5) | MA (40) | DFA (200) | 20,000 | Acid equivalent: 410<br>Phenol equivalent: 700<br>Carboxylic acid equivalent: 980 | - |
| Synthesis Example 5 | Polyimide precursor (PIP-3) | BSAA (80) | - | BAFL (50) | DAE (45) | SiDA (5) | MA (40) | DFA (200) | 18,000 | Acid equivalent: 400<br>Phenol equivalent: 760<br>Carboxylic acid equivalent: 860 | - |
| Synthesis Example 6 | Polyimide precursor (PIP-4) | BSAA (80) | - | APB-P (50) | DAE (45) | SiDA (5) | MA (40) | DFA (200) | 18,000 | Acid equivalent: 390<br>Phenol equivalent: 730<br>Carboxylic acid equivalent: 830 | - |
| Synthesis Example 7 | Polyimide precursor (PIP-5) | BSAA (80) | - | HAB (50) | DAE (45) | SiDA (5) | MA (40) | DFA (200) | 18,000 | Acid equivalent: 360<br>Phenol equivalent: 670<br>Carboxylic acid equivalent: 770 | - |
| Synthesis Example 8 | Polyimide precursor (PIP-6) | BSAA (80) | - | ADPE (50) | DAE (45) | SiDA (5) | MA (40) | DFA (200) | 18,000 | Acid equivalent: 360<br>Phenol equivalent: 680<br>Carboxylic acid equivalent: 770 | - |
| Synthesis Example 9 | Polyimide precursor (PIP-7) | BSAA (80) | - | HA-1 (50) | DAE (45) | SiDA (5) | MA (40) | DFA (200) | 20,000 | Acid equivalent: 470<br>Phenol equivalent: 800<br>Carboxylic acid equivalent: 1,110 | - |
| Synthesis Example 10 | Polyimide precursor (PIP-8) | BSAA (80) | - | BAP (50) | DDS (45) | SiDA (5) | MA (40) | DFA (200) | 20,000 | Acid equivalent: 420<br>Phenol equivalent: 710<br>Carboxylic acid equivalent: 990 | - |
| Synthesis Example 11 | Polyimide precursor (PIP-9) | BSAA (80) | - | BAP (50) | FDA (45) | SiDA (5) | MA (40) | DFA (200) | 18,000 | Acid equivalent: 410<br>Phenol equivalent: 760<br>Carboxylic acid equivalent: 870 | - |
| Synthesis Example 12 | Polyimide precursor (PIP-10) | BSAA (80) | - | BAP (50) | APB-N (45) | SiDA (5) | MA (40) | DFA (200) | 18,000 | Acid equivalent: 390<br>Phenol equivalent: 740<br>Carboxylic acid equivalent: 840 | - |

[Table 1-4]

| | Polymer | Monomer [mol ratio] | | | | | | | Weight average molecular weight | Acid equivalent<br>Phenol equivalent<br>Carboxylic acid equivalent<br>[g/mol] | Double bond equivalent [g/mol] |
|---|---|---|---|---|---|---|---|---|---|---|---|
| | | Carboxylic acid derivative | | Amine derivative | | | End-sealing agent | Esterifying agent | | | |
| Synthesis Example 13 | Polyimide precursor (PIP-11) | BSAA (80) | - | BAP (50) | m-TB (45) | SiDA (5) | MA (40) | DFA (200) | 18,000 | Acid equivalent: 370<br>Phenol equivalent: 700<br>Carboxylic acid equivalent: 800 | - |
| Synthesis Example 14 | Polyimide precursor (PIP-12) | BSAA (80) | - | BAP (30) | DAE (65) | SiDA (5) | MA (40) | DFA (200) | 18,000 | Acid equivalent: 460<br>Phenol equivalent: 1,140<br>Carboxylic acid equivalent: 780 | - |
| Synthesis Example 15 | Polyimide precursor (PIP-13) | BSAA (80) | - | BAP (70) | DAE (25) | SiDA (5) | MA (40) | DFA (200) | 18,000 | Acid equivalent: 310<br>Phenol equivalent: 510<br>Carboxylic acid equivalent: 800 | - |
| Synthesis Example 16 | Polyimide precursor (PIP-14) | BSAA (80) | - | BAP (50) | DAE (45) | SiDA (5) | MA (40) | DFA (300) | 18,000 | Acid equivalent: 430<br>Phenol equivalent: 700<br>Carboxylic acid equivalent: 1,090 | - |
| Synthesis Example 17 | Polyimide precursor (PIP-15) | BSAA (20) | ODB-HBT (60) | BAP (75) | DAE (20) | SiDA (5) | MA (40) | DFA (50) | 20,000 | Acid equivalent: 260<br>Phenol equivalent: 350<br>Carboxylic acid equivalent: 1,010 | - |
| Synthesis Example 18 | Polybenzoxazole (PB-1) | ODB-HBT (80) | - | BAP (95) | - | SiDA (5) | MA (40) | - | 26,000 | Acid equivalent: 400<br>Phenol equivalent: 600<br>Carboxylic acid equivalent: 1,140 | - |
| Synthesis Example 19 | Polybenzoxazole precursor (PBP-1) | ODB-HBT (80) | - | BAP (100) | - | - | MA (40) | - | 20,000 | Acid equivalent: 200<br>Phenol equivalent: 240<br>Carboxylic acid equivalent: 1,190 | - |
| Synthesis Example 20 | Polybenzoxazole precursor (PBP-2) | ODB-HBT (80) | - | ABPS (100) | - | - | MA (40) | - | 22,000 | Acid equivalent: 210<br>Phenol equivalent: 250<br>Carboxylic acid equivalent: 1,250 | - |
| Synthesis Example 21 | Polyamideimide (PAI-1) | TMAC (80) | - | BAP (100) | - | - | MA (40) | - | 25,000 | Acid equivalent: 210<br>Phenol equivalent: 210 | - |
| Synthesis Example 22 | Polyimide (PI-3) | BSAA (100) | - | 6FAP (95) | - | SiDA (5) | MA (40) | - | 27,000 | Acid equivalent: 420<br>Phenol equivalent: 420 | - |
| Synthesis Example 23 | Polyimide precursor (PIP-16) | 6FDA (80) | - | 6FAP (45) | HA-2 (50) | SiDA (5) | MA (40) | DFA (200) | 20,000 | Acid equivalent: 500<br>Phenol equivalent: 980<br>Carboxylic acid equivalent: 1,000 | - |
| Synthesis Example 24 | Polybenzoxazole precursor (PBP-3) | ODB-HBT (80) | - | 6FAP (100) | - | - | NA (40) | - | 22,000 | Acid equivalent: 260<br>Phenol equivalent: 310<br>Carboxylic acid equivalent: 1,530 | - |

[Table 1-5]

| | Polymer | Monomer [mol ratio] | | | | Weight average molecular weight | Acid equivalent (= carboxylic acid equivalent) [g/mol] | Double bond equivalent [g/mol] |
|---|---|---|---|---|---|---|---|---|
| | | Polyfunctional epoxy compound | Polyfunctional carboxylic dianhydride | Carboxylic anhydride | Radical polymerizable group-containing carboxylic acid compound | | | |
| Synthesis Example 25 | Polycyclic side chain-containing resin (CR-1) | BGPF (100) | ODPA (90) | PHA (20) | MAA (200) | 4,700 | 470 | 470 |

| | Polymer | Monomer [mol ratio] | | | | Weight average molecular weight | Acid equivalent (= carboxylic acid equivalent) [g/mol] | Double bond equivalent [g/mol] |
|---|---|---|---|---|---|---|---|---|
| | | Polyfunctional epoxy compound | | Carboxylic anhydride | Radical polymerizable group-containing carboxylic acid compound | | | |
| Synthesis Example 26 | Acid-modified epoxy resin (AE-1) | NC-3000-H (Epoxy equivalent: 290 g/mol) (Epoxy group standard: 0.2 mol) (Epoxy group standard mol ratio: 100) | | THPHA (0.18 mol) (mol ratio: 90) | MAA (0.20 mol) (mol ratio: 100) | 4,500 | 570 | 510 |

| | Polymer | Monomer [mol ratio] | | | | Weight average molecular weight | Acid equivalent (= carboxylic acid equivalent) [g/mol] | Double bond equivalent [g/mol] |
|---|---|---|---|---|---|---|---|---|
| | | Acidic copolymerization component | Aromatic copolymerization component | Alicyclic copolymerization component | Radical polymerizable group-containing epoxy compound | | | |
| Synthesis Example 27 | Acrylic resin (AC-1) | MAA (50) | BnMA (45) | TCDM (5) | GMA (20) | 15,000 | 540 | 810 |

| | Polymer | Monomer [mol ratio] | | Weight average molecular weight | Acid equivalent (= phenol equivalent) [g/mol] | Double bond equivalent [g/mol] |
|---|---|---|---|---|---|---|
| | | Phenol compound | Aldehyde compound Bisalkoxymethyl compound | | | |
| Synthesis Example 28 | Phenolic resin (PR-1) | MCS (100) | HAD (100) | 3,000 | 120 | - |

| | Polymer | Monomer [mol ratio] | | Weight average molecular weight | Acid equivalent (= phenol equivalent) [g/mol] | Double bond equivalent [g/mol] |
|---|---|---|---|---|---|---|
| | | Hydroxystyrene copolymerization component | Styrene copolymerization component | | | |
| Synthesis Example 29 | Polyhydroxystyrene (PHS-1) | HST (80) | STR (20) | 9,500 | 150 | - |

[Table 1-6]

| | Polymer | Monomer [mol ratio] | | | | | | | Weight average molecular weight | Acid equivalent Phenol equivalent Carboxylic acid equivalent [g/mol] | Double bond equivalent [g/mol] |
|---|---|---|---|---|---|---|---|---|---|---|---|
| | | Carboxylic acid derivative | | Amine derivative | | | End-sealing agent | Esterifying agent | | | |
| Synthesis Example 30 | Polyimide (PI-4) | BSAA (80) | - | DA79 (70) | DA104 (25) | SiDA (5) | MA (40) | - | 26,000 | Acid equivalent: 540<br>Phenol equivalent: 540 | - |
| Synthesis Example 31 | Polyimide (PI-5) | BSAA (80) | - | DA94 (70) | DA104 (25) | SiDA (5) | MA (40) | - | 26,000 | Acid equivalent: 660<br>Phenol equivalent: 660 | - |
| Synthesis Example 32 | Polyimide precursor (PIP-17) | BSAA (80) | - | DA79 (70) | DA104 (25) | SiDA (5) | MA (40) | DFA (200) | 18,000 | Acid equivalent: 350<br>Phenol equivalent: 560<br>Carboxylic acid equivalent: 890 | - |
| Synthesis Example 33 | Polyimide precursor (PIP-18) | BSAA (80) | - | DA70 (70) | DA104 (25) | SiDA (5) | MA (40) | DFA (200) | 18,000 | Acid equivalent: 330<br>Phenol equivalent: 540<br>Carboxylic acid equivalent: 850 | - |
| Synthesis Example 34 | Polyimide precursor (PIP-19) | BSAA (80) | - | DA71 (70) | DA104 (25) | SiDA (5) | MA (40) | DFA (200) | 18,000 | Acid equivalent: 340<br>Phenol equivalent: 550<br>Carboxylic acid equivalent: 880 | - |
| Synthesis Example 35 | Polyimide precursor (PIP-20) | BSAA (80) | - | DA75 (70) | DA104 (25) | SiDA (5) | MA (40) | DFA (200) | 18,000 | Acid equivalent: 340<br>Phenol equivalent: 550<br>Carboxylic acid equivalent: 880 | - |
| Synthesis Example 36 | Polyimide precursor (PIP-21) | BSAA (80) | - | DA76 (70) | DA104 (25) | SiDA (5) | MA (40) | DFA (200) | 18,000 | Acid equivalent: 340<br>Phenol equivalent: 540<br>Carboxylic acid equivalent: 860 | - |
| Synthesis Example 37 | Polyimide precursor (PIP-22) | BSAA (80) | - | DA77 (70) | DA104 (25) | SiDA (5) | MA (40) | DFA (200) | 18,000 | Acid equivalent: 340<br>Phenol equivalent: 550<br>Carboxylic acid equivalent: 870 | - |
| Synthesis Example 38 | Polyimide precursor (PIP-23) | BSAA (80) | - | DA78 (70) | DA104 (25) | SiDA (5) | MA (40) | DFA (200) | 18,000 | Acid equivalent: 330<br>Phenol equivalent: 540<br>Carboxylic acid equivalent: 860 | - |
| Synthesis Example 39 | Polyimide precursor (PIP-24) | BSAA (80) | - | DA80 (70) | DA104 (25) | SiDA (5) | MA (40) | DFA (200) | 18,000 | Acid equivalent: 320<br>Phenol equivalent: 520<br>Carboxylic acid equivalent: 820 | - |
| Synthesis Example 40 | Polyimide precursor (PIP-25) | BSAA (80) | - | DA82 (70) | DA104 (25) | SiDA (5) | MA (40) | DFA (200) | 18,000 | Acid equivalent: 320<br>Phenol equivalent: 520<br>Carboxylic acid equivalent: 820 | - |

[Table 1-7]

| | Polymer | Monomer [mol ratio] | | | | | | | Weight average molecular weight | Acid equivalent Phenol equivalent Carboxylic acid equivalent [g/mol] | Double bond equivalent [g/mol] |
|---|---|---|---|---|---|---|---|---|---|---|---|
| | | Carboxylic acid derivative | | Amine derivative | | | End-sealing agent | Esterifying agent | | | |
| Synthesis Example 41 | Polyimide precursor (PIP-26) | BSAA (80) | - | DA84 (70) | DA104 (25) | SiDA (5) | MA (40) | DFA (200) | 18,000 | Acid equivalent: 330 Phenol equivalent: 530 Carboxylic acid equivalent: 840 | - |
| Synthesis Example 42 | Polyimide precursor (PIP-27) | BSAA (80) | - | DA86 (70) | DA104 (25) | SiDA (5) | MA (40) | DFA (200) | 20,000 | Acid equivalent: 410 Phenol equivalent: 670 Carboxylic acid equivalent: 1,060 | - |
| Synthesis Example 43 | Polyimide precursor (PIP-28) | BSAA (80) | - | DA90 (70) | DA104 (25) | SiDA (5) | MA (40) | DFA (200) | 20,000 | Acid equivalent: 410 Phenol equivalent: 670 Carboxylic acid equivalent: 1,060 | - |
| Synthesis Example 44 | Polyimide precursor (PIP-29) | BSAA (80) | - | DA92 (70) | DA104 (25) | SiDA (5) | MA (40) | DFA (200) | 20,000 | Acid equivalent: 410 Phenol equivalent: 670 Carboxylic acid equivalent: 1,060 | - |
| Synthesis Example 45 | Polyimide precursor (PIP-30) | BSAA (80) | - | DA94 (70) | DA104 (25) | SiDA (5) | MA (40) | DFA (200) | 20,000 | Acid equivalent: 420 Phenol equivalent: 680 Carboxylic acid equivalent: 1,080 | - |
| Synthesis Example 46 | Polyimide precursor (PIP-31) | BSAA (80) | - | DA79 (70) | DA100 (25) | SiDA (5) | MA (40) | DFA (200) | 18,000 | Acid equivalent: 370 Phenol equivalent: 610 Carboxylic acid equivalent: 960 | - |
| Synthesis Example 47 | Polyimide precursor (PIP-32) | BSAA (80) | - | DA79 (70) | DA103 (25) | SiDA (5) | MA (40) | DFA (200) | 20,000 | Acid equivalent: 370 Phenol equivalent: 560 Carboxylic acid equivalent: 1,090 | - |
| Synthesis Example 48 | Polyimide precursor (PIP-33) | BSAA (40) | AH1 (40) | DA79 (70) | DA104 (25) | SiDA (5) | MA (40) | DFA (200) | 16,000 | Acid equivalent: 310 Phenol equivalent: 500 Carboxylic acid equivalent: 790 | - |
| Synthesis Example 49 | Polyimide precursor (PIP-34) | BSAA (40) | AH2 (40) | DA79 (70) | DA104 (25) | SiDA (5) | MA (40) | DFA (200) | 16,000 | Acid equivalent: 290 Phenol equivalent: 480 Carboxylic acid equivalent: 750 | - |
| Synthesis Example 50 | Polyimide precursor (PIP-35) | BSAA (80) | - | DA79 (70) | DDS (25) | SiDA (5) | MA (40) | DFA (200) | 20,000 | Acid equivalent: 370 Phenol equivalent: 560 Carboxylic acid equivalent: 1,090 | - |
| Synthesis Example 51 | Polyimide precursor (PIP-36) | BSAA (80) | - | DA79 (70) | FDA (25) | SiDA (5) | MA (40) | DFA (200) | 18,000 | Acid equivalent: 360 Phenol equivalent: 580 Carboxylic acid equivalent: 920 | - |
| Synthesis Example 52 | Polyimide precursor (PIP-37) | BSAA (80) | - | BAP (70) | DA104 (25) | SiDA (5) | MA (40) | DFA (200) | 18,000 | Acid equivalent: 320 Phenol equivalent: 510 Carboxylic acid equivalent: 810 | - |

[Table 1-8]

| | Polymer | Monomer [mol ratio] | | | | | | | Weight average molecular weight | Acid equivalent Phenol equivalent Carboxylic acid equivalent [g/mol] | Double bond equivalent [g/mol] |
|---|---|---|---|---|---|---|---|---|---|---|---|
| | | Carboxylic acid derivative | | Amine derivative | | | End-sealing agent | Esterifying agent | | | |
| Synthesis Example 53 | Polyimide precursor (PIP-38) | BSAA (80) | - | BAP (70) | DA100 (25) | SiDA (5) | MA (40) | DFA (200) | 18,000 | Acid equivalent: 340 Phenol equivalent: 560 Carboxylic acid equivalent: 890 | - |
| Synthesis Example 54 | Polyimide precursor (PIP-39) | BSAA (80) | - | BAP (70) | DA101 (25) | SiDA (5) | MA (40) | DFA (200) | 18,000 | Acid equivalent: 340 Phenol equivalent: 550 Carboxylic acid equivalent: 870 | - |
| Synthesis Example 55 | Polyimide precursor (PIP-40) | BSAA (80) | - | BAP (70) | DA102 (25) | SiDA (5) | MA (40) | DFA (200) | 18,000 | Acid equivalent: 310 Phenol equivalent: 510 Carboxylic acid equivalent: 800 | - |
| Synthesis Example 56 | Polyimide precursor (PIP-41) | BSAA (80) | - | BAP (70) | DA103 (25) | SiDA (5) | MA (40) | DFA (200) | 20,000 | Acid equivalent: 340 Phenol equivalent: 510 Carboxylic acid equivalent: 990 | - |
| Synthesis Example 57 | Polybenzoxazole (PB-2) | ODB-HBT (80) | - | DA79 (95) | - | SiDA (5) | MA (40) | - | 26,000 | Acid equivalent: 480 Phenol equivalent: 720 Carboxylic acid equivalent: 1,370 | - |
| Synthesis Example 58 | Polybenzoxazole precursor (PBP-4) | ODB-HBT (80) | - | DA79 (100) | - | - | MA (40) | - | 20,000 | Acid equivalent: 240 Phenol equivalent: 290 Carboxylic acid equivalent: 1,440 | - |
| Synthesis Example 59 | Polybenzoxazole precursor (PBP-5) | ODB-HBT (80) | - | DA71 (100) | - | - | MA (40) | - | 20,000 | Acid equivalent: 240 Phenol equivalent: 280 Carboxylic acid equivalent: 1,400 | - |
| Synthesis Example 60 | Polybenzoxazole precursor (PBP-6) | ODB-HBT (80) | - | DA82 (100) | - | - | MA (40) | - | 20,000 | Acid equivalent: 210 Phenol equivalent: 250 Carboxylic acid equivalent: 1,230 | - |
| Synthesis Example 61 | Polybenzoxazole precursor (PBP-7) | ODB-HBT (80) | - | DA84 (100) | - | - | MA (40) | - | 20,000 | Acid equivalent: 220 Phenol equivalent: 260 Carboxylic acid equivalent: 1,300 | - |
| Synthesis Example 62 | Polyamideimide (PAI-2) | TMAC (80) | - | DA79 (100) | - | - | MA (40) | - | 25,000 | Acid equivalent: 260 Phenol equivalent: 260 | - |

The structural units and structures of the resins obtained in the respective Synthesis Examples and the resins used in the respective Examples, Reference Examples, and Comparative Examples are collectively shown in Table 2-1 to Table 2-4.

[Table 2-1]

| Binder resin (A) | Structural unit of binder resin (A) [mol ratio] | | | | | | Content of specific element in structure of resin | Imide cyclization ratio Benzoxazole cyclization ratio | Structural unit and structure of binder resin (A) |
|---|---|---|---|---|---|---|---|---|---|
| | Polyimide unit | Polyimide precursor unit | | Polybenzoxazole unit | Polybenzoxazole precursor unit | Polyamideimide unit | | | |
| | | Amic acid structure | Amic acid ester structure | | | | | | |
| Polyimide (PI-1) | 100 | - | - | - | - | - | - | Imide cyclization ratio = 100% | Unit represented by formula (1) (Structural unit having imide structure) |
| Polyimide (PI-2) | 100 | - | - | - | - | - | Sulfur element = 2.4 mass% | Imide cyclization ratio = 100% | |
| Polyimide precursor (PIP-1) | 10 | 30 | 60 | - | - | - | - | Imide cyclization ratio = 10% | Unit represented by formula (1) and formula (2) (Structural unit having imide structure and amide structure) |
| Polyimide precursor (PIP-2) | 20 | 20 | 60 | - | - | - | Sulfur element = 2.3 mass% | Imide cyclization ratio = 20% | |
| Polyimide precursor (PIP-3) | 10 | 30 | 60 | - | - | - | - | Imide cyclization ratio = 10% | |
| Polyimide precursor (PIP-4) | 10 | 30 | 60 | - | - | - | - | Imide cyclization ratio = 10% | |
| Polyimide precursor (PIP-5) | 10 | 30 | 60 | - | - | - | - | Imide cyclization ratio = 10% | |
| Polyimide precursor (PIP-6) | 10 | 30 | 60 | - | - | - | - | Imide cyclization ratio = 10% | |
| Polyimide precursor (PIP-7) | 20 | 20 | 60 | - | 100 | - | - | Imide cyclization ratio = 20% Benzoxazole cyclization ratio = 0% | Unit represented by formula (1), formula (2), and formula (4) (Structural unit having imide structure and amide structure) |
| Polyimide precursor (PIP-8) | 20 | 20 | 60 | - | - | - | Sulfur element = 2.0 mass% | Imide cyclization ratio = 20% | Unit represented by formula (1) and formula (2) (Structural unit having imide structure and amide structure) |
| Polyimide precursor (PIP-9) | 10 | 30 | 60 | - | - | - | - | Imide cyclization ratio = 10% | |
| Polyimide precursor (PIP-10) | 10 | 30 | 60 | - | - | - | - | Imide cyclization ratio = 10% | |
| Polyimide precursor (PIP-11) | 10 | 30 | 60 | - | - | - | - | Imide cyclization ratio = 10% | |
| Polyimide precursor (PIP-12) | 10 | 30 | 60 | - | - | - | - | Imide cyclization ratio = 10% | |
| Polyimide precursor (PIP-13) | 10 | 30 | 60 | - | - | - | - | Imide cyclization ratio = 10% | |
| Polyimide precursor (PIP-14) | 10 | 15 | 75 | - | - | - | - | Imide cyclization ratio = 10% | |

[Table 2-2]

| Binder resin (A) | Structural unit of binder resin (A) [mol ratio] | | | | | | Content of specific element in structure of resin | Imide cyclization ratio Benzoxazole cyclization ratio | Structural unit and structure of binder resin (A) |
|---|---|---|---|---|---|---|---|---|---|
| | Polyimide unit | Polyimide precursor unit | | Polybenzoxazole unit | Polybenzoxazole precursor unit | Polyamideimide unit | | | |
| | | Amic acid structure | Amic acid ester structure | | | | | | |
| Polyimide precursor (PIP-15) | 10 | 30 | 60 | - | 300 | - | - | Imide cyclization ratio = 10% Benzoxazole cyclization ratio = 0% | Unit represented by formula (1), formula (2), and formula (4) (Structural unit having imide structure and amide structure) |
| Polybenzoxazole (PB-1) | - | - | - | 60 | 40 | - | - | Benzoxazole cyclization ratio = 60% | Unit represented by formula (3) and formula (4) (Structural unit having amide structure and oxazole structure) |
| Polybenzoxazole precursor (PBP-1) | - | - | - | - | 100 | - | - | Benzoxazole cyclization ratio = 0% | Unit represented by formula (4) (Structural unit having amide structure) |
| Polybenzoxazole precursor (PBP-2) | - | - | - | - | 100 | - | Sulfur element = 6.4 mass% | Benzoxazole cyclization ratio = 0% | |
| Polyamideimide (PAI-1) | - | - | - | - | 100 | 100 | - | Imide cyclization ratio = 100% Benzoxazole cyclization ratio = 0% | Unit represented by formula (4) and formula (5) (Structural unit having imide structure and amide structure) |
| Polyimide (PI-3) | 100 | - | - | - | - | - | Fluorine element = 13.8 mass% | Imide cyclization ratio = 100% | Unit represented by formula (1) (Structural unit having imide structure) |
| Polyimide precursor (PIP-16) | 10 | 30 | 60 | - | 100 | - | Fluorine element = 22.7 mass% | Imide cyclization ratio = 10% Benzoxazole cyclization ratio = 0% | Unit represented by formula (1), formula (2), and formula (4) (Structural unit having imide structure and amide structure) |
| Polybenzoxazole precursor (PBP-3) | - | - | - | - | 100 | - | Fluorine element = 18.7 mass% | Benzoxazole cyclization ratio = 0% | Unit represented by formula (4) (Structural unit having amide structure) |

| Binder resin (A) | Structural unit and structure of binder resin (A) |
|---|---|
| Polycyclic side chain-containing resin (CR-1) | Cardo-based resin structure having fluoren structure; Radical polymerizable group: methacryloyl group (methacrylic acid residue) |
| Acid-modified epoxy resin (AE-1) | Epoxy methacrylate resin structure having biphenyl structure; Radical polymerizable group: methacryloyl group (methacrylic acid residue) |
| Acrylic resin (AC-1) | Acrylic resin structure; Radical polymerizable group: methacryloyl group (glycidyl methacrylate residue) |
| Phenolic resin (PR-1) | Phenolic resin structure |
| Polyhydroxystyrene (PHS-1) | Polyhydroxystyrene structure |

[Table 2-3]

| Binder resin (A) | Structural unit of binder resin (A) [mol ratio] | | | | | | Content of specific element in structure of resin | Imide cyclization ratio Benzoxazole cyclization ratio | Structural unit and structure of binder resin (A) |
|---|---|---|---|---|---|---|---|---|---|
| | Polyimide unit | Polyimide precursor unit | | Polybenzoxazole unit | Polybenzoxazole precursor unit | Polyamideimide unit | | | |
| | | Amic acid structure | Amic acid ester structure | | | | | | |
| Polyimide (PI-4) | 100 | - | - | - | - | - | - | Imide cyclization ratio = 100% | Unit represented by formula (1) (Structural unit having imide structure) |
| Polyimide (PI-5) | 100 | - | - | - | - | - | - | Imide cyclization ratio = 100% | |
| Polyimide precursor (PIP-17) | 10 | 30 | 60 | - | - | - | - | Imide cyclization ratio = 10% | Unit represented by formula (1) and formula (2) (Structural unit having imide structure and amide structure) |
| Polyimide precursor (PIP-18) | 10 | 30 | 60 | - | - | - | - | Imide cyclization ratio = 10% | |
| Polyimide precursor (PIP-19) | 10 | 30 | 60 | - | - | - | - | Imide cyclization ratio = 10% | |
| Polyimide precursor (PIP-20) | 10 | 30 | 60 | - | - | - | - | Imide cyclization ratio = 10% | |
| Polyimide precursor (PIP-21) | 10 | 30 | 60 | - | - | - | - | Imide cyclization ratio = 10% | |
| Polyimide precursor (PIP-22) | 10 | 30 | 60 | - | - | - | - | Imide cyclization ratio = 10% | |
| Polyimide precursor (PIP-23) | 10 | 30 | 60 | - | - | - | - | Imide cyclization ratio = 10% | |
| Polyimide precursor (PIP-24) | 10 | 30 | 60 | - | - | - | - | Imide cyclization ratio = 10% | |
| Polyimide precursor (PIP-25) | 10 | 30 | 60 | - | - | - | - | Imide cyclization ratio = 10% | |
| Polyimide precursor (PIP-26) | 10 | 30 | 60 | - | - | - | - | Imide cyclization ratio = 10% | |
| Polyimide precursor (PIP-27) | 10 | 30 | 60 | - | 100 | - | - | Imide cyclization ratio = 10% Benzoxazole cyclization ratio = 0% | Unit represented by formula (1), formula (2), and formula (4) (Structural unit having imide structure and amide structure) |
| Polyimide precursor (PIP-28) | 10 | 30 | 60 | - | 100 | - | - | Imide cyclization ratio = 10% Benzoxazole cyclization ratio = 0% | |
| Polyimide precursor (PIP-29) | 10 | 30 | 60 | - | 100 | - | - | Imide cyclization ratio = 10% Benzoxazole cyclization ratio = 0% | |
| Polyimide precursor (PIP-30) | 10 | 30 | 60 | - | 100 | - | - | Imide cyclization ratio = 10% Benzoxazole cyclization ratio = 0% | |

[Table 2-4]

| Binder resin (A) | Structural unit of binder resin (A) [mol ratio] | | | | | | Content of specific element in structure of resin | Imide cyclization ratio Benzoxazole cyclization ratio | Structural unit and structure of binder resin (A) |
|---|---|---|---|---|---|---|---|---|---|
| | Polyimide unit | Polyimide precursor unit | | Polybenzoxazole unit | Polybenzoxazole precursor unit | Polyamideimide unit | | | |
| | | Amic acid structure | Amic acid ester structure | | | | | | |
| Polyimide precursor (PIP-31) | 10 | 30 | 60 | - | - | - | - | Imide cyclization ratio = 10% | Unit represented by formula (1) and formula (2) (Structural unit having imide structure and amide structure) |
| Polyimide precursor (PIP-32) | 20 | 20 | 60 | - | - | - | Sulfur element = 1.0 mass% | Imide cyclization ratio = 20% | |
| Polyimide precursor (PIP-33) | 10 | 30 | 60 | - | - | - | - | Imide cyclization ratio = 10% | |
| Polyimide precursor (PIP-34) | 10 | 30 | 60 | - | - | - | - | Imide cyclization ratio = 10% | |
| Polyimide precursor (PIP-35) | 20 | 20 | 60 | - | - | - | Sulfur element = 1.0 mass% | Imide cyclization ratio = 20% | |
| Polyimide precursor (PIP-36) | 10 | 30 | 60 | - | - | - | - | Imide cyclization ratio = 10% | |
| Polyimide precursor (PIP-37) | 10 | 30 | 60 | - | - | - | - | Imide cyclization ratio = 10% | |
| Polyimide precursor (PIP-38) | 10 | 30 | 60 | - | - | - | - | Imide cyclization ratio = 10% | |
| Polyimide precursor (PIP-39) | 10 | 30 | 60 | - | - | - | - | Imide cyclization ratio = 10% | |
| Polyimide precursor (PIP-40) | 10 | 30 | 60 | - | - | - | - | Imide cyclization ratio = 10% | |
| Polyimide precursor (PIP-41) | 20 | 20 | 60 | - | - | - | Sulfur element = 1.1 mass% | Imide cyclization ratio = 20% | |
| Polybenzoxazole (PB-2) | - | - | - | 60 | 40 | - | - | Benzoxazole cyclization ratio = 60% | Unit represented by formula (3) and formula (4) (Structural unit having amide structure and oxazole structure) |
| Polybenzoxazole precursor (PBP-4) | - | - | - | - | 100 | - | - | Benzoxazole cyclization ratio = 0% | Unit represented by formula (4) (Structural unit having amide structure) |
| Polybenzoxazole precursor (PBP-5) | - | - | - | - | 100 | - | - | Benzoxazole cyclization ratio = 0% | |
| Polybenzoxazole precursor (PBP-6) | - | - | - | - | 100 | - | - | Benzoxazole cyclization ratio = 0% | |
| Polybenzoxazole precursor (PBP-7) | - | - | - | - | 100 | - | - | Benzoxazole cyclization ratio = 0% | |
| Polyamideimide (PAI-2) | - | - | - | - | 100 | 100 | - | Imide cyclization ratio = 100% Benzoxazole cyclization ratio = 0% | Unit represented by formula (4) and formula (5) (Structural unit having imide structure and amide structure) |

<Preparation Examples of Pigment Dispersion Liquids>

As a pigment dispersion liquid, the compositions of the dispersion liquids obtained in Preparation Examples Bk-1 to Bk-5 are collectively shown in Table 2-5. In Preparation Examples Bk-1 to Bk-5, each pigment dispersion liquid was prepared by the following method. A list and description of the colorant (D) and the dispersant (E) used in each of Examples, Reference Examples, and Comparative Examples are collectively shown in Table 2-5.

Preparation Examples Bk-1 to Bk-5 Preparation of pigment dispersion liquids (Bk-1) to (Bk-5)

On the basis of the method described in paragraphs [0138] to [0140] of WO 2022/196261 A and Preparation Example 1, a wet media dispersion treatment was performed by a circulation method using a colorant described in Table 2-5 and ADP which is a polyalkylene amine-based/polyoxyalkylene ether-based dispersant as a dispersant such that the average primary particle size of the pigment was the value described in Table 2-5. Thereafter, filtration was performed with a filter of 0.80 μmφ to obtain pigment dispersion liquids (Bk-1) to (Bk-5) having a solid content concentration of 15 mass% and colorant/dispersant = 100/35 (mass ratio). The average primary particle size of the pigment in the obtained pigment dispersion liquid is shown in Table 2-5. In addition, the average primary particle size of the pigment in the film of the cured product (hereinafter, "cured film") produced by the method described in Examples, the crystallite size of the pigment in the pigment dispersion liquid, and the crystallite size of the pigment in the cured film are also shown in Table 2-5.

[Table 2-5]

| | Pigment dispersion liquid | Composition [parts by mass] | | Solvent | Average primary particle size in pigment dispersion liquid [nm] | Average primary particle size of pigment in cured film [nm] | Crystallite size in pigment dispersion liquid [nm] | Crystallite size of pigment in cured film [nm] |
|---|---|---|---|---|---|---|---|---|
| | | Colorant (D) | Dispersant (E) | | | | | |
| Preparation Example Bk-1 | Pigment dispersion liquid (Bk-1) | Bk-S0100CF (100) | ADP (35) | PGMEA | 80 | 60 | - | - |
| Preparation Example Bk-2 | Pigment dispersion liquid (Bk-2) | Bk-FK4280 (100) | | | 100 | 80 | - | - |
| Preparation Example Bk-3 | Pigment dispersion liquid (Bk-3) | Bk-CBF1 (100) | | | 60 | 60 | - | - |
| Preparation Example Bk-4 | Pigment dispersion liquid (Bk-4) | Bk-CPR1 (100) | | | 80 | 80 | - | - |
| Preparation Example Bk-5 | Pigment dispersion liquid (Bk-5) | Bk-ZrN (100) | | | - | - | 15 | 15 |

| Colorant (D) Dispersant (E) | Description of colorant (D) and description of dispersant (E) |
|---|---|
| Bk-S0100CF | Mixture of compounds having two benzofuran-2-(3H)-one structures or two benzofuran-3(2H)-one structures; "IRGAPHOR" (registered trademark) BLACK S0100CF (manufactured by BASF; benzofuranone-based black pigment having primary particle diameter of 40 to 80 nm) |
| Bk-FK4280 | Compound having 3,4,9,10-perylene tetracarboxylic acid bisbenzimidazole structure; "LUMOGEN" (registered trademark) BLACK FK4280 (manufactured by BASF; perylene-based black pigment having primary particle size of 50 to 100 nm) |
| Bk-CBF1 | Benzofuranone-based black pigment having coating layer (average coverage ratio with respect to pigment: 97.5%); silica coating layer: silica (10.0 parts by mass in terms of $SiO_2$ with respect to 100 parts by mass of pigment); metal oxide coating layer: alumina (2.0 parts by mass in terms of $Al_2O_3$ with respect to 100 parts by mass of pigment); benzofuranone-based black pigment having coating layer described in paragraphs [0503] to [0505] of WO 2019/087985 A and Coating Example 1 |
| Bk-CPR1 | Perylene-based black pigment having coating layer (average coverage ratio with respect to pigment: 84.5%) Silica coating layer: silica + silica (3.0+7.0 parts by mass in terms of SiO2 with respect to 100 parts by mass of pigment * two layers of silica coating layer) Perylene-based black pigment having coating layer obtained by synthesis method described in paragraphs [0186] to [0188] and paragraph [0191] of WO 2018/038083 and Example 18 |
| Bk-ZrN | Composite fine particles composed of zirconium nitride particles and aluminum particles produced by thermal plasma method (manufactured by Nisshin Engineering Inc.; crystallite size = 30 nm, Al element content = 4 wt%) |
| ADP | Polyalkylene amine-based-polyoxyalkylene ether-based dispersant having tertiary amino group (amine value: 20 mgKOH/g (solid content concentration: 100 mass%)) Pigment dispersant 1 described in paragraphs [0138] to [0141] of JP 2020-070352 A and Synthesis Example 2 |
| A.R.52 | C.I. Acid Red 52 (xanthene-based red dye) |
| B.B.7 | C.I. Basic Blue 7 (triarylmethane-based blue dye) |
| A.R.52-B.B.7 | A.R.52/B.B.7 = dye obtained by mixing and stirring at 1/1 (mol ratio), filtering precipitated salt, washing with water three times, and then drying |
| S.R.18 | C.I. Solvent Red 18 (azo-based red dye) |
| D.Y.201 | C.I. Disperse Yellow 201 (methine-based yellow dye) |

<Synthesis Example of Silica Particle Dispersion Liquid>

Synthesis Example 30 Synthesis of silica particle (SP-1) dispersion liquid

On the basis of the method described in paragraph [0132] to paragraph [0134] of WO 2022/196261 A and Synthesis Example 3, a dispersion liquid of silica particles (SP-1) was obtained using MEK-ST-40 as a silica particle dispersion liquid, KBM-503 as a surface modifier, and MOP as a polymerization inhibitor. In the silica particles (SP-1) as inorganic particles, the functional group on the particle surface is a methacryloyl group, the distribution range of the primary particle size is 10 to 16 nm, the average primary particle size is 12 nm, the range of the aspect ratio is 1.0 to 1.1, the average aspect ratio is 1.1, and the content of the sodium element is 100 ppm by mass.

<Evaluation Methods in Examples, Reference Examples, and Comparative Examples>

Evaluation methods in Examples, Reference Examples, and Comparative Examples are shown below. A glass substrate (manufactured by Geomatec Co., Ltd.; hereinafter, "ITO/Ag substrate") obtained by forming a film of APC (silver/palladium/copper = 98.07/0.87/1.06 (mass ratio)) of 100 nm on glass by sputtering and further forming a film of ITO of 10 nm on an upper layer of the APC layer by sputtering was used after UV-$O_3$ cleaning treatment was performed for 100

seconds using a desktop optical surface treatment apparatus (PL16-110; manufactured by Sen Lights Corporation). A Tempax glass substrate (manufactured by AGC Techno Glass Co., Ltd.) was used without being pretreated. The other substrate was heated at 130°C for 2 minutes using a hot plate (HP-1SA; manufactured by As One Corporation) to perform a dehydration bake treatment, and then used. In film thickness measurement, with the use of a surface roughness and contour shape measuring instrument (SURFCOM 1400D; manufactured by Tokyo Seimitsu Co., Ltd.), under the conditions of the measurement magnification of 10,000 times, the measurement length of 1.0 mm, and the measurement speed of 0.30 mm/s, the film thickness was measured.

(1) Weight Average Molecular Weight of Resin

In the measurement of the weight average molecular weights of the polyimide (PI-1) to (PI-3), the polyimide precursors (PIP-1) to (PIP-16), the polybenzoxazole (PB-1), the polybenzoxazole precursors (PBP-1) to (PBP-3), and the polyamideimide (PAI-1), an N-methyl-2-pyrrolidone solution of 0.10 mass% of each resin was prepared and used as a measurement sample. A gel permeation chromatography (hereinafter, "GPC") analyzer (Waters 2690; manufactured by Waters Corporation) was used, N-methyl-2-pyrrolidone in which lithium chloride and phosphoric acid were each dissolved at 0.050 mol/L was used as a mobile phase, and the weight average molecular weight in terms of polystyrene was measured and determined. For other resins, a GPC analyzer (HLC-8220; manufactured by Tosoh Corporation) was used, tetrahydrofuran or N-methyl-2-pyrrolidone was used as a mobile phase, and the weight average molecular weight in terms of polystyrene was measured and determined by a method near normal temperature according to "JIS K7252-3 (2008)".

(2) Imide Cyclization Ratio and Benzoxazole Cyclization Ratio of Resin

Regarding the imide cyclization ratio, each of the above resins was dissolved in GBL so as to have a concentration of 35 mass% to prepare a resin solution. Each of the obtained resin solutions was placed on a silicon wafer with a spin coater (1H-DX; manufactured by Mikasa Co., Ltd.) and then baked at 120°C for 180 seconds to prepare a resin film having a film thickness of 4 to 5 μm. The produced silicon wafer with a resin film was divided into two parts, and one part was placed in a clean oven (CLH-21CD-S; manufactured by Koyo Thermo Systems Co., Ltd.) and heated at 140°C for 30 minutes in a nitrogen atmosphere with an oxygen concentration of 20 ppm by mass or less, and then the temperature was further raised and the one part was heated at 320°C for 60 minutes to completely cyclize to the imide ring (resin film after heating). The other was used as it was without heat treatment (resin film before heating). The transmitted infrared absorption spectrum of the resin film before and after heating was measured using an infrared spectrophotometer (FT-720; manufactured by Horiba, Ltd.). The presence of an absorption peak (near 1,780 $cm^{-1}$, near 1,377 $cm^{-1}$) of the imide structure due to the polyimide was confirmed, and a peak intensity (X) around 1,377 $cm^{-1}$ before heating and a peak intensity (Y) around 1,377 $cm^{-1}$ after heating were determined. The imide cyclization ratio in the resin film before heating was calculated from the following formula.

$$\text{Imide cyclization ratio [\%]} = (X/Y) \times 100.$$

Regarding the benzoxazole cyclization ratio, a resin film having a film thickness of 4 to 5 μm was prepared by the same method as described above. The produced silicon wafer with a resin film was divided into two parts, and one part was heated at 320°C for 30 minutes using a buzzer hot plate (HPD-3000BZN; manufactured by As One Corporation) to completely cyclize to the benzoxazole ring (resin film after heating). The other was used as it was without heat treatment (resin film before heating). The transmitted infrared absorption spectrum of the resin film before and after heating was measured using an infrared spectrophotometer (FT-720; manufactured by Horiba, Ltd.). The presence of an absorption peak of a benzoxazole structure derived from polybenzoxazole (a peak derived from C = C (C = N) stretching vibration around 1,570 $cm^{-1}$) was confirmed, and the peak intensity (P) around 1,570 $cm^{-1}$ before heating and the peak intensity (Q) around 1,570 $cm^{-1}$ after heating were determined. The benzoxazole cyclization ratio in the resin film before heating was calculated from the following formula.

$$\text{Benzoxazole cyclization ratio [\%]} = (P/Q) \times 100.$$

(3) Mol Ratio of Polyimide Unit or the Like

Each of the above resins was used after being separated by GPC fractionation. When the resin was composed of resins having a structure in which structural units constituting the resin are different, the resins were separated by GPC fractionation and then used. The resin in the composition was used after the composition was subjected to dichloromethane extraction, ultracentrifugation, and separation of each resin from dichloromethane insolubles by GPC

fractionation in any case where the composition included a single resin or a resin having a structure in which structural units constituting the resin are different. Each resin was analyzed by methods such as proton nuclear magnetic resonance spectroscopy, infrared spectroscopy, pyrolysis gas chromatography mass spectrometry, and reaction pyrolysis gas chromatography mass spectrometry. From the obtained measurement results, the structures of each unit of a polyimide unit (imide structure), a polyimide precursor unit (amic acid structure and amic acid ester structure), a polybenzoxazole unit (benzoxazole structure), a polybenzoxazole precursor unit (hydroxyamide structure), and a polyamideimide unit (imide structure and amide structure), and a copolymerizable monomer constituting them, were determined. Next, each copolymerizable monomer was prepared as a standard sample, and peaks unique to each copolymerizable monomer were confirmed by proton nuclear magnetic resonance spectroscopy. Subsequently, the mol ratio of each unit in the resin and the copolymerizable monomer constituting the units was calculated from an area ratio of the peaks in the proton nuclear magnetic resonance spectroscopy spectrum of each resin.

(4) Content of Specific Compound in Composition or Cured Film

The contents of a specific nitrogen-containing compound, a phenol compound (I) having a specific structure, and a crosslinkable aromatic compound (J) having a specific structure in the composition or the cured film were measured by gas chromatography mass spectrometry and liquid chromatography mass spectrometry using a calibration curve by a standard substance. Note that the content in the total solid content of the composition was calculated from the obtained measured value and the following formula.

(Content of specific compound in total solid content of composition) = (content of specific compound in composition) × 100/(solid content concentration of composition [mass%]).

(5) Content of Specific Element in Resin, Composition, or Cured Film

The contents of fluorine element, chlorine element, bromine element, and sulfur element in the resin, the composition, or the cured film were measured by combustion ion chromatography under the following measurement conditions. The resin and the resin in the composition were used after each resin was separated by GPC fractionation or dichloromethane extraction, ultracentrifugation, and GPC fractionation by the method described in the above (3). A resin, a composition, or a cured film was combusted and decomposed in a combustion tube of an analyzer, the generated gas was absorbed into an absorption liquid, and a part of the absorption liquid was analyzed by ion chromatography. When the element content is not described, it indicates that the element is not detected. Note that the content in the total solid content of the composition was calculated from the obtained measured value and the following formula.

(Content of specific element in total solid content of composition) = (content of specific element in composition) × 100/(solid content concentration of composition [mass%])

<Combustion/Absorption Conditions>

System: AQF-2100H, GA-210 (manufactured by Mitsubishi Chemical Corporation)
Electric furnace temperature: Inlet 900°C, Outlet 1000°C
Gas: $Ar/O_2$ 200 mL/min, $O_2$ 400 mL/min
Absorption liquid: $H_2O_2$ 0.1 mass%
Absorption liquid amount: 5 mL
<Ion Chromatography/Anion Analysis Conditions>
System: ICS1600 (manufactured by Dionex Corporation)
Mobile phase: 2.7 mmol/L $Na_2CO_3$, 0.3 mmol/L $NaHCO_3$
Flow rate: 1.50 mL/min
Detector: Electrical conductivity detector
Injection amount: 100 μL.

(6) Content of Specific Anion in Resin, Composition, or Cured Film

The contents of fluoride ions, chloride ions, bromide ions, and sulfur-based anions in the resin, the composition, or the cured film were measured by ion chromatography under the following measurement conditions. The resin and the resin in the composition were used after each resin was separated by GPC fractionation or dichloromethane extraction,

ultracentrifugation, and GPC fractionation by the method described in the above (3). A resin, a composition, or a cured film was added to ultrapure water and shaken at room temperature to extract an ionic component. The extract was treated with a solid phase extraction cartridge, and then anion components were analyzed by ion chromatography. When the anion component could not be measured under the following ion chromatography analysis condition 1, the anion component was measured under the following ion chromatography analysis condition 2. When the ion content is not described, it indicates that the ion is not detected. Note that the content in the total solid content of the composition was calculated from the obtained measured value and the following formula.

(Content of specific anion in total solid content of composition) = (Content of specific anion in composition) × 100/(Solid content concentration of composition [mass%])

<Ion Chromatography Analysis Condition 1 (Anion Component)>

Apparatus: IC-2010 (manufactured by Tosoh Corporation)
Separation column: 4.6 mmφ × 100 mm, TSKgel Super IC-Anion HS
Eluent: Sodium hydrogen carbonate
Column temperature: 40°C
Detector: Electrical conductivity meter
Sample injection amount: 250 μL

<Ion Chromatography Analysis Condition 2 (Anion Component)>

Apparatus: IC-2010 (manufactured by Tosoh Corporation)
Separation column: 4.6 mmφ × 100 mm, TSKgel Super IC-Anion HS
Eluent: Sodium carbonate/sodium hydrogen carbonate
Column temperature: 40°C
Detector: Electrical conductivity meter
Sample injection amount: 250 μL.

(7) Water Content in Composition

The water content in the composition was measured by volumetric titration using a Karl Fischer moisture meter (MKS-520; manufactured by Kyoto Electronics Manufacturing Co., Ltd.) and a Karl Fischer reagent as a titration reagent according to "JIS K0113 (2005)".

(8) Development Residue

An FPD/LSI inspection microscope (OPTIPHOT-300; manufactured by Nikon Corporation) was used to observe the resolution pattern of the developed film prepared in each Example. As an index of development residues, the presence or absence of residues in a 20 μm line and space pattern was observed, and the presence area of residues in the opening was calculated. It was determined as follows, and A+, A, B+, B, C+, and C in which the presence area of the residue was 20% or less were regarded as acceptable.

A+: No residue
A: The residue existing area is 3% or less.
B+: The residue existing area is more than 3% and 6% or less.
B: The residue existing area is more than 6% and 10% or less.
C+: The residue existing area is more than 10% and 15% or less.
C: The residue existing area is more than 15% and 20% or less.
D: The residue existing area is more than 20% and 50% or less.
E: The residue existing area is more than 50% and 100% or less.

(9) Light-Shielding Property (Optical Density Value (hereinafter, "OD Value"))

A cured film of the composition was prepared on a Tempax glass substrate (manufactured by AGC Techno Glass Co., Ltd.) by the method described in Example 1 below. The incident light intensity ($I_0$) and the transmitted light intensity (I) at three points in the plane of the prepared cured film were measured using a transmission densitometer (X-Rite 361T (V); manufactured by X-Rite, Incorporated).

As an index of the light-shielding property, the OD value per film thickness of 1 μm was calculated by the following formula, and the average value of the OD values at three points in the plane was calculated.

$$\text{OD value} = \log_{10} (I_0/I).$$

(10) Light Emission Characteristics of Light Emitting Element (Low Voltage Driving Characteristics/Luminance)

The voltage value of the organic EL display produced by the method described in Example 1 below was sequentially changed from the low voltage side, and light was emitted by DC driving until the current density reached 30 mA/cm$^2$. The voltage value and the current density when the voltage value was sequentially changed from the low voltage side were plotted, and the driving voltage at which the current density was 10 mA/cm$^2$ was obtained as an index of the low voltage driving characteristic and the luminance. It was determined as follows, and A+, A, B+, B, C+, and C in which the driving voltage was 4.5 V or less were regarded as acceptable.

A+: The driving voltage is 3.2 V or less.
A: The driving voltage is more than 3.2 V and 3.5 V or less.
B+: The driving voltage is more than 3.5 V and 3.7 V or less.
B: The driving voltage is more than 3.7 V and 4.0 V or less.
C+: The driving voltage is more than 4.0 V and 4.2 V or less.
C: The driving voltage is more than 4.2 V and 4.5 V or less.
D: The driving voltage is more than 4.5 V and 5.5 V or less.
E: The driving voltage exceeds 5.5 V or cannot be measured.

(11) Reliability of Light Emitting Element

The organic EL display produced by the method described in Example 1 below was caused to emit light at 10 mA/cm$^2$ by DC driving, and whether there was a light emission defect such as a non-light emitting area or luminance unevenness was observed. In addition, as a durability test, the light emitting element was heated to 80°C with the light extraction side facing upward, irradiated with light having a wavelength of 365 nm and an illuminance of 0.6 mW/cm$^2$, and held for 500 hours. After 500 hours, the organic EL display was caused to emit light at 10 mA/cm$^2$ by DC driving, and whether there was a change in the light emission characteristics was observed. As an index of the reliability of the light emitting element, the light emitting area after the durability test when the light emitting area before the durability test was set to 100% was measured. It was determined as follows, and A+, A, B+, B, C+, and C in which the light emitting area was 80% or more were regarded as acceptable.

A+: The light emitting area is 100%.
A: The light emitting area is 97% or more and less than 100%.
B+: The light emitting area is 94% or more and less than 97%.
B: The light emitting area is 90% or more and less than 94%.
C+: The light emitting area is 85% or more and less than 90%.
C: The light emitting area is 80% or more and less than 85%.
D: The light emitting area is 60% or more and less than 80%.
E: The light emitting area is less than 60%.

(12) Migration Resistance (Insulation Reliability)

A cured film of a composition having a film thickness of about 1.5 μm was prepared on a migration evaluation substrate (WALTS-TEG ME0102JY; Walts Co., Ltd.) in the same manner as the method for preparing a cured film described in Example 1 below. Next, in the line and space pattern of the copper wiring of the comb teeth, the lead wire was soldered to the portion of the measurement terminal having the line of 15 μm and the space of 10 μm to produce an evaluation element. The prepared evaluation element was evaluated for insulation reliability under high temperature and

high humidity using an insulation degradation characteristic evaluation system (ETAC SIR13; manufactured by Kusumoto Chemicals, Ltd.). The evaluation element was placed in a high temperature and high humidity chamber in which the test conditions were set to a temperature of 85°C and a humidity of 85% RH, a voltage of 5.0 V was applied, and the change over time of the resistance value was measured at intervals of 5 minutes. When the resistance value reached $1.0 \times 10^6\ \Omega$ or less, insulation failure was determined, and the test time at that time was measured as an index of migration resistance. It was determined as follows, and A+, A, B+, B, C+, and C with a test time of 200 hours or more were regarded as acceptable.

A+: The test time is 1,000 hours or more.
A: The test time is 800 hours or more and less than 1,000 hours.
B+: The test time is 600 hours or more and less than 800 hours.
B: The test time is 400 hours or more and less than 600 hours.
C+: The test time is 300 hours or more and less than 400 hours.
C: The test time is 200 hours or more and less than 300 hours.
D: The test time is 50 hours or more and less than 200 hours.
E: The test time is less than 50 hours or unmeasurable.

<Compounds Used in Examples, Reference Examples, and Comparative Examples>

The structures of the compounds used in Examples, Reference Examples, and Comparative Examples are shown below. These compounds were synthesized by a known method. (p-1) is a dissolution promoter. (i-1) to (i-5) are phenol compounds (I) having a specific structure. (j-1) and (j-2) are crosslinkable aromatic compounds (J) having a specific structure.

[Chemical Formula 19]

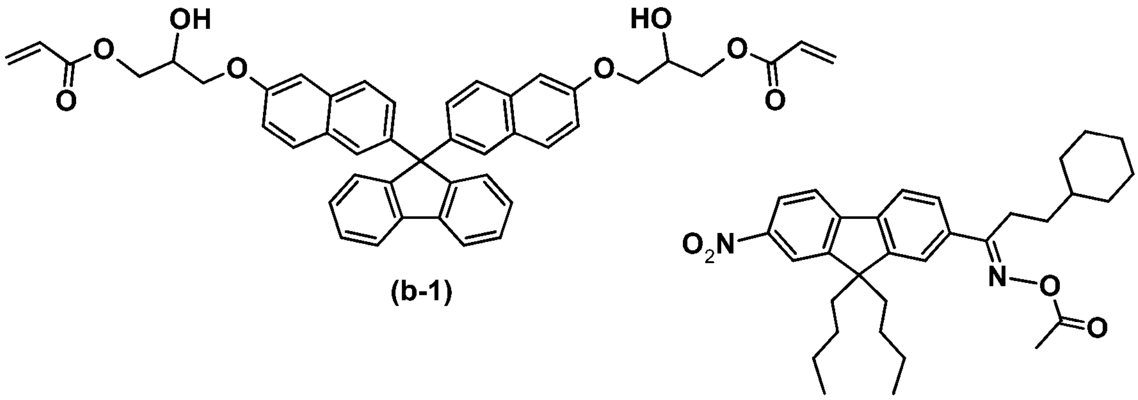

(b-1)

(c-1)

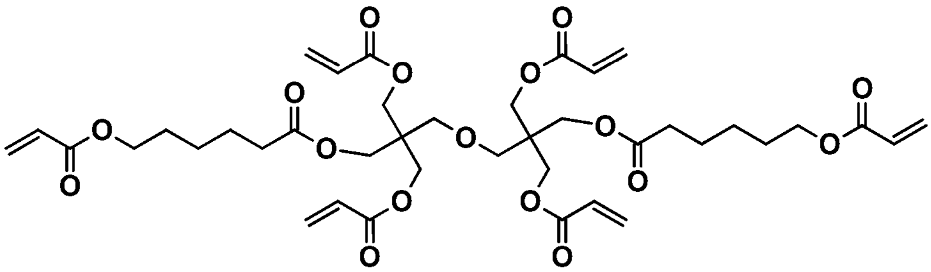

(b-2)

[Chemical Formula 20]

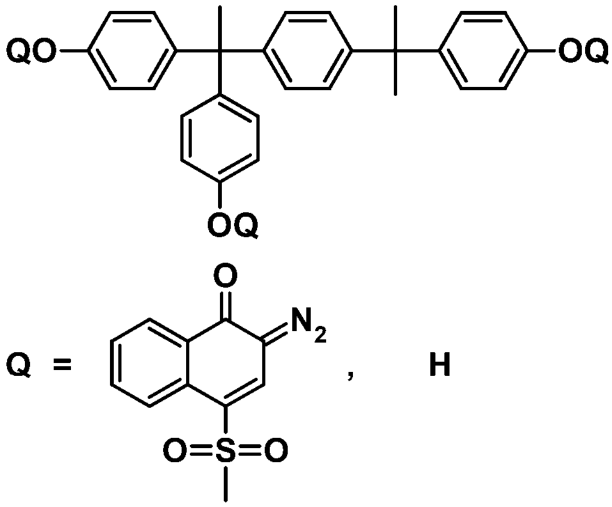

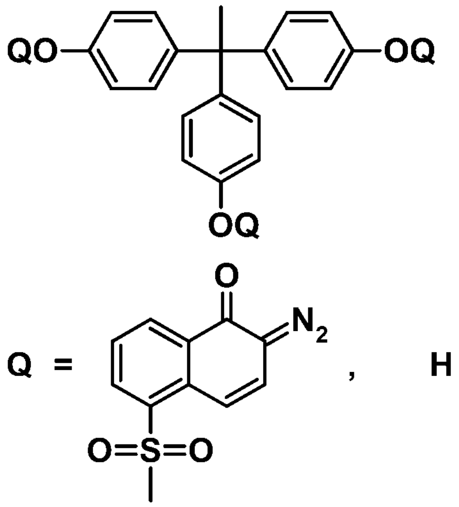

2.3 : 0.7

(NQD-1)

1.7 : 1.3

(NQD-2)

[Chemical Formula 21]

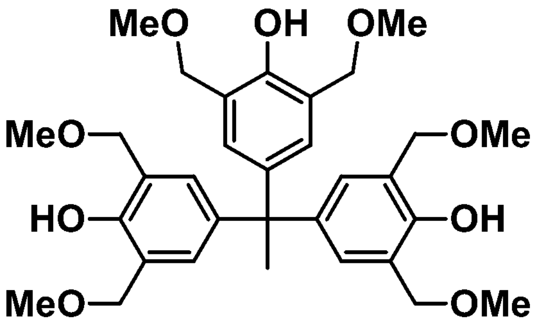

(f-1)

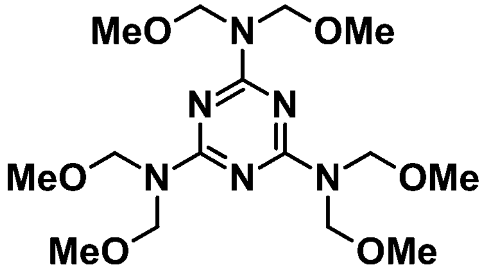

(f-2)

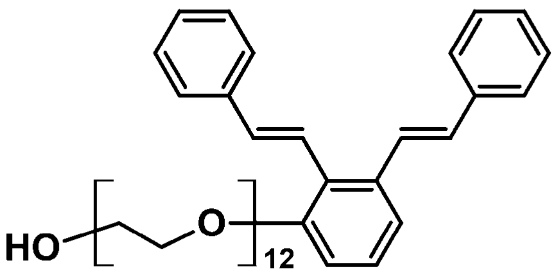

(p-1)

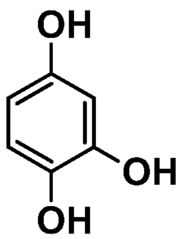

(dt-1)

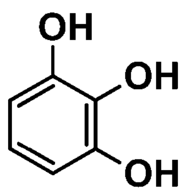

(dt-2)

[Chemical Formula 22]

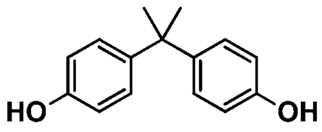
(i-1)

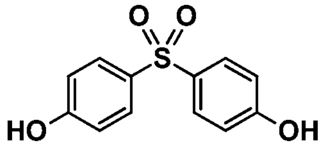
(i-2)

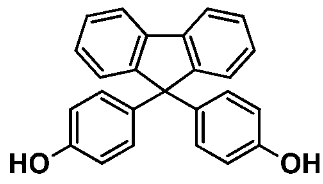
(i-3)

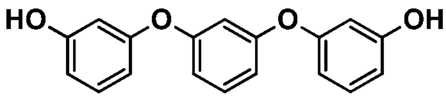
(i-4)

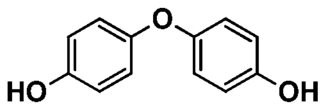
(i-5)

[Chemical Formula 23]

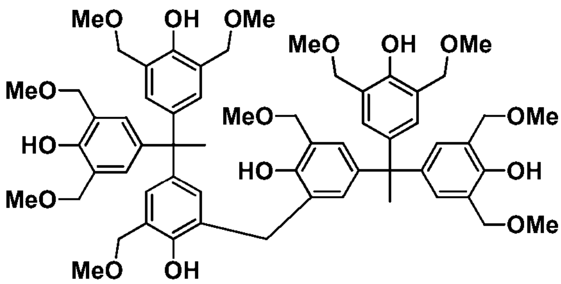
(j-1)

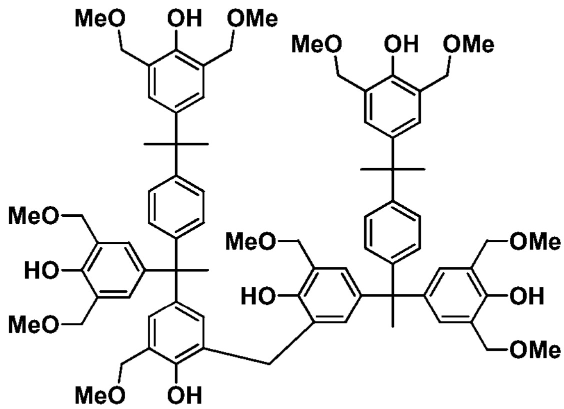
(j-2)

A compound including a fluorine element, a chlorine element, a bromine element, or a sulfur element (hereinafter, "compound including a specific element") used in each of Examples, Reference Examples, and Comparative Examples; the specific nitrogen-containing compounds and the compounds corresponding thereto are collectively shown in Table 2-6.

[Table 2-6]

| Abbreviation | Compound including specific element | Abbreviation | Specific nitrogen-containing compound |
|---|---|---|---|
| Fc-1 | 2,2-bis(4-hydroxyphenyl)hexafluoropropane | Nc-1 | N-methyl-2-pyrrolidone |
| F-I-1 | Ammonium fluoride (decyltriethyl) | Nc-2 | N,N'-dimethylisobutyramide |
| Cl-1 | 2,2-bis(4-hydroxyphenyl) hexachloropropane | Nc-3 | N,N'-dimethyl-3-methoxypropionamide |
| Cl-I-1 | Ammonium chloride (decyltriethyl) | Nc-4 | N,N'-dimethyl-3-butoxypropionamide |
| Br-1 | 2,2-bis(4-hydroxyphenyl) hexabromopropane | Nc-5 | 1,3-dimethyl-2-imidazolidinone |
| Br-I-1 | Ammonium bromide (decyltriethyl) | Nc-6 | 1,1,3,3-tetramethylurea |
| Sc-1 | Ethylene bis(2-mercaptoacetate) | Nc-7 | N-methyl-2-oxazolidone |
| S-I-1 | Bis(decyltriethylammonium) sulfide | Nc-8 | N-methyl-3-isoxazolidone |

<Preparation of Photosensitive Composition>

Compositions 1 to 110 were prepared with the compositions described in Tables 3-1 to 3-10. In Table 3-1 to Table 3-10, the numerical values in parentheses represent parts by mass of the solid content of each component. When the composition contained a pigment, first, a preparation liquid containing no pigment dispersion liquid was prepared, and then the pigment dispersion liquid and the preparation liquid were mixed to prepare a composition. Using PGMEA/EL/GBL = 50/40/10 (mass ratio) as a solvent, the composition was prepared so that the solid content concentration was 20 mass%. The solution of the obtained composition was filtered through a 0.45 μmφ filter and used. Composition 45 to Composition

56 were prepared in the same manner using PGMEA/EDM/MBA = 70/20/10 (mass ratio) as a solvent.

<Example 1>

First, a method for preparing a cured film of a composition will be described. The composition 1 prepared on an ITO/Ag substrate was applied with the use of a spin coater (MS-A100; manufactured by Mikasa Co., Ltd.), and then prebaked at 120°C for 120 seconds with the use of a buzzer hot plate (HPD-3000BZN; manufactured by As One Corporation) to prepare a prebaked film having a film thickness of about 1.8 μm. The prebaked film was subjected to patterning exposure using a double-sided alignment single-sided exposure system (Mask Aligner PEM-6M; manufactured by Union Optical Co., Ltd.) with i-line (wavelength 365 nm), h-line (wavelength 405 nm), and g-line (wavelength 436 nm) from an ultra-high pressure mercury lamp through a grayscale mask for sensitivity measurement (MDRM MODEL 4000-5-FS; manufactured by Opto-Line International). After the exposure, the film was subjected to development with a 2.38 mass% TMAH aqueous solution with the use of a small-size development device for photolithography (AD-1200; manufactured by Takizawa Sangyo K.K.), and rinsed with water for 30 seconds to prepare a developed film. The development time was 60 seconds, 90 seconds, or 120 seconds. When a pattern could not be formed after development with a 2.38 mass% TMAH aqueous solution, an exposed film was prepared in the same manner as described above, developed with cyclopentanone after exposure, and rinsed with water for 30 seconds to prepare a developed film. The development time was similarly 60 seconds, 90 seconds, or 120 seconds. The developed pattern was observed for all the films, and the optimum exposure dose (i-ray illuminometer value) at which a space pattern corresponding to an opening could be formed with a dimension width of 20 μm in a 20 μm line and space pattern was determined. From these results, the optimum development time and the optimum exposure dose at the development time were determined. After the exposure with the optimum exposure dose, the pattern after development with the optimum development time was processed in a high-temperature inert gas oven (INH-9CD-S; Koyo Thermo Systems Co., Ltd.) at 200°C for 60 minutes to prepare a thermally cured film having a film thickness of about 1.2 μm. As thermal curing conditions, the temperature was raised to 200°C at a heating rate of 3.5°C/min in a nitrogen atmosphere having an oxygen concentration of 20 ppm by mass or less, heat treatment was performed at 200°C for 60 minutes, and then the temperature was cooled to 50°C.

The cured film was analyzed by methods such as proton nuclear magnetic resonance spectroscopy, infrared spectroscopy, pyrolysis gas chromatography mass spectrometry, reaction pyrolysis gas chromatography mass spectrometry, liquid chromatography mass spectrometry, and time-of-flight secondary ion mass spectrometry, and the structural unit of the resin and the structure of the compound contained in the cured film were analyzed. It was confirmed that the cured film of the composition 1 contained the resin and the compound in the composition 1 and the resin and the compound having a structure derived therefrom, as follows.

(XAlx) resin: Polyimide (unit represented by formula (1)); polyimide precursor (unit represented by formula (2)); polybenzoxazole (unit represented by formula (3)); polybenzoxazole precursor (unit represented by formula (4))
(XA1y) resin: Phenolic resin
(XC1x) compound: Carboxylic acids including an indene structure; carboxylic acid esters including an indene structure; sulfonic acids including an indene structure; and sulfonic acid aryl esters including an indene structure.

<Production of Organic EL Display (Including Pixel Dividing Layer Having Thick Film Portion and Thin Film Portion)>

Next, a method for producing an organic EL display will be described. Fig. 2 illustrates a schematic diagram of the substrate used. First, APC (silver/palladium/copper = 98.07/0.87/1.06 (mass ratio)) as a non-transparent conductive metal layer was formed in a thickness of 100 nm on a 38 × 46 mm alkali-free glass substrate 47 by sputtering, and subjected to pattern processing by etching to form an APC layer. Further, an amorphous ITO film having a thickness of 10 nm was formed as a transparent conductive oxide layer on the APC layer by sputtering, and subjected to pattern processing by etching to form a first electrode unit 48 as a reflective electrode. Further, at this time, an auxiliary electrode unit 49 for taking out the second electrode was also formed at the same time ((1) in Fig. 2). The obtained electrode-equipped substrate was ultrasonically cleaned for 10 minutes using "Semico Clean" (registered trademark) 56 (manufactured by Furuuchi Chemical Corporation), and then washed with ultrapure water. Next, the composition 1 was applied and prebaked on the substrate in the same manner as described above, subjected to patterning exposure, development, and rinsing through a photomask having a predetermined pattern, and then heated and thermally cured. The processing conditions were an optimum exposure dose and an optimum development time measured in advance. The thermal curing conditions were the same as described above. By the above method, a pixel division layer portion 50 was formed only in an effective area of the substrate, in which quadrangular openings having a width of 70 μm and a length of 70 μm were arranged at a pitch of 175 μm in a width direction and a pitch of 175 μm in a length direction, and each opening was shaped to expose the first electrode ((2) in Fig. 2). Note that the opening of the pixel dividing layer portion 50 finally becomes a light-emitting pixel of the organic EL display. Further, the substrate effective area was 16 mm square, and the thickness of the

pixel dividing layer portion 50 was about 1.5 μm. Further, on the substrate on which the pixel dividing layer portion 50 was formed, the composition 1 was applied and prebaked in the same manner as described above, subjected to patterning exposure, development, and rinsing through a photomask having a predetermined pattern, and then heated and thermally cured. The processing conditions were an optimum exposure dose and an optimum development time measured in advance. The thermal curing conditions were the same as described above. By such a method, quadrangular thick film portions having a width of 35 μm and a length of 35 μm were formed at a plurality of locations not adjacent to the opening on the pixel dividing layer portion 50. The thick film portion was formed to have a thickness of about 1.5 μm.

Next, an organic EL display was produced using the substrate on which the first electrode unit 48, the auxiliary electrode unit 49, and the pixel dividing layer portion 50 were formed. A nitrogen plasma treatment was performed as a pretreatment, and then an organic EL layer portion 51 including a light emitting layer was formed by a vacuum evaporation method ((3) in Fig. 2). The vacuum degree at the time of vapor deposition was $1 \times 10^{-3}$ Pa or less, and the substrate was rotated with respect to the evaporation source during evaporation. First, a compound (HT-1) was deposited as a hole injection layer in a thickness of 10 nm, and a compound (HT-2) was deposited as a hole transport layer in a thickness of 50 nm. Next, a compound (GH-1) as a host material and a compound (GD-1) as a dopant material were deposited on the light emitting layer in a thickness of 40 nm so as to have a doping concentration of 10 vol%. Thereafter, a compound (ET-1) and a compound (LiQ) as electron transport materials were laminated at a volume ratio of 1 : 1 in a thickness of 40 nm. As the compound (Compounds (HT-1), (HT-2), (GH-1), (GD-1), (ET-1), and (LiQ)) used in the organic EL layer, the same compounds as those described in paragraphs [0599] to [0600] of WO 2017/057281 were used. Next, a compound (LiQ) was deposited to a thickness of 2 nm, and then MgAg (magnesium/silver =10/1 (volume ratio)) was deposited to a thickness of 10 nm to form a second electrode portion 52 as a transparent electrode ((4) in Fig. 2). Thereafter, sealing was performed by bonding a cap-shaped glass plate using an epoxy resin adhesive under a low humidity nitrogen atmosphere, and four 5-mm-square top emission type organic EL displays were produced on one substrate. The film thickness referred to herein is a quartz crystal film thickness monitor display value.

<Examples 2 to 104 and Comparative Examples 1 to 6>

The same operation and evaluation as in Example 1 were performed using each composition shown in Table 3-1 to Table 3-10. These evaluation results are collectively shown in Table 3-1 to Table 3-10. When a composition having negative-type photosensitivity was used in each Example, a prebaked film was prepared in the same manner as in Example 1, and spray-developed with a 2.38 mass% aqueous TMAH solution or cyclopentanone, and the time for completely dissolving the prebaked film (unexposed portion) (Breaking Point; hereinafter, "BP") was measured, and the development time was 1.3 times the measured BP. As a photomask, a photomask in which a light-transmitting portion and a light-shielding portion were reversed was used, and a pattern after exposure at an optimum exposure dose and development was thermally cured at 200°C for 60 minutes. The contents of sulfur element and sulfur-based anions were measured only in Example 45 to Example 56.

[Table 3-1]

| | Composition | Composition (parts by mass) | | | | | Composition of cured film | | | Photosensitive characteristics / cured film characteristics / light emission characteristics | | | |
|---|---|---|---|---|---|---|---|---|---|---|---|---|---|
| | | Resin (A) Photosensitive agent (C) Crosslinking agent (F) Dissolution promoter | Compound including specific element | Content in total solid content of composition | | Content in composition | Specific compound in cured film | Content in cured film | | Development residue | Low voltage driving characteristic | Reliability of light emitting element | Migration resistance |
| | | | | Halogen element Sulfur element | Halogen ion Sulfur ion | | | Halogen element Sulfur element | Halogen ion Sulfur ion | | | | |
| Example 1 | 1 | PIP-1 (45) PBP-1 (30) PR-1 (25) NQD-1 (20) NQD-2 (10) f-1 (5) f-2 (5) p-1 (5) | Fc-1 | Fluorine element (3 ppm by mass) | - | Water (1.0 mass%) | Fc-1 | Fluorine element (3 ppm by mass) | - | B+ | A | B+ | B+ |
| Example 2 | 2 | | | Fluorine element (0.5 ppm by mass) | - | | | Fluorine element (0.5 ppm by mass) | - | A | A+ | A | A |
| Example 3 | 3 | | | Fluorine element (1 ppm by mass) | - | | | Fluorine element (1 ppm by mass) | - | A | A+ | B+ | B+ |
| Example 4 | 4 | | | Fluorine element (40 ppm by mass) | - | | | Fluorine element (40 ppm by mass) | - | B+ | A | B | B |
| Example 5 | 5 | | F-I-1 | Fluorine element (3 ppm by mass) | Fluoride ion (3 ppm by mass) | | F-I-1 | Fluorine element (3 ppm by mass) | Fluoride ion (3 ppm by mass) | B+ | A+ | B+ | B+ |
| Example 6 | 6 | | Fc-1 Cl-1 | Fluorine element (1 ppm by mass) Chlorine element (1 ppm by mass) | - | | Fc-1 Cl-1 | Fluorine element (1 ppm by mass) Chlorine element (1 ppm by mass) | - | A | A+ | B+ | B+ |
| Example 7 | 7 | | Fc-1 Cl-I-1 | Fluorine element (1 ppm by mass) Chlorine element (1 ppm by mass) | Chloride ion (1 ppm by mass) | | Fc-1 Cl-I-1 | Fluorine element (1 ppm by mass) Chlorine element (1 ppm by mass) | Chloride ion (1 ppm by mass) | A | A+ | A | B+ |
| Example 8 | 8 | | Fc-1 Br-1 | Fluorine element (1 ppm by mass) Bromine element (1 ppm by mass) | - | | Fc-1 Br-1 | Fluorine element (1 ppm by mass) Bromine element (1 ppm by mass) | - | A | A+ | B+ | B+ |
| Example 9 | 9 | | Fc-1 Br-I-1 | Fluorine element (1 ppm by mass) Bromine element (1 ppm by mass) | Bromide ion (1 ppm by mass) | | Fc-1 Br-I-1 | Fluorine element (1 ppm by mass) Bromine element (1 ppm by mass) | Bromide ion (1 ppm by mass) | A | A+ | A | B+ |

[Table 3-2]

| | Composition | Composition (parts by mass) | | | | Composition of cured film | | Photosensitive characteristics / cured film characteristics / light emission characteristics | | | |
|---|---|---|---|---|---|---|---|---|---|---|---|
| | | Resin (A) Photosensitive agent (C) Crosslinking agent (F) Dissolution promoter | Compound including specific element | Content in total solid content of composition | Content in composition | Specific compound in cured film | Content in cured film | Development residue | Low voltage driving characteristic | Reliability of light emitting element | Migration resistance |
| | | | | Halogen element Sulfur element | | | Halogen element Sulfur element | | | | |
| Example 1 | 1 | PIP-1 (45) PBP-1 (30) PR-1 (25) NQD-1 (20) NQD-2 (10) f-1 (5) f-2 (5) p-1 (5) | Fc-1 | Fluorine element (3 ppm by mass) | Water (1.0 mass%) | Fc-1 | Fluorine element (3 ppm by mass) | B+ | A | B+ | B+ |
| Example 10 | 10 | | Cl-1 Br-1 | Chlorine element (1 ppm by mass) Bromine element (1 ppm by mass) | | Cl-1 Br-1 | Chlorine element (1 ppm by mass) Bromine element (1 ppm by mass) | B | B | B | B |
| Example 11 | 11 | | | Chlorine element (0.5 ppm by mass) Bromine element (0.5 ppm by mass) | | | Chlorine element (0.5 ppm by mass) Bromine element (0.5 ppm by mass) | B+ | B+ | B | B |
| Example 12 | 12 | | | Chlorine element (40 ppm by mass) Bromine element (40 ppm by mass) | | | Chlorine element (40 ppm by mass) Bromine element (40 ppm by mass) | B+ | B+ | C+ | C+ |
| Example 13 | 13 | | Fc-1 | Fluorine element (3 ppm by mass) | Water (0.10 mass%) | Fc-1 | Fluorine element (3 ppm by mass) | A | A+ | A | A |
| Example 14 | 14 | | | | Water (0.50 mass%) | | | A | A+ | B+ | B+ |
| Example 15 | 15 | | | | Water (1.5 mass%) | | | B+ | A | B | B |

[Table 3-3]

| | Composition | Composition [parts by mass] | | | | | | Composition of cured film | | Photosensitive characteristics / cured film characteristics / light emission characteristics | | | |
|---|---|---|---|---|---|---|---|---|---|---|---|---|---|
| | | Binder resin (A) | | | Photosensitive agent (C) Crosslinking agent (F) Dissolution promoter Compound including specific element | Content in total solid content of composition | Content in composition | Specific compound in cured film | Content in cured film | Development residue | Low voltage driving characteristic | Reliability of light emitting element | Migration resistance |
| | | Resin (A1x) | | Resin (A1y) Resin (A2x) Resin (A2y) | | | | | Halogen element Sulfur element | | | | |
| Example 1 | 1 | PIP-1 (45) | PBP-1 (30) | PR-1 (25) | NQD-1 (20) NQD-2 (10) f-1 (5) f-2 (5) p-1 (5) Fc-1 | Fluorine element (3 ppm by mass) | Water (1.0 mass%) | Fc-1 | Fluorine element (3 ppm by mass) | B+ | A | B+ | B+ |
| Example 16 | 16 | PI-1 (45) | | | | | | | | B+ | B+ | B+ | B+ |
| Example 17 | 17 | PI-2 (45) | | | | | | | | B+ | B+ | B+ | B+ |
| Example 18 | 18 | PIP-2 (45) | | | | | | | | B+ | A | B+ | B+ |
| Example 19 | 19 | PIP-3 (45) | | | | | | | | B+ | A | B+ | B |
| Example 20 | 20 | PIP-4 (45) | | | | | | | | B+ | A | B+ | B |
| Example 21 | 21 | PIP-5 (45) | | | | | | | | B+ | A | B+ | B |
| Example 22 | 22 | PIP-6 (45) | | | | | | | | B+ | A | B+ | B |
| Example 23 | 23 | PIP-7 (45) | | | | | | | | B+ | A | B+ | B+ |
| Example 24 | 24 | PIP-8 (45) | | | | | | | | B+ | B+ | B+ | B |
| Example 25 | 25 | PIP-9 (45) | | | | | | | | B+ | A | B+ | B |
| Example 26 | 26 | PIP-10 (45) | | | | | | | | B+ | A | B+ | B |
| Example 27 | 27 | PIP-11 (45) | | | | | | | | B+ | A | B+ | B |
| Example 28 | 28 | PIP-12 (45) | | | | | | | | B+ | B+ | B+ | B+ |
| Example 29 | 29 | PIP-13 (45) | | | | | | | | B+ | B+ | B+ | B+ |
| Example 30 | 30 | PIP-14 (45) | | | | | | | | B+ | B+ | B+ | B+ |
| Example 31 | 31 | PIP-15 (45) | | | | | | | | A | A+ | B+ | B+ |
| Example 32 | 32 | PB-1 (45) | | | | | | | | B+ | B+ | B+ | B+ |
| Example 33 | 33 | PIP-1 (45) | PBP-2 (30) | | | | | | | B+ | A | B+ | B+ |
| Example 34 | 34 | PAI-1 (45) | PBP-1 (30) | | | | | | | B+ | B+ | B+ | B+ |
| Example 35 | 35 | PIP-1 (75) | - | | | | | | | B | B+ | B | B |
| Example 36 | 36 | PIP-1 (45) | PBP-1 (30) | PHS-1 (25) | | | | | | B+ | A | B+ | B |
| Example 37 | 37 | | | CR-1 (25) | | | | | | B | B+ | B | B |
| Example 38 | 38 | | | AE-1 (25) | | | | | | B | B+ | B | B |
| Example 39 | 39 | | | AC-1 (25) | | | | | | B | B+ | B | B |
| Example 40 | 40 | PIP-1 (40) | PBP-1 (30) | PR-1 (20) CR-1 (10) | | | | | | A | A+ | B+ | B+ |

[Table 3-4]

| | Composition | Composition [parts by mass] | | | | | | Composition of cured film | | Photosensitive characteristics / cured film characteristics / light emission characteristics | | | | |
|---|---|---|---|---|---|---|---|---|---|---|---|---|---|---|
| | | Resin (A) Photosensitive agent (C) Dissolution promoter Compound including specific element | Crosslinking agent (F) Inorganic particles (G) | Colorant (D) | Thermal colorant | Content in total solid content of composition | Content in composition | Specific compound in cured film | Content in cured film | Development residue | Light-shielding property OD value | Low voltage driving characteristic | Reliability of light emitting element | Migration resistance |
| | | | | | | | | | Halogen element Sulfur element | | | | | |
| Example 1 | 1 | PIP-1 (45) PBP-1 (30) PR-1 (25) NQD-1 (20) NQD-2 (10) p-1 (5) Fc-1 | f-1 (5) f-2 (5) | - | - | Fluorine element (3 ppm by mass) | Water (1.0 mass%) | Fc-1 | Fluorine element (3 ppm by mass) | B+ | - | A | B+ | B+ |
| Example 41 | 41 | | f-1 (5) f-2 (5) SP-1 (20) | - | - | | | | | A | - | A+ | A | A |
| Example 42 | 42 | | f-1 (5) f-2 (5) | A.R.52-B.B.7 (15.0) S.R.18 (6.0) D.Y.201 (9.0) | - | | | | | B | 0.5 | B | A | A |
| Example 43 | 43 | PIP-1 (45) PBP-1 (30) PR-1 (25) NQD-1 (20) NQD-2 (10) Fc-1 | f-1 (5) f-2 (15) | A.R.52-B.B.7 (21.0) S.R.18 (9.0) | dt-1 (15) | | | | | A | 0.9 | A+ | A+ | A |
| Example 44 | 44 | | | | dt-2 (15) | | | | | A | 0.8 | A+ | A | A |

[Table 3-5]

| | Composition | Composition [parts by mass] | | | | | | Composition of cured film | | Photosensitive characteristics / cured film characteristics / light emission characteristics | | | | |
|---|---|---|---|---|---|---|---|---|---|---|---|---|---|---|
| | | Resin (A) Compound (B) Photosensitive agent (C) Crosslinking agent (F) Dissolution promoter Compound including specific element | Pigment dispersion liquid | Colorant (D) derived from pigment dispersion liquid | Dispersant (E) derived from pigment dispersion liquid | Content in total solid content of composition | Content in composition | Specific compound in cured film | Content in cured film<br>Halogen element Sulfur element | Development residue | Light-shielding property OD value | Low voltage driving characteristic | Reliability of light emitting element | Migration resistance |
| Example 45 | 45 | PI-1 (35) PBP-1 (20) PR-1 (10) b-1 (10) b-2 (25) c-1 (10) f-2 (3) p-1 (2) Fc-1 | Bk-1 | Bk-S0100CF (37.0) | ADP (13.0) | Fluorine element (3 ppm by mass) | Water (1.0 mass%) | Fc-1 | Fluorine element (3 ppm by mass) | B | 1.0 | B | A | A |
| Example 46 | 46 | | Bk-2 | Bk-FK4280 (37.0) | | | | | | B | 0.8 | B | A | B+ |
| Example 47 | 47 | | Bk-3 | Bk-CBF1 (37.0) | | | | | | A | 0.9 | A+ | A+ | A |
| Example 48 | 48 | | Bk-4 | Bk-CPR1 (37.0) | | | | | | A | 0.8 | A+ | A | A |
| Example 49 | 49 | | Bk-5 | Bk-ZrN (22.0) | ADP (7.7) | | | | | B+ | 1.0 | B+ | A | B+ |
| Example 50 | 50 | | Bk-3 | Bk-CBF1 (7.0) | ADP (2.4) | | | | | B+ | 0.2 | A | A | B+ |
| Example 51 | 51 | | - | - | - | | | | | B+ | - | A | B+ | B+ |

[Table 3-6]

| | Composition | Composition [parts by mass] | | | | | | Composition of cured film | | | Photosensitive characteristics / cured film characteristics / light emission characteristics | | | |
|---|---|---|---|---|---|---|---|---|---|---|---|---|---|---|
| | | Resin (A) Compound (B) Photosensitive agent (C) Crosslinking agent (F) Dissolution promoter | Compound including specific element | Content in total solid content of composition | | Content in total solid content of composition | Content in composition | Specific compound in cured film | Content in cured film | | Development residue | Low voltage driving characteristic | Reliability of light emitting element | Migration resistance |
| | | | | Halogen element Sulfur element | Halogen ion Sulfur ion | | | | Halogen element Sulfur element | Halogen ion Sulfur ion | | | | |
| Example 51 | 51 | PI-1 (35) PBP-1 (20) PR-1 (10) b-1 (10) b-2 (25) c-1 (10) f-2 (3) p-1 (2) | Fc-1 | Fluorine element (3 ppm by mass) | - | Fluorine element (3 ppm by mass) | Water (1.0 mass%) | Fc-1 | Fluorine element (3 ppm by mass) | - | B+ | A | B+ | B+ |
| Example 52 | 52 | | Fc-1 Sc-1 | Fluorine element (1 ppm by mass) Sulfur element (1 ppm by mass) | - | | | Fc-1 Sc-1 | Fluorine element (1 ppm by mass) Sulfur element (1 ppm by mass) | - | A | A+ | B+ | B+ |
| Example 53 | 53 | | Fc-1 S-I-1 | Fluorine element (1 ppm by mass) Sulfur element (1 ppm by mass) | Sulfide ion (1 ppm by mass) | | | Fc-1 S-I-1 | Fluorine element (1 ppm by mass) Sulfur element (1 ppm by mass) | Sulfide ion (1 ppm by mass) | A | A+ | A | B+ |
| Example 54 | 54 | | Cl-1 Sc-1 | Chlorine element (1 ppm by mass) Sulfur element (1 ppm by mass) | - | | | Cl-1 Sc-1 | Chlorine element (1 ppm by mass) Sulfur element (1 ppm by mass) | - | B | B | B | B |
| Example 55 | 55 | | | Chlorine element (0.5 ppm by mass) Sulfur element (0.5 ppm by mass) | - | | | | Chlorine element (0.5 ppm by mass) Sulfur element (0.5 ppm by mass) | - | B+ | B+ | B | B |
| Example 56 | 56 | | | Chlorine element (40 ppm by mass) Sulfur element (40 ppm by mass) | - | | | | Chlorine element (40 ppm by mass) Sulfur element (40 ppm by mass) | - | B+ | B+ | C+ | C+ |

[Table 3-7]

| | Composition | Composition [parts by mass] | | | | | Composition of cured film | | | | Photosensitive characteristics / cured film characteristics / light emission characteristics | | | |
|---|---|---|---|---|---|---|---|---|---|---|---|---|---|---|
| | | Resin (A) Photosensitive agent (C) Crosslinking agent (F) Dissolution promoter | Specific compound | Content in total solid content of composition | Content in total solid content of composition | Content in composition | Specific compound in cured film | | Content in cured film | | Development residue | Low voltage driving characteristic | Reliability of light emitting element | Migration resistance |
| | | | | | | | | | Halogen element Sulfur element | Specific compound | | | | |
| Example 1 | 1 | | - | - | | | | - | | - | B+ | A | B+ | B+ |
| Example 57 | 57 | PIP-1 (45) PBP-1 (30) PR-1 (25) NQD-1 (20) NQD-2 (10) f-1 (5) f-2 (5) p-1 (5) Fc-1 | Nc-1 | 1.0 mass% | Fluorine element (3 ppm by mass) | Water (1.0 mass%) | (Fc-1) | Nc-1 | Fluorine element (3 ppm by mass) | 1.0 mass% | A | A+ | B+ | B+ |
| Example 58 | 58 | | Nc-2 | 1.0 mass% | | | | Nc-2 | | 1.0 mass% | A | A+ | A | A |
| Example 59 | 59 | | Nc-3 | 1.0 mass% | | | | Nc-3 | | 1.0 mass% | A | A+ | A | A+ |
| Example 60 | 60 | | Nc-4 | 1.0 mass% | | | | Nc-4 | | 1.0 mass% | A | A+ | A | A+ |
| Example 61 | 61 | | Nc-5 | 1.0 mass% | | | | Nc-5 | | 1.0 mass% | A | A+ | B+ | B+ |
| Example 62 | 62 | | Nc-6 | 1.0 mass% | | | | Nc-6 | | 1.0 mass% | A | A+ | B+ | B+ |
| Example 63 | 63 | | Nc-7 | 1.0 mass% | | | | Nc-7 | | 1.0 mass% | A | A+ | A | A |
| Example 64 | 64 | | Nc-8 | 1.0 mass% | | | | Nc-8 | | 1.0 mass% | A | A+ | A | A |
| Example 65 | 65 | | i-1 | 3 ppm by mass | | | | i-1 | | 3 ppm by mass | A | A+ | A | A |
| Example 66 | 66 | | i-2 | 3 ppm by mass | | | | i-2 | | 3 ppm by mass | A | A+ | A | A |
| Example 67 | 67 | | i-3 | 3 ppm by mass | | | | i-3 | | 3 ppm by mass | A | A+ | B+ | B+ |
| Example 68 | 68 | | i-4 | 3 ppm by mass | | | | i-4 | | 3 ppm by mass | A | A+ | B+ | B+ |
| Example 69 | 69 | | i-5 | 3 ppm by mass | | | | i-5 | | 3 ppm by mass | A | A+ | B+ | B+ |
| Example 70 | 70 | | j-1 | 3 ppm by mass | | | | j-1 | | 3 ppm by mass | A | A+ | A | A |
| Example 71 | 71 | | j-2 | 3 ppm by mass | | | | j-2 | | 3 ppm by mass | A | A+ | A | A |

[Table 3-8]

| | Composition | Composition (parts by mass) | | | | | | Composition of cured film | | Photosensitive characteristics / cured film characteristics / light emission characteristics | | | |
|---|---|---|---|---|---|---|---|---|---|---|---|---|---|
| | | Binder resin (A) | | | Photosensitive agent (C) Crosslinking agent (F) Dissolution promoter Compound including specific element | Content in total solid content of composition | Content in composition | Specific compound in cured film | Content in cured film | Development residue | Low voltage driving characteristic | Reliability of light emitting element | Migration resistance |
| | | Resin (A1x) | | Resin (A1y) Resin (A2x) Resin (A2y) | | | | | Halogen element Sulfur element | | | | |
| Example 1 | 1 | PIP-1 (45) | PBP-1 (30) | PR-1 (25) | NQD-1 (20) NQD-2 (10) f-1 (5) f-2 (5) p-1 (5) Fc-1 | Fluorine element (3 ppm by mass) | Water (1.0 mass%) | Fc-1 | Fluorine element (3 ppm by mass) | B+ | A | B+ | B+ |
| Example 72 | 72 | PI-4 (45) | | | | | | | | A+ | A | A | A |
| Example 73 | 73 | PI-5 (45) | | | | | | | | A+ | A | A | A |
| Example 74 | 74 | PIP-17 (45) | | | | | | | | A+ | A+ | A | A |
| Example 75 | 75 | PIP-18 (45) | | | | | | | | A+ | A+ | A | A |
| Example 76 | 76 | PIP-19 (45) | | | | | | | | A+ | A+ | A | A |
| Example 77 | 77 | PIP-20 (45) | | | | | | | | A+ | A+ | A | A |
| Example 78 | 78 | PIP-21 (45) | | | | | | | | A | A | A | B+ |
| Example 79 | 79 | PIP-22 (45) | | | | | | | | A+ | A+ | A | A |
| Example 80 | 80 | PIP-23 (45) | | | | | | | | A | A | A | B+ |
| Example 81 | 81 | PIP-24 (45) | | | | | | | | A | A+ | A | A |
| Example 82 | 82 | PIP-25 (45) | | | | | | | | A | A | A | B+ |
| Example 83 | 83 | PIP-26 (45) | | | | | | | | A+ | A+ | A | A |
| Example 84 | 84 | PIP-27 (45) | | | | | | | | A+ | A+ | A | A |
| Example 85 | 85 | PIP-28 (45) | | | | | | | | A+ | A+ | A | A |
| Example 86 | 86 | PIP-29 (45) | | | | | | | | A+ | A+ | A | A |
| Example 87 | 87 | PIP-30 (45) | | | | | | | | A+ | A+ | A | A |
| Example 88 | 88 | PIP-31 (45) | | | | | | | | A+ | A+ | A+ | A+ |
| Example 89 | 89 | PIP-32 (45) | | | | | | | | A | A | A | B+ |

[Table 3-9]

| | Composition | Composition (parts by mass) | | | | | | Composition of cured film | | Photosensitive characteristics / cured film characteristics / light emission characteristics | | | |
|---|---|---|---|---|---|---|---|---|---|---|---|---|---|
| | | Binder resin (A) | | | Photosensitive agent (C) Crosslinking agent (F) Dissolution promoter Compound including specific element | Content in total solid content of composition | Content in composition | Specific compound in cured film | Content in cured film | Development residue | Low voltage driving characteristic | Reliability of light emitting element | Migration resistance |
| | | Resin (A1x) | | Resin (A1y) Resin (A2x) Resin (A2y) | | | | | Halogen element Sulfur element | | | | |
| Example 1 | 1 | PIP-1 (45) | PBP-1 (30) | PR-1 (25) | NQD-1 (20) NQD-2 (10) f-1 (5) f-2 (5) p-1 (5) Fc-1 | Fluorine element (3 ppm by mass) | Water (1.0 mass%) | Fc-1 | Fluorine element (3 ppm by mass) | B+ | A | B+ | B+ |
| Example 90 | 90 | PIP-33 (45) | | | | | | | | A+ | A+ | A+ | A+ |
| Example 91 | 91 | PIP-34 (45) | | | | | | | | A+ | A+ | A+ | A |
| Example 92 | 92 | PIP-35 (45) | | | | | | | | A | B+ | B+ | B+ |
| Example 93 | 93 | PIP-36 (45) | | | | | | | | A | A | B+ | B+ |
| Example 94 | 94 | PIP-37 (45) | | | | | | | | A | B+ | A | A |
| Example 95 | 95 | PIP-38 (45) | | | | | | | | A+ | A | A | A |
| Example 96 | 96 | PIP-39 (45) | | | | | | | | A+ | A | A | A |
| Example 97 | 97 | PIP-40 (45) | | | | | | | | A | B+ | A | A |
| Example 98 | 98 | PIP-41 (45) | | | | | | | | A | A | B+ | B+ |
| Example 99 | 99 | PB-2 (45) | | | | | | | | A+ | A | A | A |
| Example 100 | 100 | PIP-1 (45) | PBP-4 (30) | | | | | | | A+ | A+ | A | A |
| Example 101 | 101 | | PBP-5 (30) | | | | | | | A+ | A+ | A | A |
| Example 102 | 102 | | PBP-6 (30) | | | | | | | A | A | A | B+ |
| Example 103 | 103 | | PBP-7 (30) | | | | | | | A+ | A+ | A | A |
| Example 104 | 104 | PAI-2 (45) | PBP-1 (30) | | | | | | | A+ | A | A | A |

[Table 3-10]

| | Composition | Composition (parts by mass) | | | | | | Composition of cured film | | | Photosensitive characteristics / cured film characteristics / light emission characteristics | | | |
|---|---|---|---|---|---|---|---|---|---|---|---|---|---|---|
| | | Resin (A1x) | Resin (A1y) Photosensitive agent (C) Crosslinking agent (F) Dissolution promoter | Compound including specific element | Content in total solid content of composition | | Content in composition | Specific compound in cured film | Content in cured film | | Development residue | Low voltage driving characteristic | Reliability of light emitting element | Migration resistance |
| | | | | | Halogen element Sulfur element | Halogen ion Sulfur ion | | | Halogen element Sulfur element | Halogen ion Sulfur ion | | | | |
| Comparative Example 1 | 105 | PIP-1 (45) PBP-1 (30) | PR 1 (25) MQD-1 (20) MQD-2 (10) f-1 (5) f-2 (5) p-1 (5) | Fo-1 | Fluorine element (1,500 ppm by mass) | - | Water (1.0 mass%) | Fo-1 | Fluorine element (1,500 ppm by mass) | - | D | D | D | D |
| Comparative Example 2 | 106 | | | F-I-1 | Fluorine element (1,500 ppm by mass) | Fluoride ion (1,500 ppm by mass) | | F-I-1 | Fluorine element (1,500 ppm by mass) | Fluoride ion (1,500 ppm by mass) | D | D | D | D |
| Comparative Example 3 | 107 | | | Fo-1 Cl-I-1 | Fluorine element (1,500 ppm by mass) Chlorine element (1,500 ppm by mass) | Chloride ion (1,500 ppm by mass) | | Fo-1 Cl-I-1 | Fluorine element (1,500 ppm by mass) Chlorine element (1,500 ppm by mass) | Chloride ion (1,500 ppm by mass) | D | D | D | E |
| Comparative Example 4 | 108 | | | Fo-1 Br-I-1 | Fluorine element (1,500 ppm by mass) Bromine element (1,500 ppm by mass) | Bromide ion (1,500 ppm by mass) | | Fo-1 Br-I-1 | Fluorine element (1,500 ppm by mass) Bromine element (1,500 ppm by mass) | Bromide ion (1,500 ppm by mass) | D | D | D | E |
| Comparative Example 5 | 109 | PIP-16 (45) PBP-3 (30) | | PIP-16 PBP-3 | Fluorine element (109,000 ppm by mass) | - | | PIP-16 PBP-3 | Fluorine element (109,000 ppm by mass) | - | D | E | E | E |
| Comparative Example 6 | 110 | PI-3 (45) PBP-3 (30) | | PI-3 PBP-3 | Fluorine element (82,000 ppm by mass) | - | | PI-3 PBP-3 | Fluorine element (82,000 ppm by mass) | - | D | E | D | D |

In Comparative Example 1 to Comparative Example 4, the content of the fluorine element in the total solid content of the composition does not satisfy the matters specifying the invention of the composition of the present invention. In Comparative Example 5 and Comparative Example 6, the content of the fluorine element in the structure of the (A1x) resin is large, and the content of the fluorine element in the total solid content of the composition exceeds a suitable range. Therefore, Comparative Example 1 to Comparative Example 6 are inferior in various properties.

<Example 105; Production of organic EL display>

An organic EL display was produced by the method described in Example 1 except that the thin film portion of the pixel dividing layer was produced using the composition 47 in place of the composition 1, and the thick film portion of the pixel dividing layer was formed using the composition 51. The results of evaluating various characteristics in the same manner as in Example 1 are collectively shown in Table 3-11. The structural unit of the resin and the structure of the compound contained in the thin film portion and the thick film portion were analyzed in the same manner. The thin film portion and the thick film portion included, respectively, the resin and the compound in the composition 47 or the composition 51, and the resin and the compound having a structure derived therefrom, as follows. The OD value per film thickness of 1 μm, which is an index of the light-shielding property of the thin film portion, was 0.9.

Thin film portion:

(XAlx) resin: Polyimide; Polybenzoxazole; Polybenzoxazole precursor
(XA1y) resin: Phenolic resin
(XC2x) compound: Compound having fluorene structure and having structure in which imino group is bonded to fluorene structure
(XD) colorant: Benzofuranone-based black pigment

Thick film portion:

(XAlx) resin: Polyimide; Polybenzoxazole; Polybenzoxazole precursor
(XA1y) resin: Phenolic resin
(XC2x) compound: A compound having a fluorene structure and having a structure in which an imino group is bonded to the fluorene structure.

<Example 106; Production of organic EL display (collective processing of thick film portion and thin film portion)>

An organic EL display was produced by the method described in Example 1 except that the cured film of a

composition 43 was formed as the pixel division layer portion 50 by a method of collectively processing the step shape using a halftone photomask having a predetermined pattern. The pixel dividing layer portion 50 was formed so as to have a thick film portion having a film thickness of about 3.0 μm and a thin film portion having a film thickness of about 1.5 μm. The results of evaluating various characteristics in the same manner as in Example 1 are collectively shown in Table 3-11. The structural unit of the resin and the structure of the compound contained in the thin film portion and the thick film portion were analyzed in the same manner. The thin film portion and the thick film portion each contained the resin and compound in composition 43, and resins and compounds having structures derived therefrom, as follows. That is, the thin film portion and the thick film portion obtained by curing composition 43 include the same compound. The OD values per film thickness of 1 μm, which is an index of the light-shielding property of the thin film portion and the thick film portion, were both 0.9.

(XA1x) resin: Polyimide (unit represented by formula (1)); polyimide precursor (unit represented by formula (2)); polybenzoxazole (unit represented by formula (3)); polybenzoxazole precursor (unit represented by formula (4))
(XA1y) resin: Phenolic resin
(XC1x) compound: Carboxylic acids including an indene structure; Carboxylic acid esters including an indene structure; Sulfonic acids including an indene structure; Aryl sulfonic acid esters including an indene structure
(XD) colorant: C.I. Acid Red 52; C.I. Basic Blue 7; C.I. Solvent Red 18
Other compounds: 1,2,4-trihydroxybenzene; structure represented by Formula (12)

A compound having a specific crosslinked structure (a structure represented by formula (12) and a quinone structure represented by formula (12)).

[Table 3-11]

| | Composition for forming thin film portion | Composition for forming thick film portion | Composition of cured film | | Photosensitive characteristics / cured film characteristics / light emission characteristics | | | | |
|---|---|---|---|---|---|---|---|---|---|
| | | | Specific compound in cured film | Content in cured film<br>Halogen element Sulfur element | Development residue | Light-shielding property OD value | Low voltage driving characteristic | Reliability of light emitting element | Migration resistance |
| Example 1 | 1 | 1 | Fc-1 | Fluorine element (3 ppm by mass) | B+ | - | A | B+ | B+ |
| Example 105 | 47 | 51 | Fc-1 | Fluorine element (3 ppm by mass) | A | 0.9 | A+ | A+ | A |
| Example 106 | 43 (batch processing) | | | | A | 0.9 | A+ | A+ | A+ |

<Storage Stability of Photosensitive Composition>

Each composition prepared in Examples 1 to 104 was stored at 25°C for one week. After the storage, as a result of forming a film of the composition on the substrate in the same manner as in Example 1, there was no generation of foreign matters, and the storage stability was good. On the other hand, the compositions 105 to 110 prepared in Comparative Examples 1 to 6, in which the content of the fluorine element in the total solid content of the photosensitive compositions exceeds 1,000 ppm by mass, were stored at 25°C for one week in the same manner. After the storage, as a result of forming a film of the composition on the substrate in the same manner, there were many foreign matters generated, and the storage stability was poor.

DESCRIPTION OF REFERENCE SIGNS

47: Alkali-free glass substrate
48: First electrode portion
49: Auxiliary electrode portion
50: Pixel dividing layer portion
51: Organic EL layer portion including light emitting layer
52: Second electrode portion
100A: Display device having step shape in which pixel dividing layer has thick film portions and thin film portions

101: Substrate
102: Metal wiring
103: TFT element layer
104: Interlayer insulating layer
105: TFT planarization layer/TFT protective layer
106: Pixel dividing layer having step shape
106a: Thin film portion in pixel dividing layer portion
107: First electrode
108: Light emitting layer
109: Second electrode
110: Sealing layer
111: Touch panel wiring/touch panel electrode
112: Color filter layer
113: Black matrix layer
114: Overcoat layer
115: Substrate
116: Thick film portion in pixel dividing layer
100x: Cross-sectional axis in plan view
112a: Color filter layer portion
116a: Thick film portion in pixel dividing layer portion
117a: Opening of pixel dividing layer portion having step shape
118a: Opening of black matrix layer portion

## Claims

1. A resin being one or more resins selected from the group consisting of a polyimide, a polyimide precursor, a polybenzoxazole, a polybenzoxazole precursor, a polyamideimide, a polyamideimide precursor, and a copolymer thereof, wherein

   the resin has a first amine residue (DA1): an amine residue having a phenolic hydroxyl group, and the first amine residue (DA1) has at least two structures (Ia): a cyclic structure having a phenolic hydroxyl group, and a structure (IIa): a structure linking at least two of the structures (Ia), and
   the structure (IIa) is a sulfonyl group, an alkylene group, a condensed polycyclic structure, a hydrocarbon group including an ether bond, a direct bond, an ether bond, a sulfide bond, a carbonyl group, a carboxylate ester bond, an amide bond, a urea bond, a urethane bond, a carbonate ester bond, a cycloalkylene group, an arylene group, a condensed polycyclic heterocyclic structure, a hydrocarbon group including a carbonyloxy group, or a hydrocarbon group including a carbonyl amide group, and
   the resin satisfies the following condition (P1a):
   (P1a) a content of a fluorine element in the structure of the resin is 10,000 ppm by mass or less.

2. The resin according to claim 1, wherein the first amine residue (DA1) has an amine residue satisfying the following condition (S1x):
   (S1x) an amine residue has a $C_1$ symmetry axis as a molecular symmetry and does not have a $C_2$ symmetry axis.

3. The resin according to claim 1, further comprising a second amine residue (DA2): an amine residue having no phenolic hydroxyl group, and satisfying the following condition ($\alpha$1) and/or condition ($\alpha$2), wherein

   a total content ratio of the first amine residue (DA1) to all amine residues in the resin is 20 mol% or more and 90 mol% or less, and
   a total content ratio of the second amine residue (DA2) to all amine residues in the resin is 10 mol% or more and 80 mol% or less:

   ($\alpha$1) the second amine residue (DA2) has at least two structures (Ib): a cyclic structure having no phenolic hydroxyl group, and a structure (IIb): a structure linking at least two of the structures (Ib), and
   the structure (IIb) is a sulfonyl group, an alkylene group, a condensed polycyclic structure, a hydrocarbon group including an ether bond, a direct bond, an ether bond, a sulfide bond, a carbonyl group, a carboxylate ester bond, an amide bond, a urea bond, a urethane bond, a carbonate ester bond, a cycloalkylene group, an

arylene group, a condensed polycyclic heterocyclic structure, a hydrocarbon group including a carbonyloxy group, or a hydrocarbon group including a carbonyl amide group;
($\alpha$2) the second amine residue (DA2) has a structure (IIIb): a silicone structure and/or a siloxane structure.

**4.** The resin according to claim 3, wherein the first amine residue (DA1) has an amine residue satisfying the following conditions (S1x), and/or the second amine residue (DA2) has an amine residue satisfying at least one of the following conditions (S1x) and (S2x):

(S1x) an amine residue has a $C_1$ symmetry axis as a molecular symmetry and does not have a $C_2$ symmetry axis;
(S2x) an amine residue has at least one of a chiral center, a chiral axis, a chiral plane, and a helical axis.

**5.** The resin according to claim 2 comprising a polyimide unit and a polyimide precursor unit, wherein

a content ratio of a polyimide unit to a total of the polyimide unit and the polyimide precursor unit is 1.0 mol% or more and 30 mol% or less, and
a content ratio of an amic acid ester structure to a total of an amic acid structure and an amic acid ester structure in the polyimide precursor unit is 40 mol% or more and 99 mol% or less.

**6.** The resin according to claim 2 comprising a polyimide unit and/or a polyimide precursor unit, and

the resin has one or more selected from the group consisting of a polybenzoxazole unit, a polybenzoxazole precursor unit, a polyamideimide unit, and a polyamideimide precursor unit, wherein
a total content ratio of a polybenzoxazole unit, a polybenzoxazole precursor unit, a polyamideimide unit, and a polyamideimide precursor unit to a total of a polyimide unit, a polyimide precursor unit, a polybenzoxazole unit, a polybenzoxazole precursor unit, a polyamideimide unit, and a polyamideimide precursor unit of the resin is 10 mol% or more and 90 mol% or less.

**7.** The resin according to claim 2, further satisfying at least one of the following conditions (P1b), (P1c), and (P1d) :

(P1b) a content of a chlorine element in the structure of the resin is 30,000 ppm by mass or less;
(P1c) a content of a bromine element in the structure of the resin is 30,000 ppm by mass or less;
(P1d) a content of a sulfur element in the structure of the resin is 30,000 ppm by mass or less.

**8.** A photosensitive composition comprising a binder resin (A) and a photosensitive agent (C), and further comprising a radical polymerizable compound (B) and/or a crosslinking agent (F), wherein
the binder resin (A) includes the resin according to claim 2.

**9.** The photosensitive composition according to claim 8, wherein

the binder resin (A), the photosensitive agent (C), the radical polymerizable compound (B), or the crosslinking agent (F) has a fluorine atom, a chlorine atom, a bromine atom, a fluoride ion, a chloride ion, or a bromide ion in its structure, or
the photosensitive composition further contains a component including a fluorine element, a chlorine element, or a bromine element and/or a component including a fluoride ion, a chloride ion, or a bromide ion, and
the photosensitive composition satisfies the following condition (P1x) and the following condition (1x):

(P1x) a total content of a fluorine element, a chlorine element, and a bromine element in the structure of the resin is 30,000 ppm by mass or less;
(1x) a total content of a fluorine element, a chlorine element, and a bromine element in a total solid content of the photosensitive composition is 0.010 ppm by mass or more and 1,000 ppm by mass or less.

**10.** A photosensitive composition comprising a binder resin (A) and a photosensitive agent (C), and further comprising a radical polymerizable compound (B) and/or a crosslinking agent (F), wherein

the binder resin (A) includes a resin (Ax): one or more resins selected from the group consisting of a polyimide, a polyimide precursor, a polybenzoxazole, a polybenzoxazole precursor, a polyamideimide, a polyamideimide precursor, and a copolymer thereof, and
the resin (Ax) has a first amine residue (DA1): an amine residue having a phenolic hydroxyl group, and the first

amine residue (DA1) has at least two structures (Ia): a cyclic structure having a phenolic hydroxyl group, and a structure (IIa): a structure linking at least two of the structures (Ia), and
the structure (IIa) is a sulfonyl group, an alkylene group, a condensed polycyclic structure, a hydrocarbon group including an ether bond, a direct bond, an ether bond, a sulfide bond, a carbonyl group, a carboxylate ester bond, an amide bond, a urea bond, a urethane bond, a carbonate ester bond, a cycloalkylene group, an arylene group, a condensed polycyclic heterocyclic structure, a hydrocarbon group including a carbonyloxy group, or a hydrocarbon group including a carbonyl amide group, and
the photosensitive composition satisfies the following condition (1a):
(1a) a content of a fluorine element in a total solid content of the photosensitive composition is 1,000 ppm by mass or less.

**11.** The photosensitive composition according to claim 10, wherein

the binder resin (A), the photosensitive agent (C), the radical polymerizable compound (B), or the crosslinking agent (F) has a chlorine atom, a bromine atom, a sulfur atom, a chloride ion, a bromide ion, or a sulfur-based anion as described below in its structure, or
the photosensitive composition further contains a component including a chlorine element, a bromine element, or a sulfur element and/or a component including a chloride ion, a bromide ion, or a sulfur-based anion as described below, and
the photosensitive composition satisfies at least one of the following conditions (1b), (1c), and (1d):

sulfur-based anion: one or more ions selected from the group consisting of a sulfide ion, a hydrogen sulfide ion, a sulfate ion, and a hydrogen sulfate ion
(1b) a content of a chlorine element in the total solid content of the photosensitive composition is 0.010 ppm by mass or more and 1,000 ppm by mass or less;
(1c) a content of a bromine element in the total solid content of the photosensitive composition is 0.010 ppm by mass or more and 1,000 ppm by mass or less;
(1d) a content of a sulfur element in the total solid content of the photosensitive composition is 0.010 ppm by mass or more and 1,000 ppm by mass or less.

**12.** The photosensitive composition according to any one of claims 8 to 11, further comprising a phenol compound (I), wherein the phenol compound (I) satisfies the following condition (β1), and the photosensitive composition satisfies the following condition (5):

(β1) having at least two of the following structures (Ic) and the following structure (IIIc)
structure (Ic): a cyclic structure having a phenolic hydroxyl group
structure (IIIc): a structure linking at least two of the structures (Ic), the structure being a sulfonyl group, an alkylene group, a condensed polycyclic structure, a hydrocarbon group including an ether bond, a direct bond, an ether bond, a sulfide bond, a carbonyl group, a carboxylate ester bond, an amide bond, a urea bond, a urethane bond, a carbonate ester bond, a cycloalkylene group, an arylene group, a condensed polycyclic heterocyclic structure, a hydrocarbon group including a carbonyloxy group, or a hydrocarbon group including a carbonyl amide group;
(5) a total content of the phenol compound (I) in the total solid content of the photosensitive composition is 0.010 ppm by mass or more and 10,000 ppm by mass or less.

**13.** The photosensitive composition according to claims 8 to 11, further comprising one or more resins selected from the group consisting of a phenolic resin, polyhydroxystyrene, a phenol group-containing epoxy resin, and a phenol group-containing acrylic resin.

**14.** The photosensitive composition according to any one of claims 8 to 11, wherein the photosensitive agent (C) contains a compound having a 1,2-naphthoquinonediazide-5-sulfonic acid ester structure and a compound containing a 1,2-naphthoquinonediazide-4-sulfonic acid ester structure.

**15.** The photosensitive composition according to any one of claims 8 to 11, further comprising water, and satisfying the following condition (3):
(3) a content of water in the photosensitive composition is 0.010 mass% or more and 3.0 mass% or less.

**16.** The photosensitive composition according to any one of claims 8 to 11, further comprising a nitrogen-containing

compound (H), wherein the nitrogen-containing compound (H) includes one or more selected from the group consisting of a cyclic amide compound, an amide compound, a cyclic urea compound, a urea compound, an oxazolidone compound, and an isoxazolidone compound, and the photosensitive composition satisfies the following condition (4):
(4) a total content of a cyclic amide compound, an amide compound, a cyclic urea compound, a urea compound, an oxazolidone compound, and an isoxazolidone compound in the total solid content of the photosensitive composition is 0.010 mass% or more and 5.0 mass% or less.

**17.** The photosensitive composition according to any one of claims 8 to 11, further comprising a crosslinkable aromatic compound (J), wherein the crosslinkable aromatic compound (J) has at least two structures (Id): a cyclic structure in which a phenolic hydroxyl group and at least two crosslinkable groups are bonded, and at least two structures (IId): a cyclic structure having a phenolic hydroxyl group different from the structure (Id), and further has a structure (IIId): a structure linking at least two of the structures (IId), and the photosensitive composition satisfies the following condition (6):
(6) a total content of the crosslinkable aromatic compound (J) in the total solid content of the photosensitive composition is 0.010 ppm by mass or more and 5,000 ppm by mass or less.

**18.** A cured product obtained by curing the photosensitive composition according to any one of claims 8 to 11.

**19.** A display device comprising the cured product according to claim 18.

**20.** An electronic component comprising the cured product according to claim 18.

**21.** A method for producing a cured product, the method comprising: (1) a step of forming a coating film of the photosensitive composition according to any one of claims 8 to 11 on a substrate; (2) a step of irradiating the coating film of the photosensitive composition with actinic radiation through a photomask; (3) a step of performing development with a developer to form a pattern of the photosensitive composition; and (4) a step of heating the pattern of the photosensitive composition to obtain a cured pattern of the photosensitive composition.

**22.** A display device comprising a substrate, a first electrode, a second electrode, a pixel dividing layer, a light emitting layer, and a TFT planarization layer, wherein the pixel dividing layer and/or the TFT planarization layer includes one or more resins selected from the group consisting of a polyimide, a polyimide precursor, a polybenzoxazole, a polybenzoxazole precursor, a polyamideimide, a polyamideimide precursor, and a copolymer thereof, and

the resin has an amine residue having a phenolic hydroxyl group, and the amine residue having a phenolic hydroxyl group has at least two structures (XIa): a cyclic structure having a phenolic hydroxyl group, and a structure (XIIa): a structure linking at least two of the structures (XIa), and
the structure (XIIa) is a sulfonyl group, an alkylene group, a condensed polycyclic structure, a hydrocarbon group including an ether bond, a direct bond, an ether bond, a sulfide bond, a carbonyl group, a carboxylate ester bond, an amide bond, a urea bond, a urethane bond, a carbonate ester bond, a cycloalkylene group, an arylene group, a condensed polycyclic heterocyclic structure, a hydrocarbon group including a carbonyloxy group, or a hydrocarbon group including a carbonyl amide group, and
the display device satisfies the following condition (X1a) :
(X1a) a content of a fluorine element in the pixel dividing layer is 1,000 ppm by mass or less, and/or a content of a fluorine element in the TFT planarization layer is 1,000 ppm by mass or less.

Fig. 1

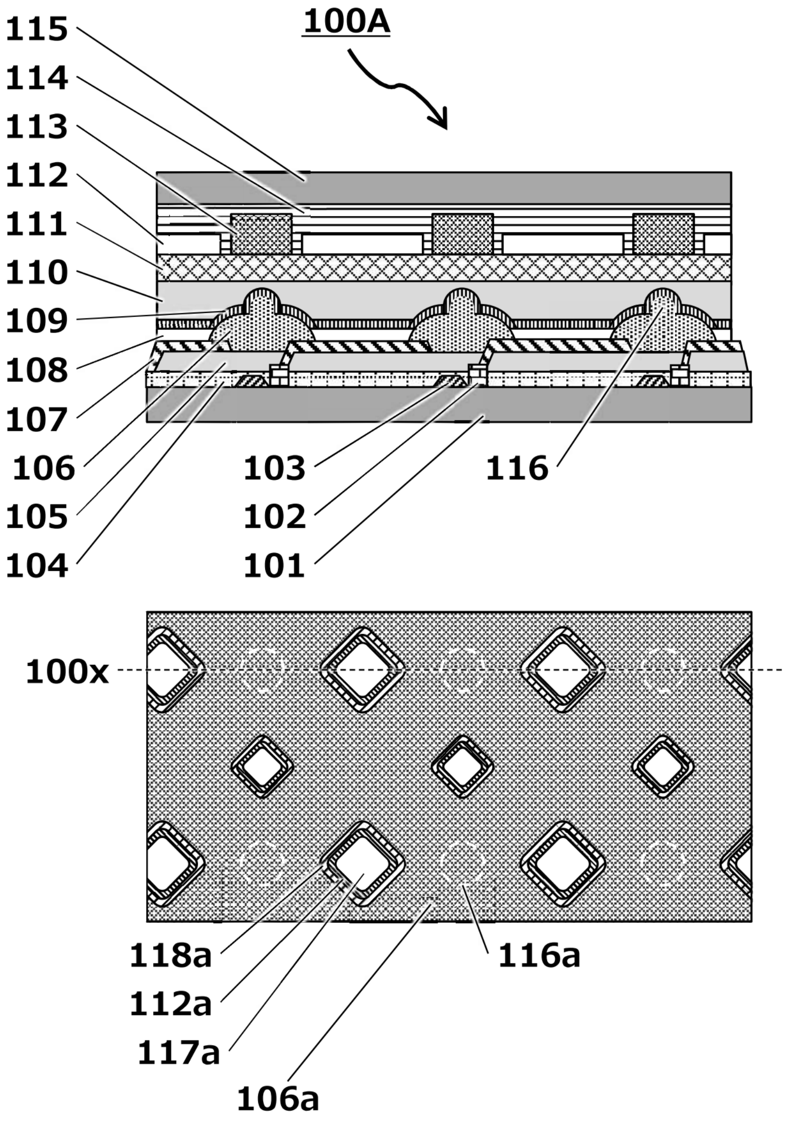
100A
115
114
113
112
111
110
109
108
107
106
105
104
103
102
101
116
100x
118a
112a
117a
106a
116a

Fig. 2

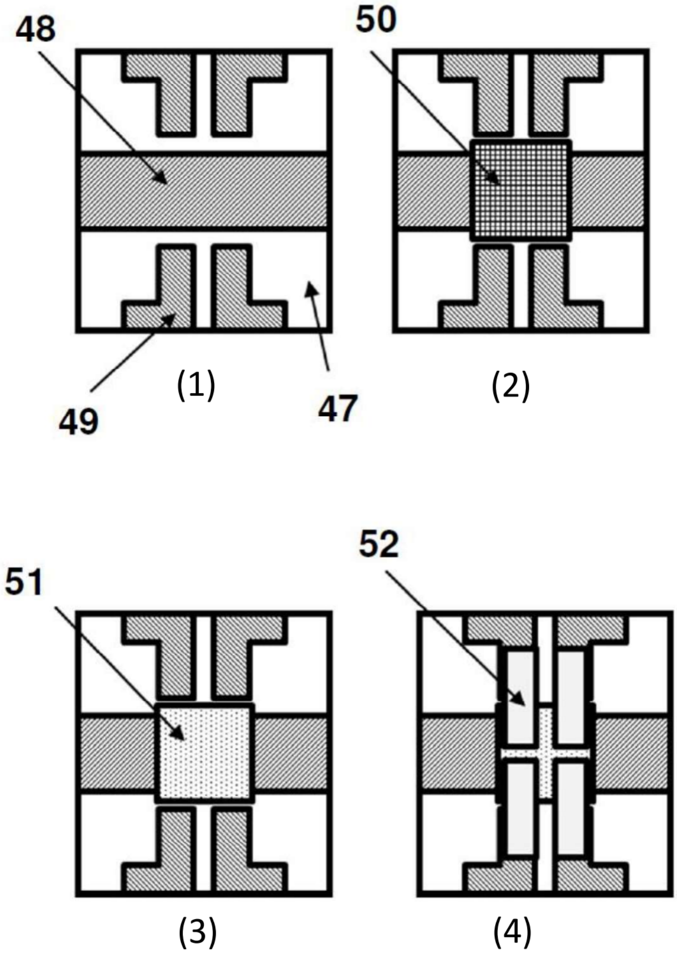

## INTERNATIONAL SEARCH REPORT

International application No.
**PCT/JP2024/022587**

**A. CLASSIFICATION OF SUBJECT MATTER**

***C08G 73/06***(2006.01)i; ***C08G 73/22***(2006.01)i; ***C08K 5/00***(2006.01)i; ***C08L 79/04***(2006.01)i; ***C08L 79/08***(2006.01)i; ***G03F 7/023***(2006.01)i; ***G03F 7/037***(2006.01)i; ***G03F 7/038***(2006.01)i; ***H05B 33/14***(2006.01)i; ***H10K 50/84***(2023.01)i; ***H10K 59/122***(2023.01)i; ***H10K 59/124***(2023.01)i; ***H10K 85/10***(2023.01)i

FI: C08G73/06; C08G73/22; C08K5/00; C08L79/04 B; C08L79/08 C; C08L79/08 Z; G03F7/023; G03F7/037; G03F7/038 504; H05B33/14 Z; H10K50/84; H10K59/122; H10K59/124; H10K85/10

According to International Patent Classification (IPC) or to both national classification and IPC

**B. FIELDS SEARCHED**

Minimum documentation searched (classification system followed by classification symbols)

C08G73/06; C08G73/22; C08K5/00; C08L79/04; C08L79/08; G03F7/023; G03F7/037; G03F7/038; H05B33/14; H10K50/84; H10K59/122; H10K59/124; H10K85/10

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2008-111929 A (SUMITOMO BAKELITE CO., LTD.) 15 May 2008 (2008-05-15) claims, paragraphs [0004], [0009]-[0026], [0036]-[0044], [0048]-[0058], [0060]-[0070], examples | 1-4, 7-12, 14-22 |
| X | JP 2004-317725 A (KANEGAFUCHI CHEM IND. CO., LTD.) 11 November 2004 (2004-11-11) claims, paragraphs [0002]-[0009], [0014]-[0019], [0044]-[0050], [0064]-[0067], [0082], [0103]-[0115], [0121], [0146]-[0149], examples | 1, 3, 10, 13-22 |
| X | JP 2010-235917 A (SUMITOMO BAKELITE CO., LTD.) 21 October 2010 (2010-10-21) claims, paragraphs [0011], [0031]-[0046], [0078]-[0084], [0115], [0153], examples | 1-2, 8-11, 14-15, 18-19 |
| X | JP 2009-290166 A (NIPPON STEEL CHEM CO., LTD.) 10 December 2009 (2009-12-10) claims, paragraphs [0014], [0029]-[0042], examples | 1, 3 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **23 July 2024** | **06 August 2024** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (July 2022)

INTERNATIONAL SEARCH REPORT

International application No. PCT/JP2024/022587

C. DOCUMENTS CONSIDERED TO BE RELEVANT

| Category* | Citation of document, with indication, where appropriate, of the relevant passages | Relevant to claim No. |
|---|---|---|
| X | WO 2017/018290 A1 (SUMITOMO BAKELITE CO., LTD.) 02 February 2017 (2017-02-02) claims, paragraphs [0002]-[0005], [0022]-[0046], [0048], [0053]-[0057], [0066]-[0070], examples | 1-2, 5-22 |
| X | JP 2009-073875 A (SHIN-ETSU CHEMICAL CO., LTD.) 09 April 2009 (2009-04-09) claims, paragraphs [0003], [0010]-[0013], [0016], [0018], [0023]-[0024], [0027]-[0028], [0032], examples | 1, 3-4 |
| A | JP 2008-214391 A (ASAHI KASEI KABUSHIKI KAISHA) 18 September 2008 (2008-09-18) entire text | 1-22 |

Form PCT/ISA/210 (second sheet) (July 2022)

**INTERNATIONAL SEARCH REPORT**
**Information on patent family members**

International application No.
**PCT/JP2024/022587**

| Patent document cited in search report | Publication date (day/month/year) | Patent family member(s) | Publication date (day/month/year) |
|---|---|---|---|
| JP 2008-111929 A | 15 May 2008 | (Family: none) | |
| JP 2004-317725 A | 11 November 2004 | US 2006/0199920 A1<br>claims, paragraphs [0002]-[0016], [0037]-[0053], [0111]-[0113], [0127]-[0129], [0200]-[0204], [0281]-[0303], [0388]-[0391], examples<br>WO 2004/092838 A1 | |
| JP 2010-235917 A | 21 October 2010 | (Family: none) | |
| JP 2009-290166 A | 10 December 2009 | WO 2009/147997 A1<br>claims, paragraphs [0014], [0029]-[0042], examples | |
| WO 2017/018290 A1 | 02 February 2017 | CN 107924122 A<br>claims, examples<br>KR 10-2018-0030693 A | |
| JP 2009-073875 A | 09 April 2009 | KR 10-2009-0030207 A<br>claims, examples | |
| JP 2008-214391 A | 18 September 2008 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2002091343 A
- WO 2018123853 A
- WO 2019087985 A
- WO 2016056451 A
- WO 2022196261 A
- WO 2017057281 A